# EUROPEAN PATENT APPLICATION

(11) **EP 4 524 144 A1**
(43) Date of publication of application: **19.03.2025**
(21) Application number: 24200157.6
(22) Date of filing: 13.09.2024
(51) Int. Cl.: C07F 15/00, C09K 11/06, H10K 50/11

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**

(30) Priority: 15.09.2023 KR 20230123319
(71) Applicant: Samsung Display Co., Ltd., Gyeonggi-do 17113 (KR)
(72) Inventor: Kang, Iljoon, 17113 Yongin-si, Gyeonggi-do (KR); Ko, Soobyung, 17113 Yongin-si, Gyeonggi-do (KR); Ahn, Seihwan, 17113 Yongin-si, Gyeonggi-do (KR); Han, Junghoon, 17113 Yongin-si, Gyeonggi-do (KR)
(74) Representative: Gulde & Partner

(57) **Abstract**

Provided are an organometallic compound represented by Formula 1 and an organic light-emitting device including the same. Each substituent in Formula 1 is as described in the present specification.

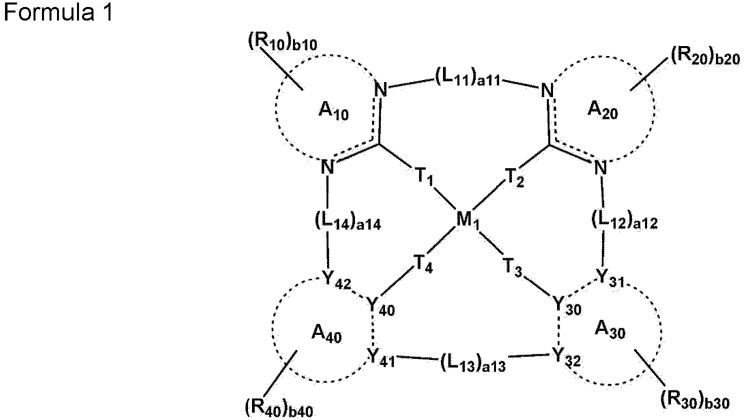

## Description

### BACKGROUND

### 1. Field

One or more embodiments of the present disclosure relate to an organometallic compound, and an organic light-emitting device and an electronic apparatus that include the organometallic compound.

### 2. Description of the Related Art

Organic light-emitting devices are self-emissive devices that, as compared with devices of the related art, have wide viewing angles, high contrast ratios, short response times, and excellent characteristics in terms of luminance, driving voltage, and response speed, and produce full-color images.

In an example, an organic light-emitting device may have a structure in which a first electrode is arranged on a substrate, and a hole transport region, an emission layer, an electron transport region, and a second electrode are sequentially formed on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. The excitons may transition from an excited state to a ground state, thereby generating light.

### SUMMARY

The invention is defined by the appended claims. The description that follows is subjected to this limitation. Any disclosure lying outside the scope of said claims is only intended for illustrative as well as comparative purposes. One or more embodiments of the present disclosure include an organometallic compound, an organic light-emitting device including the same, and an electronic apparatus including the organic light-emitting device.

Additional aspects of embodiments will be set forth in part in the description which follows and, in part, will be apparent from the description, or may be learned by practice of the presented embodiments of the disclosure.

According to one or more embodiments, an organometallic compound is represented by Formula 1: 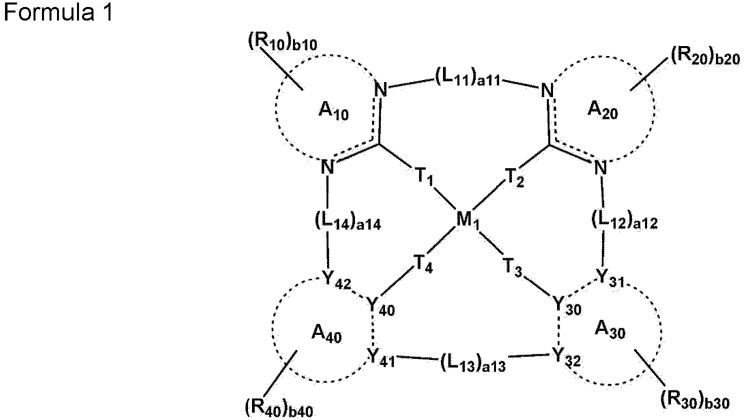 wherein, in Formula 1,
M₁ is platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), or thulium (Tm),
A₁₀ and A₂₀ are each independently an N-containing C₁-C₆₀ heterocyclic group,
A₃₀ and A₄₀ are each independently a C₅-C₆₀ carbocyclic group or a C₁-C₆₀ heterocyclic group,
Y₃₀ and Y₄₀ are each independently C or N,
Y₃₁, Y₃₂, Y₄₁, and Y₄₂ are each independently N or C,
T₁ to T₄ each indicate a chemical bond (e.g., a covalent bond or a coordinate covalent bond, which may also be referred to as a dative bond),
L₁₁ is *-O-*', *-S-*', *-C(R₁)(R₂)-*', *-C(R₁)=*', *=C(R₁)-*', *-C(R₁)=C(R₂)-*', *-C(=O)-*', *-C(=S)-*', *-C≡C-*', *-B(R₁)-*', *-N(R₁)-*', *-P(R₁)-*', *-Si(R₁)(R₂)-*', *-P(R₁)(R₂)-*', *-Ge(R₁)(R₂)-*', a C₅-C₆₀ carbocyclic group unsubstituted or substituted with at least one R₁₀ₐ, or a C₁-C₆₀ heterocyclic group unsubstituted or substituted with at least one R10a,
L₁₂ to L₁₄ are each independently *-O-*', *-S-*', *-C(R₃)(R₄)-*', *-C(R₃)=*', *=C(R₃)-*', *-C(R₃)=C(R₄)-*', *-C(=O)-*', *-C(=S)-*', *-C≡C-*', *-B(R₃)-*', *-N(R₃)-*', *-P(R₃)-*', *-Si(R₃)(R₄)-*', *-P(R₃)(R₄)-*', *-Ge(R₃)(R₄)-*', a C₅-C₆₀ carbocyclic group unsubstituted or substituted with at least one R₁₀ₐ, or a C₁-C₆₀ heterocyclic group unsubstituted or substituted with at least one R₁₀ₐ, *, and *' each indicate a binding site to a neighboring atom,
a11 is 1, 2, 3, 4, or 5,
a12, a13, and a14 are each independently 0, 1, 2, 3, 4, or 5,
R₁ to R₄, R₁₀, R₂₀, R₃₀, and R₄₀ are each independently hydrogen, deuterium, - F, -Cl, -Br, -I, a hydroxyl group, a cyano group, a nitro group, an amidino group, a hydrazino group, a hydrazono group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₁₀ cycloalkyl group unsubstituted or substituted with at least one R₁₀ₐ, a C₁-C₁₀ heterocycloalkyl group unsubstituted or substituted with at least one R₁₀ₐ, a C₃-C₁₀ cycloalkenyl group unsubstituted or substituted with at least one R₁₀ₐ, a C₁-C₁₀ heterocycloalkenyl group unsubstituted or substituted with at least one R₁₀ₐ, a C₆-C₆₀ aryl group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₁-C₆₀ heteroaryl group unsubstituted or substituted with at least one R₁₀ₐ, a C₁-C₆₀ heteroaryloxy group unsubstituted or substituted with at least one R₁₀ₐ, a C₁-C₆₀ heteroarylthio group unsubstituted or substituted with at least one R₁₀ₐ, a monovalent non-aromatic condensed polycyclic group unsubstituted or substituted with at least one R₁₀ₐ, a monovalent non-aromatic condensed heteropolycyclic group unsubstituted or substituted with at least one R₁₀ₐ, -Si(Q₁)(Q₂)(Q₃), -B(Q₁)(Q₂), -N(Q₁)(Q₂), -P(Q₁)(Q₂), - C(=O)(Q₁), -S(=O)(Q₁), -S(=O)₂(Q₁), -P(=O)(Q₁)(Q₂), or -P(=S)(Q₁)(Q₂),
b10, b20, b30, and b40 are each independently 1, 2, 3, 4, 5, 6, 7, or 8,
neighboring two or more of R₁ to R₄, R₁₀, R₂₀, R₃₀, and R₄₀ may optionally be bonded together to form a C₅-C₆₀ carbocyclic group unsubstituted or substituted with at least one R₁₀ₐ or a C₁-C₆₀ heterocyclic group unsubstituted or substituted with at least one R₁₀ₐ,
R₁₀ₐ is:
deuterium, -F, -Cl, -Br, -I, a hydroxyl group, a cyano group, or a nitro group,
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof,
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, - Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof, or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ are each independently hydrogen, deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

According to one or more embodiments, an organic light-emitting device includes a first electrode, a second electrode, an interlayer between the first electrode and the second electrode and including an emission layer, and
at least one of the organometallic compounds.

According to one or more embodiments an electronic apparatus includes the organic light-emitting device.

### BRIEF DESCRIPTION OF THE DRAWINGS

The above and other aspects and features of certain embodiments of the disclosure will be more apparent from the following description taken in conjunction with the accompanying drawings, in which:
FIG. 1 is a schematic cross-sectional view of an organic light-emitting device according to an embodiment;
FIG. 2 is a schematic cross-sectional view of a structure of an electronic device according to an embodiment;
FIG. 3 is a schematic cross-sectional view of a structure of an electronic device according to another embodiment;
FIG. 4 is a schematic perspective view of electronic equipment including an organic light-emitting device according to an embodiment;
FIG. 5 is a diagram illustrating the exterior of a vehicle as electronic equipment including an organic light-emitting device according to an embodiment; and
FIGS. 6A to 6C are each a diagram schematically illustrating the interior of a vehicle according to one or more embodiments.

### DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of embodiments. As used herein, the term "and/or" includes any and all combinations of one or more of the associated listed items. Expressions such as "at least one of," when preceding a list of elements, modify the entire list of elements and do not modify the individual elements of the list.

An aspect of the disclosure provides an organometallic compound represented by Formula 1: 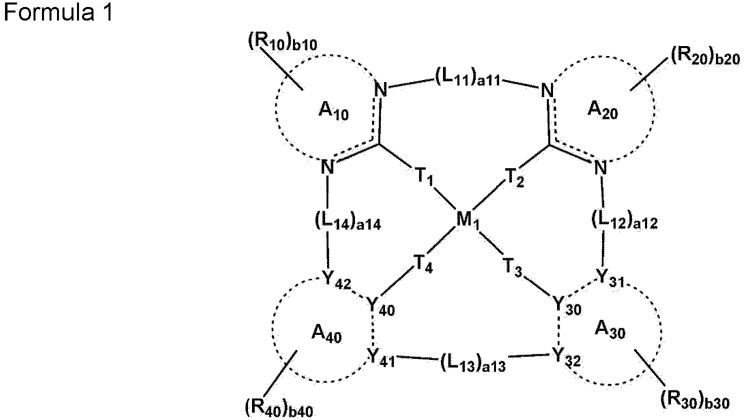 wherein, in Formula 1, M₁ is platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), or thulium (Tm).

In an embodiment, M₁ may be Pt, Pd, Cu, Ag, or Au.

In an embodiment, M₁ may be Pt or Pd.

In Formula 1, A₁₀ and A₂₀ are each independently an N-containing C₁-C₆₀ heterocyclic group.

In an embodiment, A₁₀ and A₂₀ may each independently be an imidazole group, a benzimidazole group, a 4,5,6,7-tetrahydrobenzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, or a 2,3-dihydroimidazopyrazine group.

In an embodiment, A₁₀ may be a group represented by Formula 10-1 or 10-2, and A₂₀ is a group represented by Formula 20-1 or 20-2: 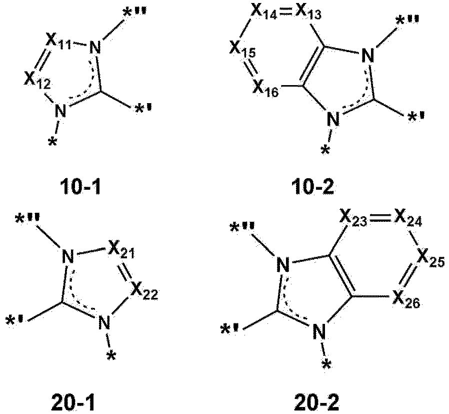 wherein, in Formulae 10-1, 10-2, 20-1, and 20-2,
X₁₁ may be C(R₁₁) or N, X₁₂ may be C(R₁₂) or N, X₁₃ may be C(R₁₃) or N, X₁₄ may be C(R₁₄) or N, X₁₅ may be C(R₁₅) or N, and X₁₆ may be C(R₁₆) or N,
X₂₁ may be C(R₂₁) or N, X₂₂ may be C(R₂₂) or N, X₂₃ may be C(R₂₃) or N, X₂₄ may be C(R₂₄) or N, X₂₅ may be C(R₂₅) or N, and X₂₆ may be C(R₂₆) or N,
R₁₁ to R₁₆ may each be the same as described in connection with R₁₀,
R₂₁ to R₂₆ may each be the same as described in connection with R₂₀, and
*, *', and *" each indicate a binding site to a neighboring atom.

In Formula 1, A₃₀ and A₄₀ are each independently a C₅-C₆₀ carbocyclic group or a C₁-C₆₀ heterocyclic group.

In an embodiment, A₃₀ and A₄₀ may each independently be a benzene group, a naphthalene group, an anthracene group, a phenanthrene group, a triphenylene group, a pyrene group, a chrysene group, a cyclopentadiene group, a 1,2,3,4-tetrahydronaphthalene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an indenopyridine group, an indolopyridine group, a benzofuropyridine group, a benzothienopyridine group, a benzosilolopyridine group, an indenopyrimidine group, an indolopyrimidine group, a benzofuropyrimidine group, a benzothienopyrimidine group, a benzosilolopyrimidine group, a dihydropyridine group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a 2,3-dihydroimidazole group, a triazole group, a 2,3-dihydrotriazole group, an oxazole group, an isoxazole group, a thiazole group, an isothiazole group, an oxadiazole group, a thiadiazole group, a benzopyrazole group, a benzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, a 2,3-dihydroimidazopyrazine group, a benzoxazole group, a benzothiazole group, a benzooxadiazole group, a benzothiadiazole group, a 5,6,7,8-tetrahydroisoquinoline group, or a 5,6,7,8-tetrahydroquinoline group.

In an embodiment, A₃₀ and A₄₀ may each independently be a group represented by one of Formulae 2-1 to 2-43: 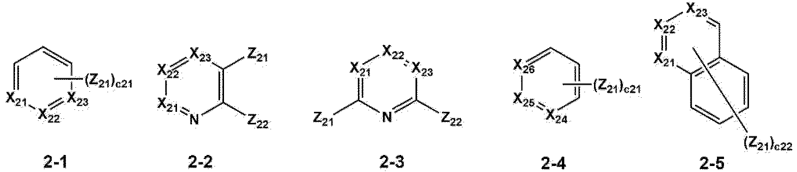 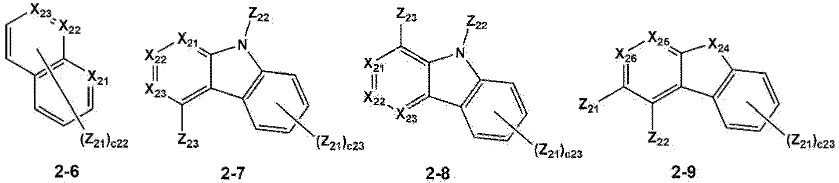 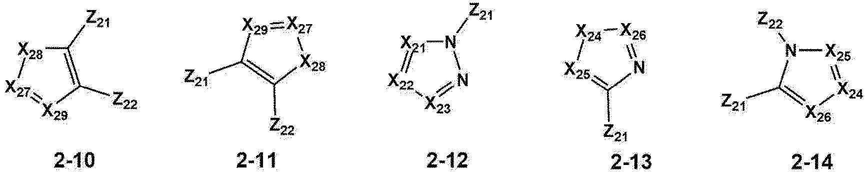 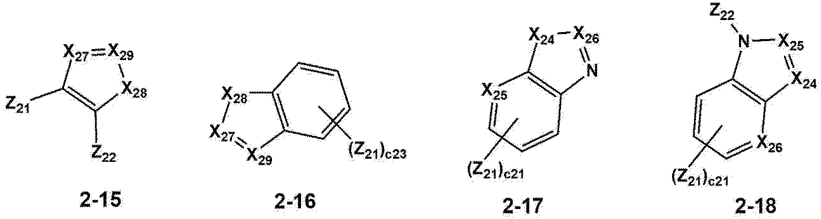 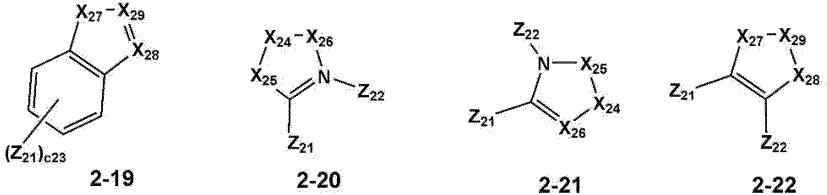 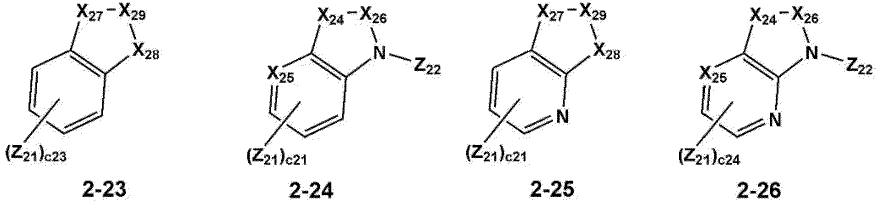 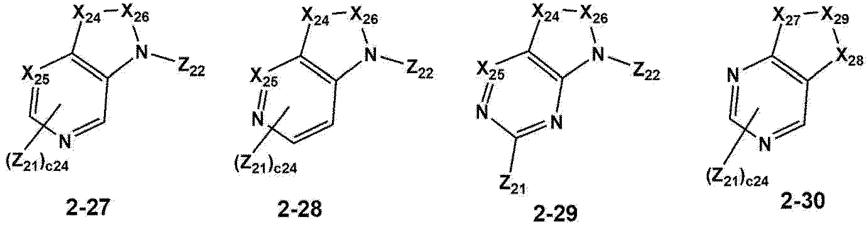 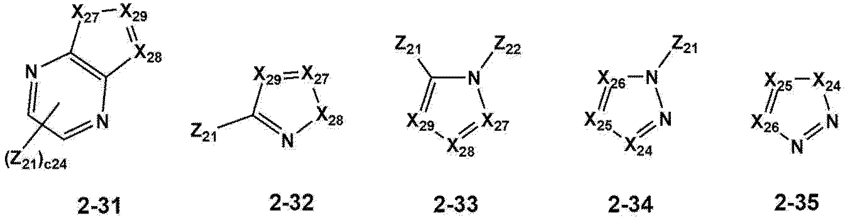 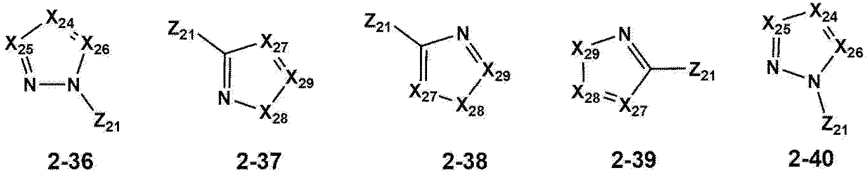 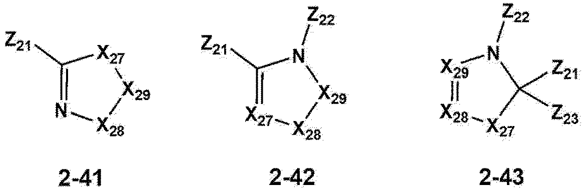 wherein, in Formulae 2-1 to 2-43,
X₂₁ to X₂₃ may each independently be C(Z₂₄) or C-*, wherein at least two of X₂₁ to X₂₃ may each be C-*,
X₂₄ may be N-*, and X₂₅ and X₂₆ may each independently be C(Z₂₄) or C-*, wherein at least one of X₂₅ and X₂₆ may be C-*,
X₂₇ and X₂₈ may each independently be N, N(Z₂₅), or N-*, X₂₉ may be C(Z₂₄) or C-*, wherein i) at least one of X₂₇ and X₂₈ may each be N-*, and X₂₉ may be C-*, or ii) X₂₇ and X₂₈ may be N-*, and X₂₉ may be C(Z₂₄),
Z₂₁ to Z₂₅ may each independently be deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkenyl group, a C₁-C₂₀ alkynyl group, a C₁-C₂₀ alkoxy group, a phenyl group, a biphenyl group, a terphenyl group, a naphthyl group, a fluorenyl group, a spiro-bifluorenyl group, a phenanthrenyl group, an anthracenyl group, a triphenylenyl group, a pyridinyl group, a pyrimidinyl group, a carbazolyl group, or a triazinyl group,
c21 may be 1, 2, or 3,
c22 may be 1, 2, 3, 4, or 5,
c23 may be 1, 2, 3, or 4,
c24 may be 1 or 2, and
* indicates a binding site to a neighboring atom.

In Formula 1, Y₃₀ and Y₄₀ are each independently C or N.

In Formula 1, Y₃₁, Y₃₂, Y₄₁, and Y₄₂ are each independently N or C.

In Formula 1, T₁ to T₄ each represent a chemical bond.

For example, T₁ to T₄ may each represent a coordinate bond (which may also be referred to as a coordinate covalent bond or a dative bond) or a covalent bond.

In an embodiment, two of T₁ to T₄ may each be a coordinate bond, and the other two may each be a covalent bond. Accordingly, the organometallic compound may be electrically neutral without having a salt form including or consisting of a cation and an anion.

In an embodiment, T₁ and T₂ may each be a coordinate bond, and T₃ and T₄ may each be a covalent bond.

In Formula 1, L₁₁ is *-O-*', *-S-*', *-C(R₁)(R₂)-*', *-C(R₁)=*', *=C(R₁)-*', *-C(R₁)=C(R₂)-*', *-C(=O)-*', *-C(=S)-*', *-C≡C-*', *-B(R₁)-*', *-N(R₁)-*', *-P(R₁)-*', *-Si(R₁)(R₂)-*', *-P(R₁)(R₂)-*', *-Ge(R₁)(R₂)-*', a C₅-C₆₀ carbocyclic group unsubstituted or substituted with at least one R₁₀ₐ, or a C₁-C₆₀ heterocyclic group unsubstituted or substituted with at least one R₁₀ₐ.

In an embodiment, L₁₁ may be *-O-*', *-S-*', *-N(R₁)-*', *-C(R₁)(R₂)-*', *-Si(R₁)(R₂)-*' *-B(R₁)-*', or a C₅-C₆₀ carbocyclic group unsubstituted or substituted with at least one R₁₀ₐ.

In an embodiment, L₁₁ may be *-C(R₁)(R₂)-*' or a C₅-C₆₀ carbocyclic group unsubstituted or substituted with at least one R₁₀ₐ.

In an embodiment, L₁₁ may be: *-C(R₁)(R₂)-*'; or a cyclopropane group, a cyclobutane group, a cyclopentane group, a cyclohexane group, a cycloheptane group, a cyclopropene group, a cyclobutene group, a cyclopentene group, a cyclohexene group, a cycloheptene group, or a benzene group, each unsubstituted or substituted with at least one R₁₀ₐ.

In an embodiment, L₁₁ may be *-C(R₁)(R₂)-*'.

In Formula 1, L₁₂ to L₁₄ are each independently *-O-*', *-S-*', *-C(R₃)(R₄)-*', *-C(R₃)=*', *=C(R₃)-*', *-C(R₃)=C(R₄)-*', *-C(=O)-*', *-C(=S)-*', *-C≡C-*', *-B(R₃)-*', *-N(R₃)-*', *-P(R₃)-*', *-Si(R₃)(R₄)-*', *-P(R₃)(R₄)-*', *-Ge(R₃)(R₄)-*', a C₅-C₆₀ carbocyclic group unsubstituted or substituted with at least one R₁₀ₐ, or a C₁-C₆₀ heterocyclic group unsubstituted or substituted with at least one R₁₀ₐ.

In an embodiment, L₁₂ to L₁₄ may each independently be *-O-*', *-S-*', *-N(R₃)-*', *-C(R₃)(R₄)-*', *-Si(R₃)(R₄)-*', or *-B(R₃)-*'.

In an embodiment, at least one of L₁₁ to L₁₄ may be *-O-*' or *-S-*'. *, and *' each indicate a binding site to a neighboring atom.

In Formula 1, a11 is 1, 2, 3, 4, or 5.

In an embodiment, a11 may be 1 or 2.

In an embodiment, a11 may be 1.

In Formula 1, a12, a13, and a14 are each independently 0, 1, 2, 3, 4, or 5.

In an embodiment, a12, a13, and a14 may each be 1.

In Formula 1, R₁ to R₄, R₁₀, R₂₀, R₃₀, and R₄₀ are each independently hydrogen, deuterium, -F, -Cl, -Br, -I, a hydroxyl group, a cyano group, a nitro group, an amidino group, a hydrazino group, a hydrazono group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₁₀ cycloalkyl group unsubstituted or substituted with at least one R₁₀ₐ, a C₁-C₁₀ heterocycloalkyl group unsubstituted or substituted with at least one R₁₀ₐ, a C₃-C₁₀ cycloalkenyl group unsubstituted or substituted with at least one R₁₀ₐ, a C₁-C₁₀ heterocycloalkenyl group unsubstituted or substituted with at least one R₁₀ₐ, a C₆-C₆₀ aryl group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₁-C₆₀ heteroaryl group unsubstituted or substituted with at least one R₁₀ₐ, a C₁-C₆₀ heteroaryloxy group unsubstituted or substituted with at least one R₁₀ₐ, a C₁-C₆₀ heteroarylthio group unsubstituted or substituted with at least one R₁₀ₐ, a monovalent non-aromatic condensed polycyclic group unsubstituted or substituted with at least one R₁₀ₐ, a monovalent non-aromatic condensed heteropolycyclic group unsubstituted or substituted with at least one R₁₀ₐ, - Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂), or -P(=S)(Q₁)(Q₂).

In Formula 1, b10, b20, b30, and b40 are each independently 1, 2, 3, 4, 5, 6, 7, or 8.

In Formula 1. neighboring two or more of R₁ to R₄, R₁₀, R₂₀, R₃₀, and R₄₀ may optionally be bonded together to form a C₅-C₆₀ carbocyclic group unsubstituted or substituted with at least one R₁₀ₐ or a C₁-C₆₀ heterocyclic group unsubstituted or substituted with at least one R₁₀ₐ.
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, - Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In an embodiment, R₁ to R₄, R₁₀, R₂₀, R₃₀, and R₄₀ may each independently be: hydrogen, deuterium, -F, -Cl, -Br, -I, a cyano group, a C₁-C₂₀ alkyl group, or a C₁-C₂₀ alkoxy group;
a C₁-C₂₀ alkyl group, a C₁-C₂₀ alkoxy group, or a C₃-C₁₀ cycloalkyl group, each substituted with deuterium, -F, -Cl, -Br, -I, -CDH₂, -CD₂H, -CD₃, a cyano group, a phenyl group, a biphenyl group, or any combination thereof;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indenocarbazolyl group, or an indolocarbazolyl group;
a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indenocarbazolyl group, or an indolocarbazolyl group, each substituted with deuterium, -F, -Cl, -Br, -I, -CDH₂, -CD₂H, - CD₃, a cyano group, a C₁-C₂₀ alkyl group, a C₁-C₂₀ alkoxy group, a C₃-C₁₀ cycloalkyl group, a cyclopentyl group, a cyclohexyl group, a cycloheptyl group, a cyclopentenyl group, a cyclohexenyl group, a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a perylenyl group, a pentacenyl group, a pyrrolyl group, a thiophenyl group, a furanyl group, a silolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an indolyl group, an isoindolyl group, an indazolyl group, a purinyl group, a quinolinyl group, an isoquinolinyl group, a benzoquinolinyl group, a benzoisoquinolinyl group, a phthalazinyl group, a naphthyridinyl group, a quinoxalinyl group, a benzoquinoxalinyl group, a quinazolinyl group, a benzoquinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzosilolyl group, a benzothiazolyl group, a benzoisothiazolyl group, a benzoxazolyl group, a benzoisoxazolyl group, a triazolyl group, a tetrazolyl group, a thiadiazolyl group, an oxadiazolyl group, a triazinyl group, a carbazolyl group, a dibenzofuranyl group, a dibenzothiophenyl group, a dibenzosilolyl group, a benzocarbazolyl group, a naphthobenzofuranyl group, a naphthobenzothiophenyl group, a naphthobenzosilolyl group, a dibenzocarbazolyl group, a dinaphthofuranyl group, a dinaphthothiophenyl group, a dinaphthosilolyl group, an imidazopyridinyl group, an imidazopyrimidinyl group, an oxazolopyridinyl group, a thiazolopyridinyl group, a benzonaphthyridinyl group, an azafluorenyl group, an azaspiro-bifluorenyl group, an azacarbazolyl group, an azadibenzofuranyl group, an azadibenzothiophenyl group, an azadibenzosilolyl group, an indenopyrrolyl group, an indolopyrrolyl group, an indenocarbazolyl group, an indolocarbazolyl group, -Si(Q₃₁)(Q₃₂)(Q₃₃), -N(Q₃₁)(Q₃₂), -B(Q₃₁)(Q₃₂), -C(=O)(Q₃₁), - S(=O)(Q₃₁), -S(=O)₂(Q₃₁), -P(=O)(Q₃₁)(Q₃₂), -P(=S)(Q₃₁)(Q₃₂), or any combination thereof; or
-Si(Q₁)(Q₂)(Q₃), -B(Q₁)(Q₂), -N(Q₁)(Q₂), -P(Q₁)(Q₂), -C(=O)(Q₁), -S(=O)(Q₁), - S(=O)₂(Q₁), -P(=O)(Q₁)(Q₂), or -P(=S)(Q1)(Q₂).

In an embodiment, R₁ to R₄, R₁₀, R₂₀, R₃₀, and R₄₀ may each independently be: hydrogen, deuterium, -F, -Cl, -Br, -I, a cyano group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, -Br, -I, a cyano group, a phenyl group, a biphenyl group, or any combination thereof; or
a group represented by one of Formulae 5-1 to 5-26 and Formulae 6-1 to 6-55: 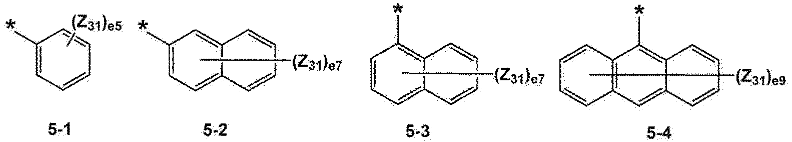 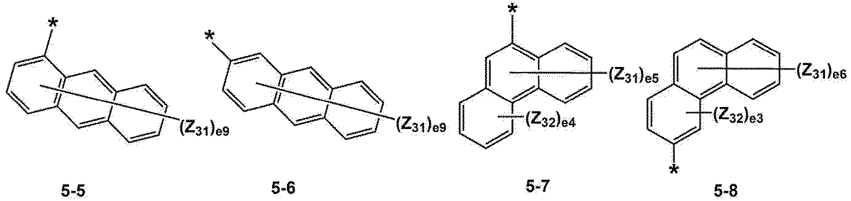 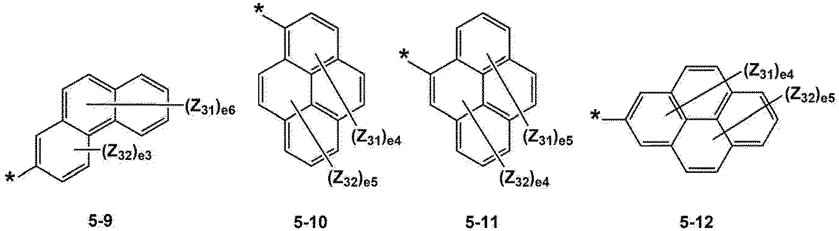 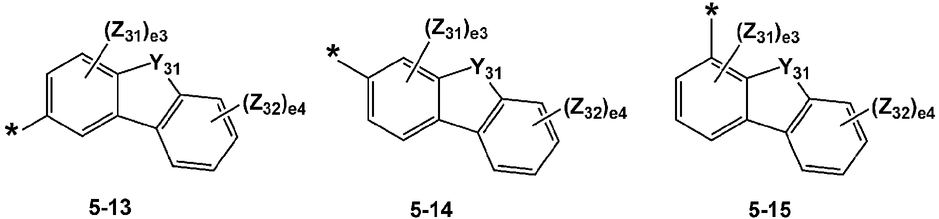 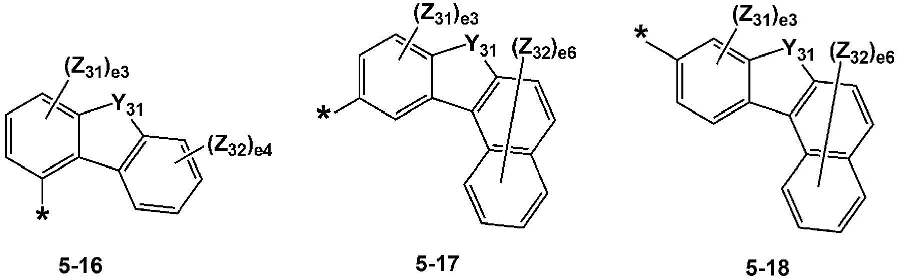 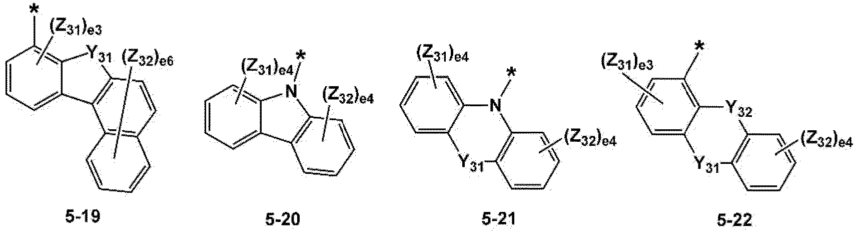 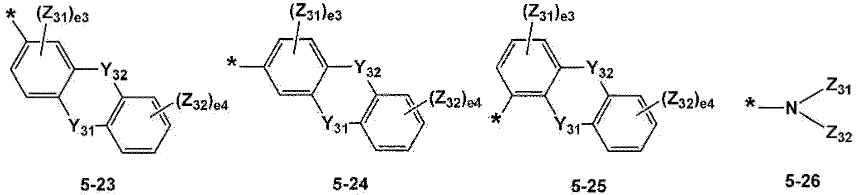 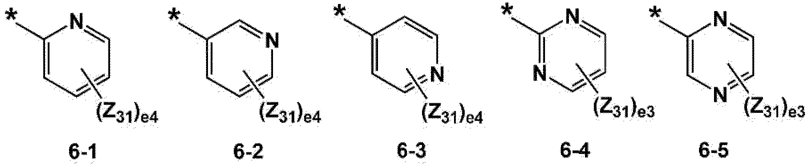 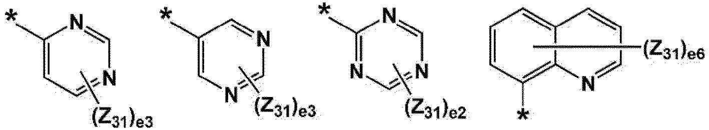 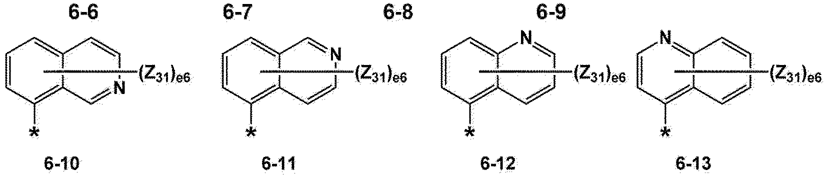 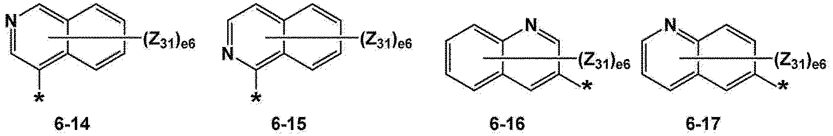 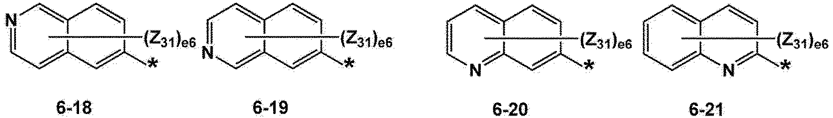 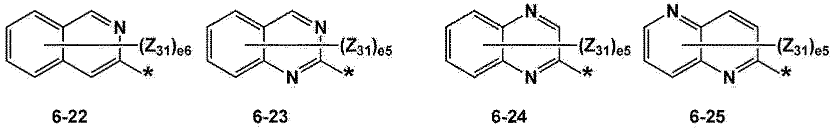 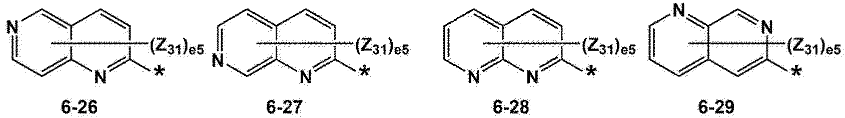 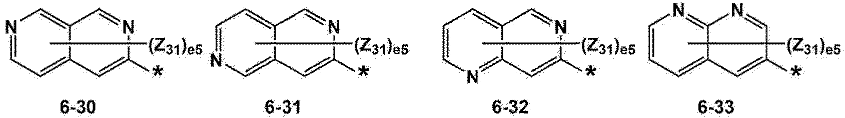 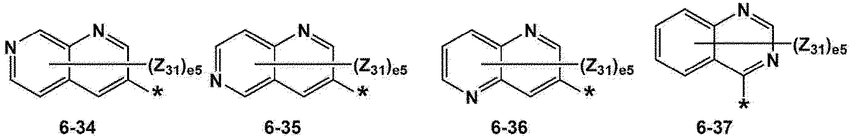 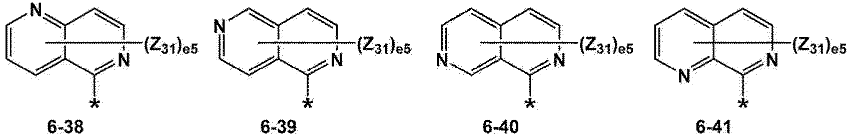 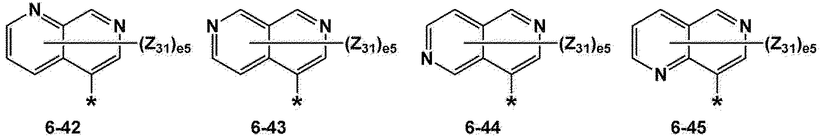 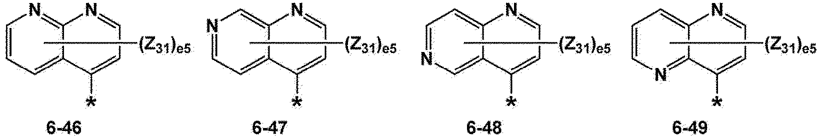 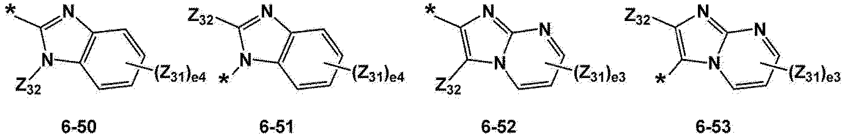 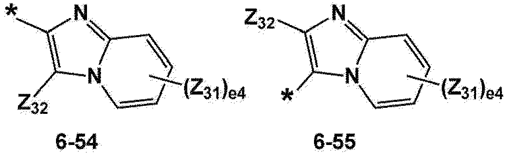
wherein, in Formulae 5-1 to 5-26 and 6-1 to 6-55,
Y₃₁ and Y₃₂ may each independently be O, S, C(Z₃₃)(Z₃₄), N(Z₃₃), or Si(Z33)(Z34),
Z₃₁ to Z₃₄ may each independently be selected from hydrogen, deuterium, -F, - Cl, -Br, -I, a hydroxyl group, a cyano group, a nitro group, an amidino group, a hydrazino group, a hydrazono group, a C₁-C₂₀ alkyl group, a C₁-C₂₀ alkenyl group, a C₁-C₂₀ alkynyl group, a C₁-C₂₀ alkoxy group, a phenyl group, a biphenyl group, a terphenyl group, a naphthyl group, a fluorenyl group, a spiro-bifluorenyl group, a phenanthrenyl group, an anthracenyl group, a triphenylenyl group, a pyridinyl group, a pyrimidinyl group, a carbazolyl group, and a triazinyl group,
e2 may be 1 or 2,
e3 may be an integer from 1 to 3,
e4 may be an integer from 1 to 4,
e5 may be an integer from 1 to 5,
e6 may be an integer from 1 to 6,
e7 may be an integer from 1 to 7,
e9 may be an integer from 1 to 9, and
* indicates a binding site to a neighboring atom.

In an embodiment, neighboring two or more of R₁ to R₄, R₁₀, R₂₀, R₃₀, and R₄₀ may optionally be bonded together to form:
a cyclopropane group, a cyclobutane group, a cyclopentane group, a cyclohexane group, a cycloheptane group, a cyclopropene group, a cyclobutene group, a cyclopentene group, a cyclohexene group, a cycloheptene group, a benzene group, a naphthalene group, a fluorene group, a phenanthrene group, a carbazole group, a dibenzofuran group, a dibenzothiophene group, or a dibenzosilole group, each unsubstituted or substituted with at least one R₁₀ₐ.

In an embodiment, R₁ and R₂ may not combine with each other to form a ring.

In an embodiment, R₁ to R₄, R₁₀, R₂₀, R₃₀, and R₄₀ may each independently be a group represented by one of Formulae 5-1 to 5-26 and 6-1 to 6-55.

In an embodiment, R₁ to R₄, R₁₀, R₂₀, R₃₀, and R₄₀ may each independently be selected from: hydrogen, deuterium, -F, -Cl, -Br, -I, a cyano group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a cyano group, a phenyl group, and a biphenyl group;
a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a carbazolyl group, an acridinyl group, a dibenzofuranyl group, a dibenzothiophenyl group, a benzocarbazolyl group, and a dibenzocarbazolyl group; and
a phenyl group, a biphenyl group, a terphenyl group, a pentalenyl group, an indenyl group, a naphthyl group, an azulenyl group, an indacenyl group, an acenaphthyl group, a fluorenyl group, a spiro-bifluorenyl group, a benzofluorenyl group, a dibenzofluorenyl group, a carbazolyl group, an acridinyl group, a dibenzofuranyl group, a dibenzothiophenyl group, a benzocarbazolyl group, and a dibenzocarbazolyl group, each substituted with at least one of deuterium, -F, -Cl, -Br, -I, a cyano group, a C₁-C₂₀ alkyl group, a C₁-C₂₀ alkoxy group, a phenyl group, and a biphenyl group.

In Formula 1, b10, b20, b30, and b40 may each independently be 1, 2, 3, 4, 5, 6, 7, or 8.

In an embodiment, the organometallic compound represented by Formula 1 may be a compound represented by one of Formulae 11 to 13: 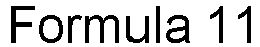 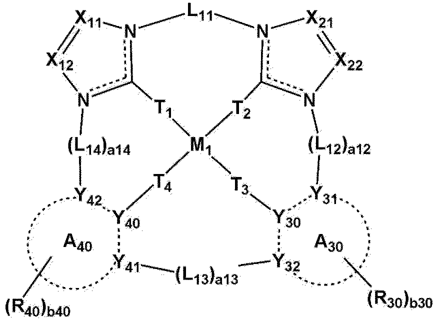 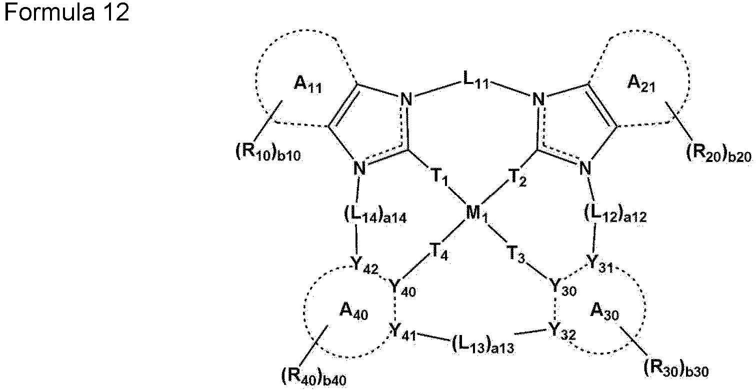 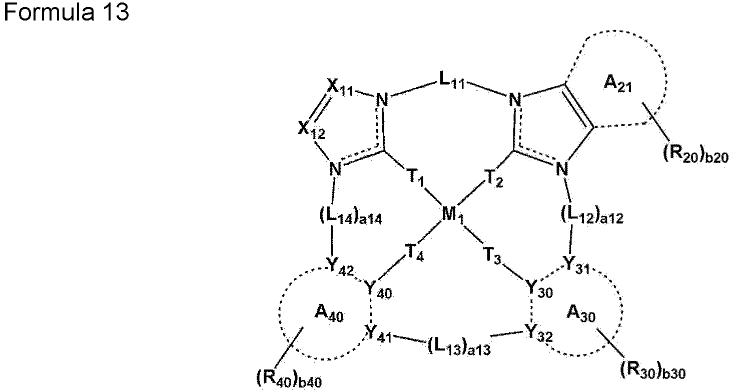 wherein, in Formulae 11 to 13,
M₁, A₃₀, A₄₀, Y₃₀ to Y₃₂, Y₄₀ to Y₄₂, T₁ to T₄, L₁₁ to L₁₄, a12 to a14, R₁₀, R₂₀, R₃₀, R₄₀, b10, b20, b30, and b40 may each be the same as described herein,
X₁₁ may be C(R₁₁) or N, X₁₂ may be C(R₁₂) or N,
X₂₁ may be C(R₂₁) or N, and X₂₂ may be C(R₂₂) or N,
R₁₁ and R₁₂ may each be the same as described in connection with R₁₀,
R₂₁ and R₂₂ may each be the same as described in connection with R₂₀, and
A₁₁ and A₂₁ are each independently a cyclopentene group, a cyclohexane group, a benzene group, a naphthalene group, a fluorene group, an anthracene group, a phenanthrene group, a carbazole group, a dibenzofuran group, a dibenzothiophene group, a dibenzosilole group, a pyridine group, a pyrimidine group, a pyrazine group, a triazine group, a quinoline group, an isoquinoline group, a quinoxaline group, or a quinazoline group.

In an embodiment, the organometallic compound represented by Formula 1 may be a compound represented by one of Formulae 31 to 33: 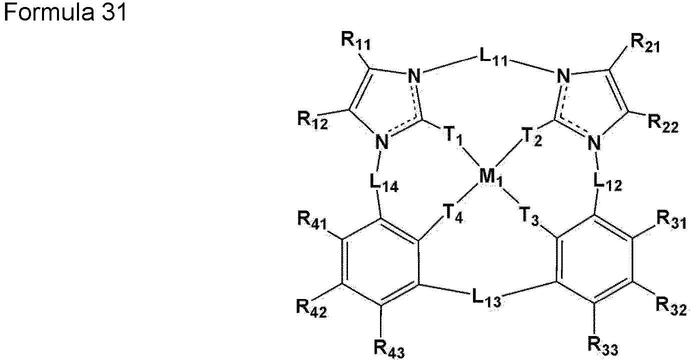 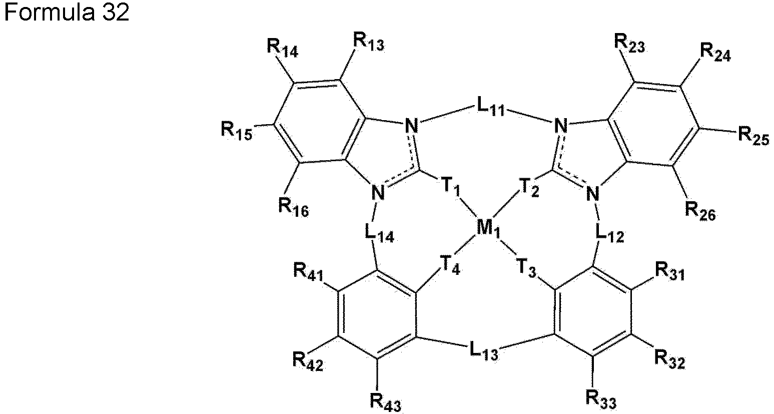 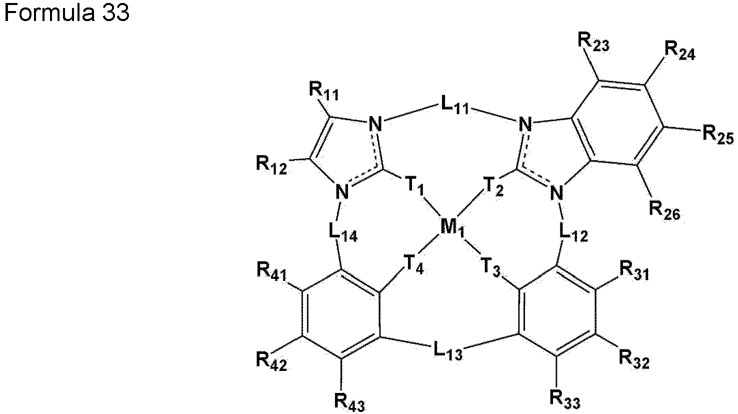 wherein, in Formulae 31 to 33,
M₁, T₁ to T₄, and L₁₁ to L₁₄ may each be the same as described herein,
R₁₁ to R₁₆ may each independently be the same as described in connection with R₁₀,
R₂₁ to R₂₆ may each independently be the same as described in connection with R₂₀,
R₃₁ to R₃₃ may each independently be the same as described in connection with R₃₀, and
R₄₁ to R₄₃ may each independently be the same as described in connection with R₄₀.

In an embodiment, the organometallic compound may be electrically neutral.

In an embodiment, the organometallic compound may have a structure in which metallocycles are all 6-or-more-membered rings.

For example, the metallocycles of the organometallic compound may be 6-membered rings or 7-membered rings.

In an embodiment, the metallocycles of the organometallic compound may all be 6-membered rings.

In an embodiment, the organometallic compound may be represented by Formula 1A, in which CY₁ to CY₄ may all be 6-or-more membered rings: 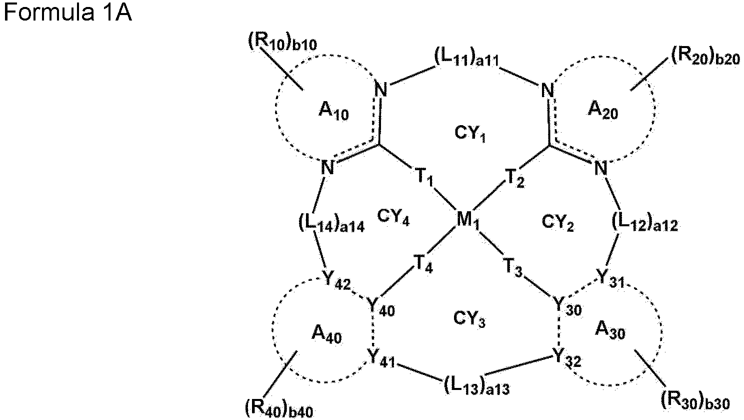 wherein, in Formula 1A,
M₁, A₁₀, A₂₀, A₃₀, A₄₀, Y₃₀, Y₄₀, Y₃₁, Y₃₂, Y₄₁, Y₄₂, T₁ to T₄, L₁₁ to L₁₄, a11 to a14, R₁₀, R₂₀, R₃₀, R₄₀, b10, b20, b30, and b40 may each be the same as described herein.

In an embodiment, CY₁ to CY₄ may each independently be a 6-membered ring or a 7-membered ring.

In an embodiment, CY₂ and CY₄ may each independently be a 6-membered ring.

In an embodiment, CY₂ to CY₄ may each independently be a 6-membered ring.

In an embodiment, CY₁ to CY₄ may each independently be a 6-membered ring.

In an embodiment, the organometallic compound represented by Formula 1 may be selected from Compounds 1 to 71, but embodiments are not limited thereto:

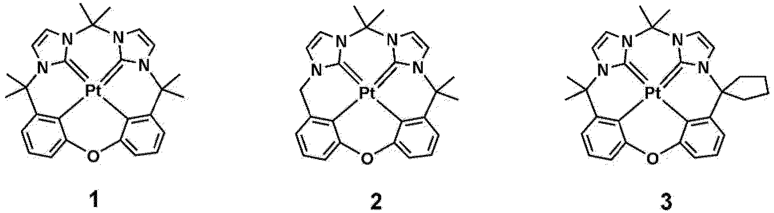

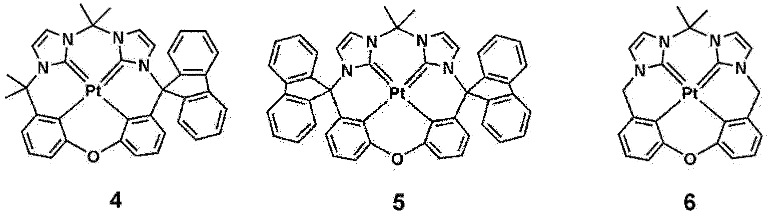

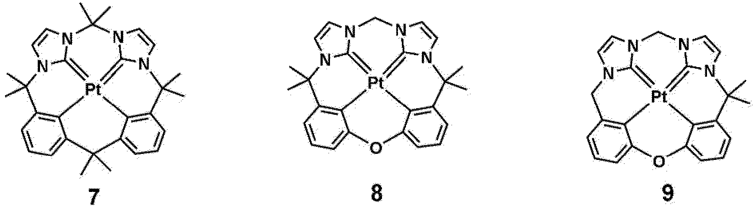

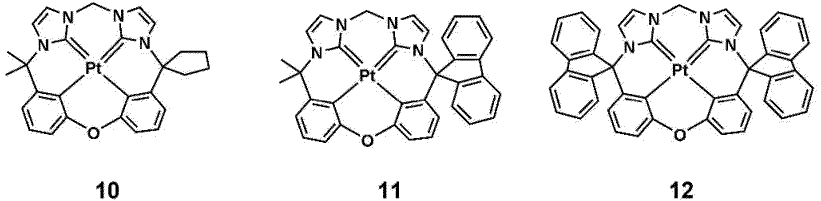

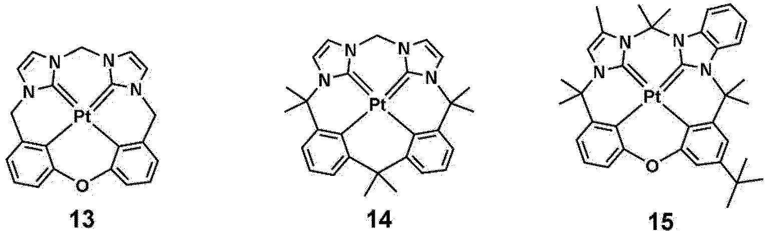

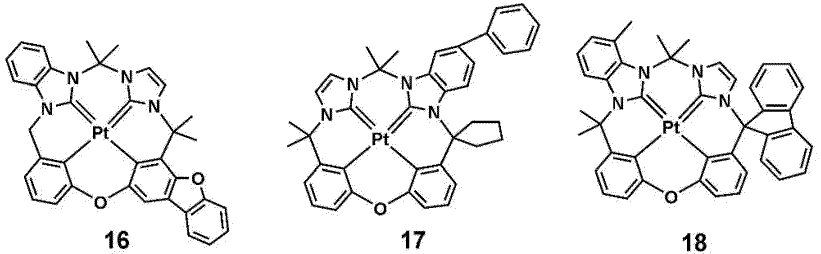

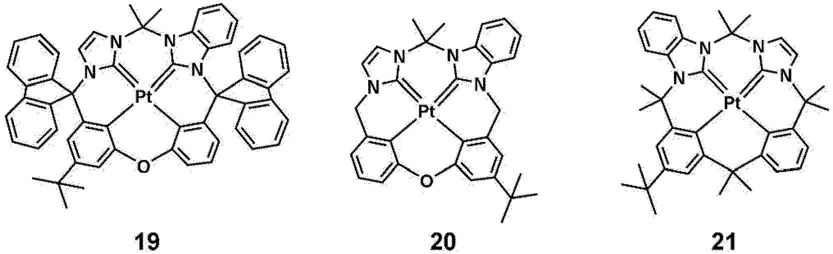

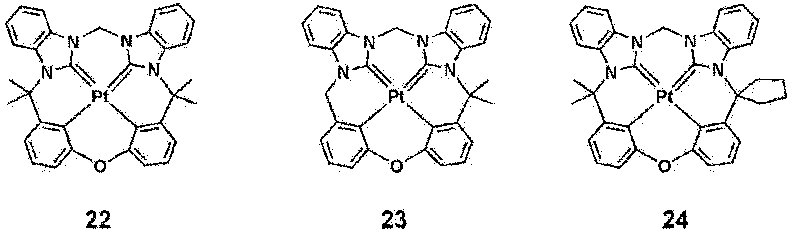

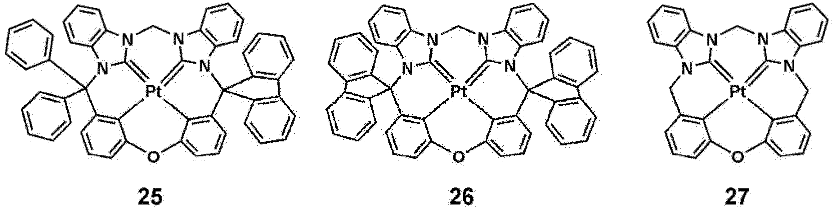

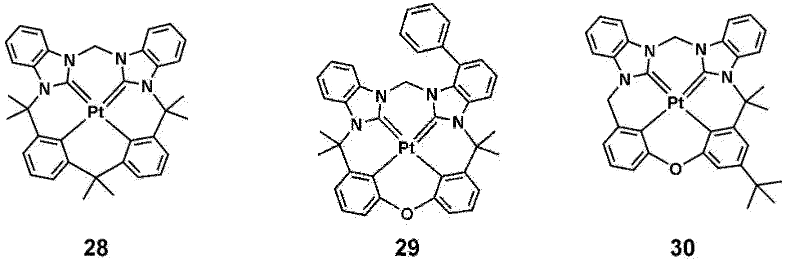

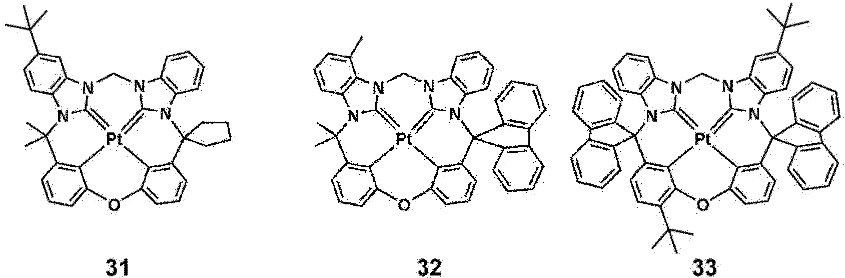

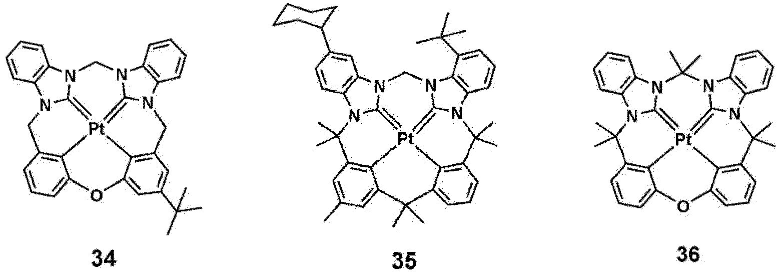

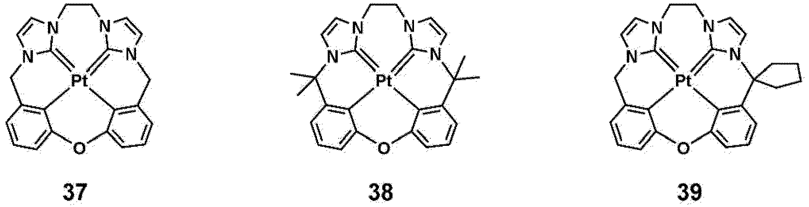

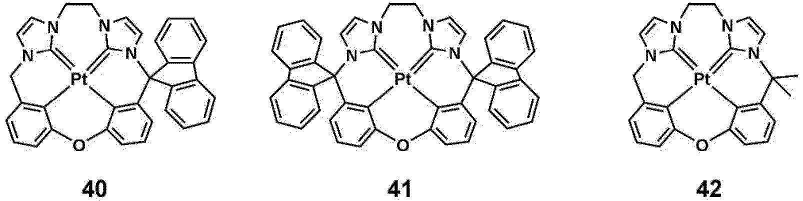

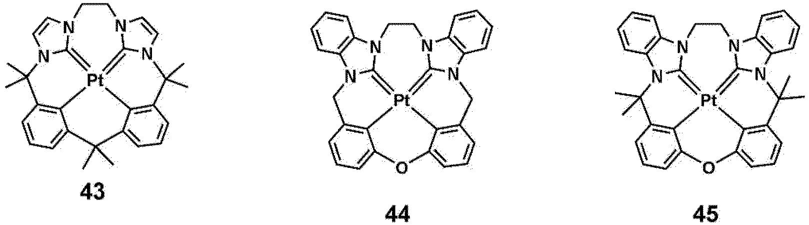

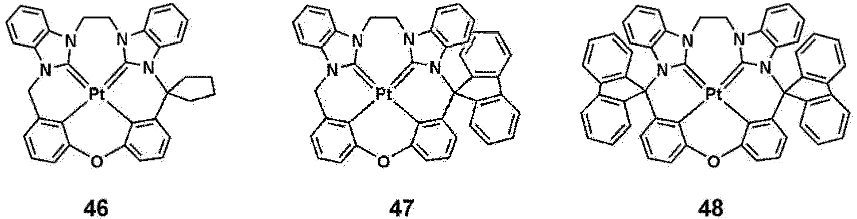

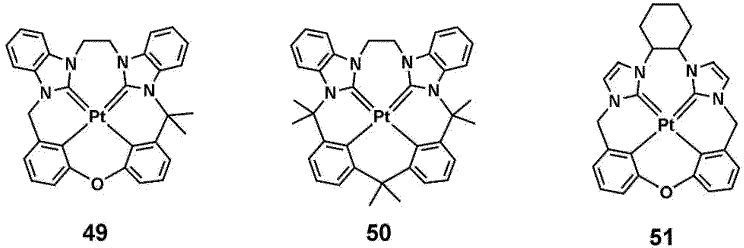

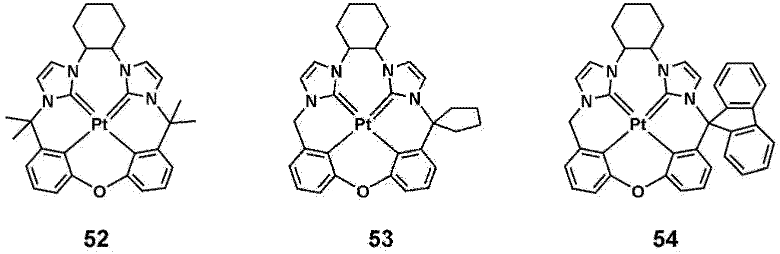

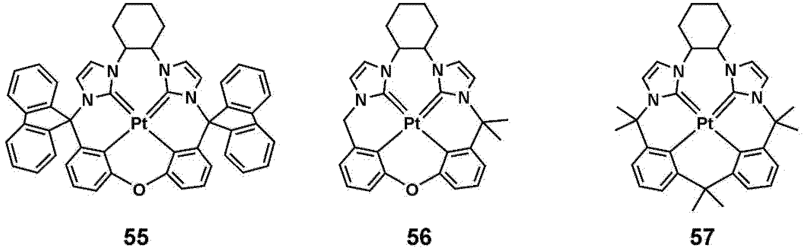

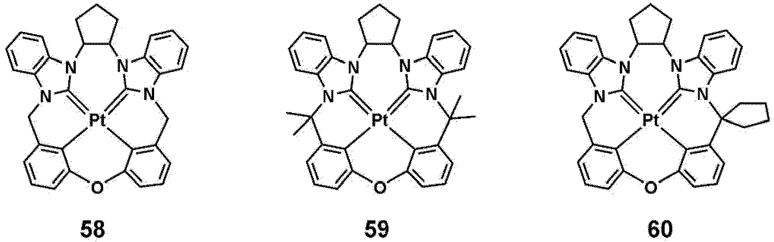

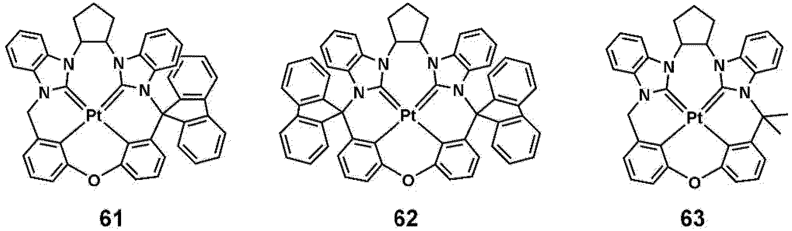

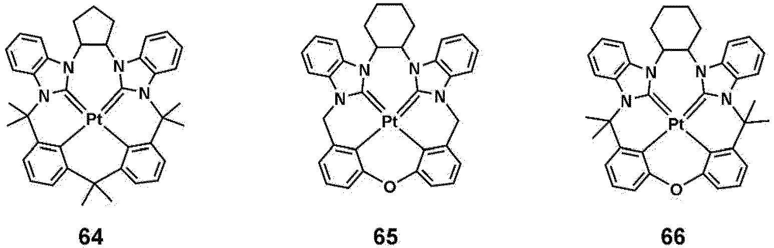

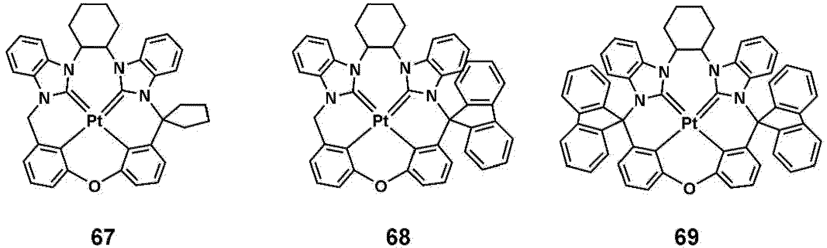

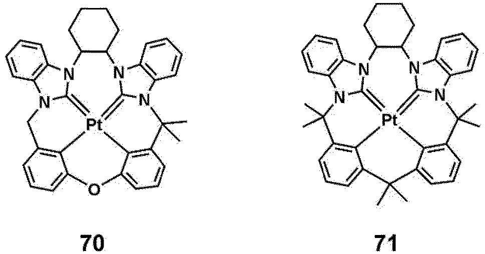

The organometallic compound represented by Formula 1 includes at least two carbene groups, and thus bonding to metal M₁ may be stable, thereby improving the stability of the organometallic compound. Also, the spin-orbit coupling is also improved, thereby improving color purity as well as luminescence efficiency.

Accordingly, when the organometallic compound represented by Formula 1 is applied to the organic light-emitting device, the color purity, luminescence efficiency, and lifespan characteristics may be improved. For example, when the emission layer of the organic light-emitting device includes the organometallic compound represented by Formula 1, the organic light-emitting device emitting deep blue with excellent color purity, luminescence efficiency, and lifespan characteristics may be implemented.

Also, when the emission layer of the organic light-emitting device includes the organometallic compound represented by Formula 1 as a sensitizer, blue shift occurs so that the Förster resonance energy transfer (FRET) of an emitter in the emission layer may be improved, thereby improving the luminescence efficiency and lifespan characteristics of the organic light-emitting device.

The organometallic compound may emit blue light. For example, the organometallic compound may emit blue light having a maximum emission wavelength of greater than or equal to 400 nm and less than 500 nm, for example, greater than or equal to 410 nm and less than 490 nm (bottom emission CIE_{x,y} color coordinates of 0.15, 0.05 to 0.15), embodiments are not limited thereto. Thus, the organometallic compound represented by Formula 1 may be useful in manufacturing an organic light-emitting device that emits blue light.

Synthesis methods of the organometallic compound represented by Formula 1 may be recognizable by one of ordinary skill in the art by referring to Examples provided below.

In an embodiment, the first electrode of the organic light-emitting device may be an anode, the second electrode of the organic light-emitting device may be a cathode, and the interlayer may further include a hole transport region between the first electrode and the emission layer and an electron transport region between the emission layer and the second electrode, wherein the hole transport region may include a hole injection layer, a hole transport layer, an emission auxiliary layer, an electron blocking layer, or any combination thereof, and the electron transport region may include a hole blocking layer, an electron transport layer, an electron injection layer, or any combination thereof.

In an embodiment, the emission layer may include the organometallic compound represented by Formula 1. For example, the emission layer may emit blue light having a maximum emission wavelength of about 400 nm to about 500 nm.

In one or more embodiments, the emission layer of the organic light-emitting device may include a dopant and a host, and the dopant may include the organometallic compound represented by Formula 1. That is, the organometallic compound may act as a dopant. The emission layer may emit, for example, blue light. The blue light may have, for example, a maximum emission wavelength of about 400 nm to about 500 nm.

In an embodiment, the emission layer may include a host and a dopant.

In an embodiment, in the emission layer, an amount of the host may be greater than that of the dopant based on a weight.

In an embodiment, the host may be understood by referring to the description of the host provided herein.

Therefore, a light-emitting device (e.g., the organic light-emitting device) including the organometallic compound represented by Formula 1 may have high color purity, high luminescence efficiency, low driving voltage, and long lifespan characteristics.

In an embodiment, the organometallic compound represented by Formula 1 may emit blue light. For example, the organometallic compound represented by Formula 1 may emit blue light having a maximum emission wavelength of about 390 nm to about 500 nm, about 410 nm to about 500 nm, about 410 nm to about 490 nm, about 430 nm to about 480 nm, about 440 nm to about 475 nm, or about 455 nm to about 470 nm.

In an embodiment, the organometallic compound represented by Formula 1 may have a color purity in which a bottom emission CIEx coordinate is in a range of about 0.12 to about 0.15 or about 0.13 to about 0.14, and a bottom emission CIEy coordinate is in a range of about 0.06 to about 0.25, about 0.10 to about 0.20, or about 0.13 to about 0.20.

The term "interlayer" as used herein refers to a single layer and/or all of a plurality of layers between the first electrode and the second electrode of the light-emitting device.

Another aspect of embodiments of the disclosure provides an electronic apparatus including the organic light-emitting device. The electronic apparatus may further include a thin-film transistor. For example, the electronic apparatus may further include a thin-film transistor including a source electrode and a drain electrode, wherein the first electrode of the organic light-emitting device may be electrically connected to the source electrode or the drain electrode. In an embodiment, the electronic apparatus may further include a color filter, a color conversion layer, a touch screen layer, a polarizing layer, or any combination thereof. More details of the electronic apparatus may be referred to the descriptions provided herein.

Another aspect of embodiments of the disclosure provides an electronic apparatus including the organic light-emitting device.

For example, the electronic device may be a flat panel display, a curved display, a computer monitor, a medical monitor, a TV, a billboard, indoor and/or outdoor illuminations and/or signal light, a head-up display, a fully or partially transparent display, a flexible display, a rollable display, a foldable display, a stretchable display, a laser printer, a phone, a cell phone, a tablet, a phablet, a personal digital assistant (PDA), a wearable device, laptop computers, digital cameras, camcorders, viewfinders, micro displays, 3D displays, virtual and/or augmented reality displays, vehicles, a video wall including multiple displays tiled together, a theater and/or stadium screen, a phototherapy device, and/or a signage.

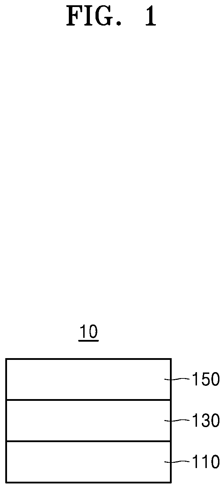

### Description of FIG. 1

FIG. 1 is a schematic cross-sectional view of an organic light-emitting device 10 according to an embodiment. The organic light-emitting device 10 includes a first electrode 110, an interlayer 130, and a second electrode 150.
Hereinafter, the structure of the organic light-emitting device 10 according to an embodiment and a method of manufacturing the organic light-emitting device 10 will be described in connection with FIG. 1.

### First electrode 110

In FIG. 1, a substrate may be additionally under the first electrode 110 and/or on the second electrode 150. In an embodiment, as the substrate, a glass substrate and/or a plastic substrate may be used. In one or more embodiments, the substrate may be a flexible substrate, and may include plastics having excellent heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing and/or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a transflective electrode, or a transmissive electrode. In an embodiment, when the first electrode 110 is a transmissive electrode, a material for forming the first electrode 110 may include indium tin oxide (ITO), indium zinc oxide (IZO), tin oxide (SnO₂), zinc oxide (ZnO), or any combination thereof. In one or more embodiments, when the first electrode 110 is a transflective electrode or a reflective electrode, a material for forming the first electrode 110 may include magnesium (Mg), silver (Ag), aluminum (Al), aluminum-lithium (Al-Li), calcium (Ca), magnesium-indium (Mg-In), magnesium-silver (Mg-Ag), or any combination thereof.

The first electrode 110 may have a single-layer structure consisting of a single layer or a multi-layer structure including a plurality of layers. For example, the first electrode 110 may have a three-layer structure of ITO/Ag/ITO.

### Interlayer 130

The interlayer 130 is on the first electrode 110. The interlayer 130 may include the emission layer.

The interlayer 130 may further include a hole transport region between the first electrode 110 and the emission layer, and an electron transport region between the emission layer and the second electrode 150.

The interlayer 130 may further include, in addition to various suitable organic materials, a metal-containing compound such as an organometallic compound, an inorganic material such as quantum dots, and/or the like.

In an embodiment, the interlayer 130 may include, i) two or more emitting units sequentially stacked between the first electrode 110 and the second electrode 150, and ii) a charge generation layer between the two or more emitting units. When the interlayer 130 includes the two or more emitting units and the charge generation layer, the organic light-emitting device 10 may be a tandem organic light-emitting device.

### Hole transport region in interlayer 130

The hole transport region may have: i) a single-layer structure consisting of a single layer consisting of a single material, ii) a single-layer structure consisting of a single layer consisting of a plurality of materials that are different from each other, or iii) a multi-layer structure including multiple layers including multiple materials that are different from each other.

The hole transport region may include a hole injection layer, a hole transport layer, an emission auxiliary layer, an electron blocking layer, or any combination thereof.

For example, the hole transport region may have a multi-layer structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein constituent layers of each structure are stacked sequentially from the first electrode 110.

The hole transport region may include a compound represented by Formula 201, a compound represented by Formula 202, or any combination thereof: 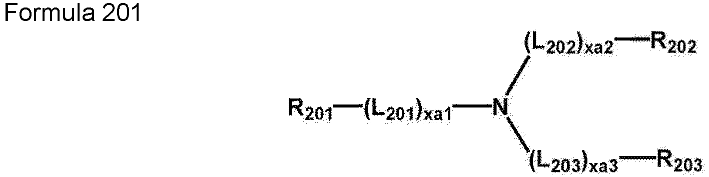 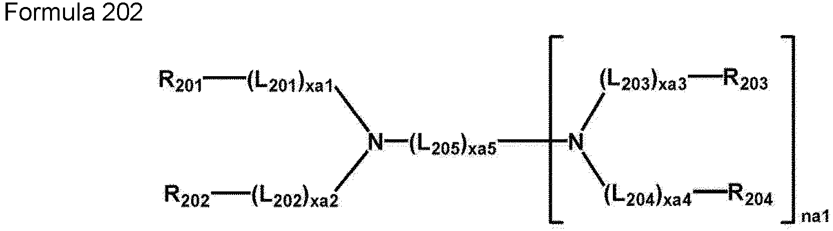 wherein, in Formulae 201 and 202, L₂₀₁ to L₂₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
L₂₀₅ may be *-O-*', *-S-*', *-N(Q₂₀₁)-*', a C₁-C₂₀ alkylene group unsubstituted or substituted with at least one R₁₀ₐ, a C₂-C₂₀ alkenylene group unsubstituted or substituted with at least one R₁₀ₐ, a C₃-C₆₀ carbocyclic group unsubstituted or substituted with at least one R₁₀ₐ, or a C₁-C₆₀ heterocyclic group unsubstituted or substituted with at least one R₁₀ₐ, * and *' each indicate a binding site to a neighboring atom,
xa1 to xa4 may each independently be an integer from 0 to 5,
xa5 may be an integer from 1 to 10,
R₂₀₁ to R₂₀₄ and Q₂₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
R₂₀₁ and R₂₀₂ may optionally be linked to each other via a single bond (e.g., a covalent bond), a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group (for example, a carbazole group, etc.) unsubstituted or substituted with at least one R₁₀ₐ (for example, Compound HT16, etc.),
R₂₀₃ and R₂₀₄ may optionally be bonded to each other via a single bond (e.g., a covalent bond), a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ polycyclic group unsubstituted or substituted with at least one R₁₀ₐ, and
na1 may be an integer from 1 to 4.

For example, each of Formulae 201 and 202 may include at least one of groups represented by Formulae CY201 to CY217:

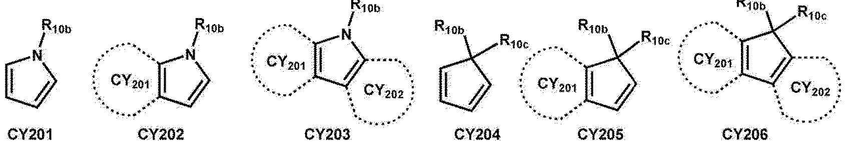

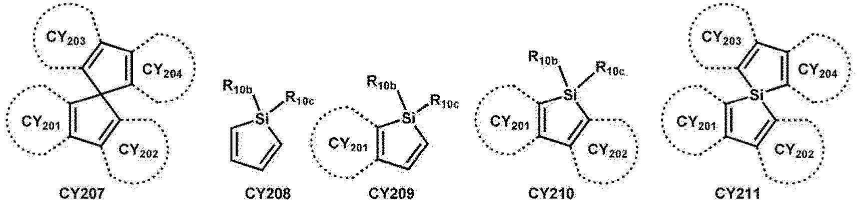

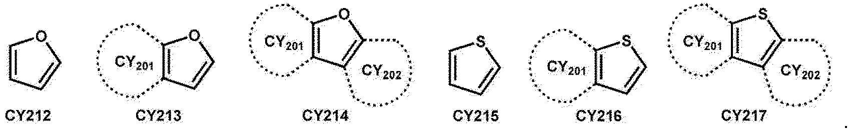

In Formulae CY201 to CY217, R_{10b} and R_{10c} may each be the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ.

In an embodiment, in Formulae CY201 to CY217, ring CY₂₀₁ to ring CY₂₀₄ may each independently be a benzene group, a naphthalene group, a phenanthrene group, or an anthracene group.

In one or more embodiments, each of Formulae 201 and 202 may include at least one of the groups represented by Formulae CY201 to CY203.

In one or more embodiments, Formula 201 may include at least one of the groups represented by Formulae CY201 to CY203 and at least one of the groups represented by Formulae CY204 to CY217.

In one or more embodiments, in Formula 201, xa1 may be 1, R₂₀₁ may be one of the groups represented by Formulae CY201 to CY203, xa2 may be 0, and R₂₀₂ may be one of the groups represented by Formulae CY204 to CY207.

In one or more embodiments, each of Formulae 201 and 202 may not include the groups represented by Formulae CY201 to CY203.

In one or more embodiments, each of Formulae 201 and 202 may not include the groups represented by Formulae CY201 to CY203, and may include at least one of the groups represented by Formulae CY204 to CY217.

In one or more embodiments, each of Formulae 201 and 202 may not include the groups represented by Formulae CY201 to CY217.

In an embodiment, the hole transport region may include one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or any combination thereof:

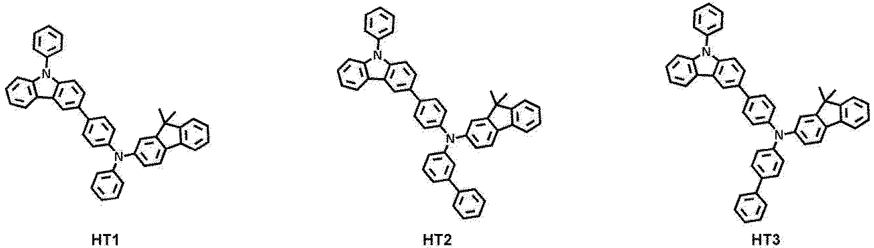

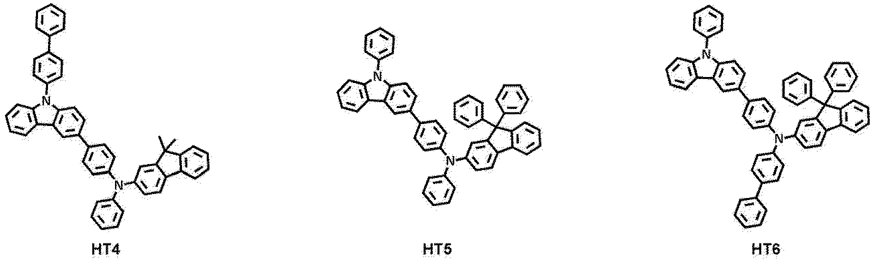

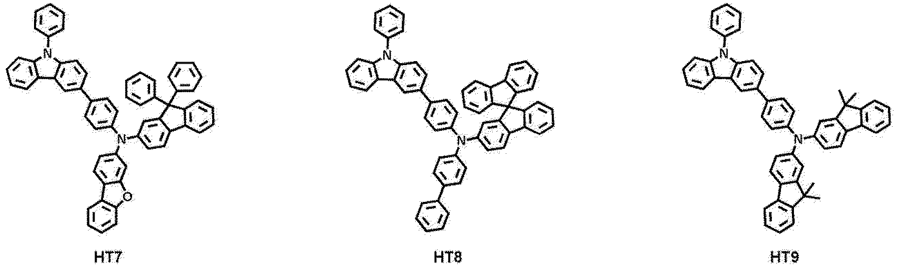

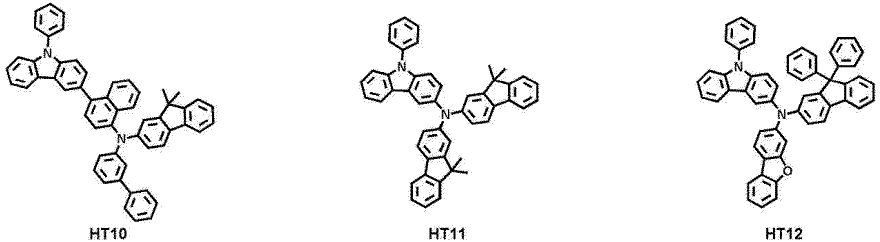

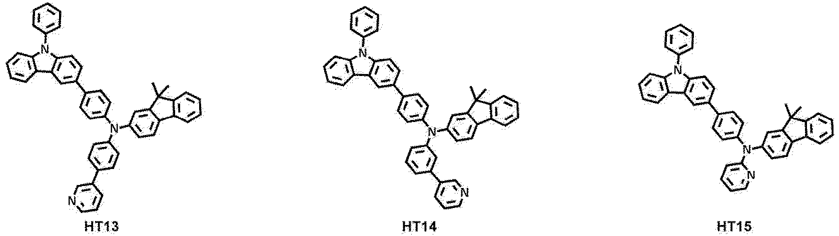

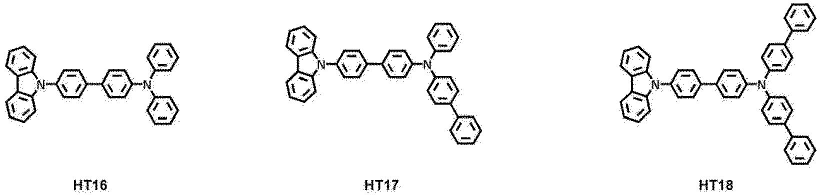

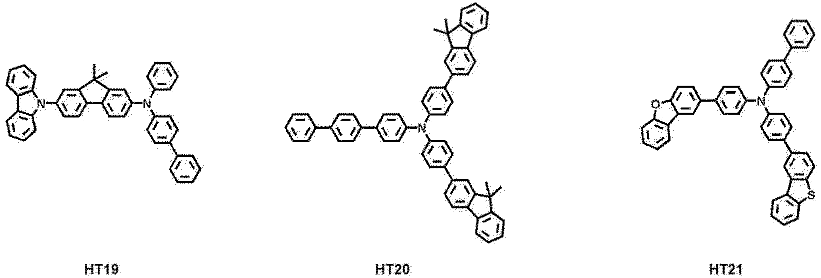

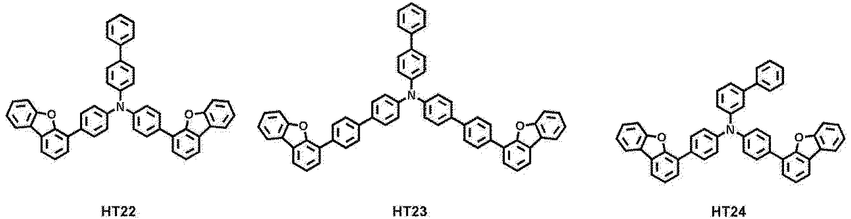

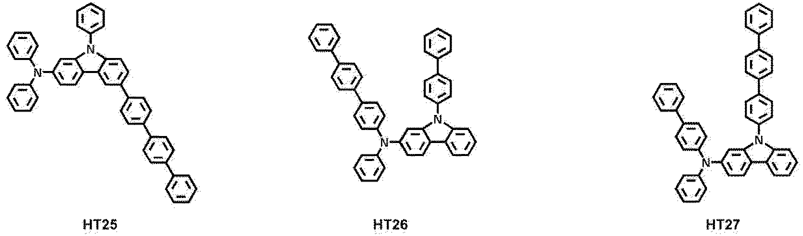

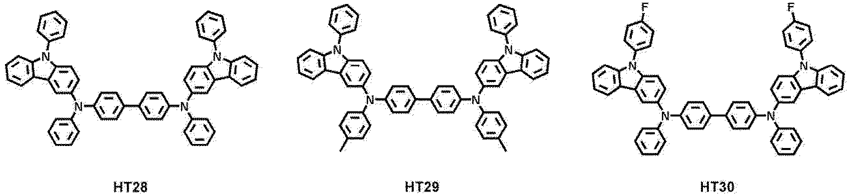

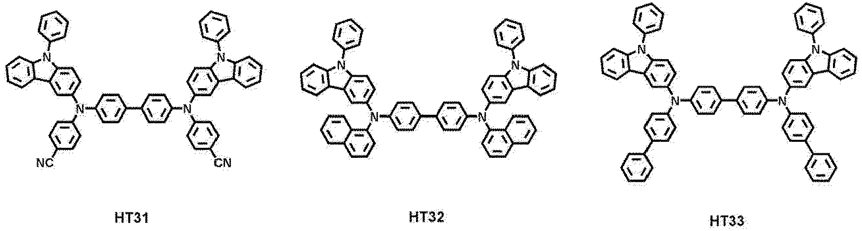

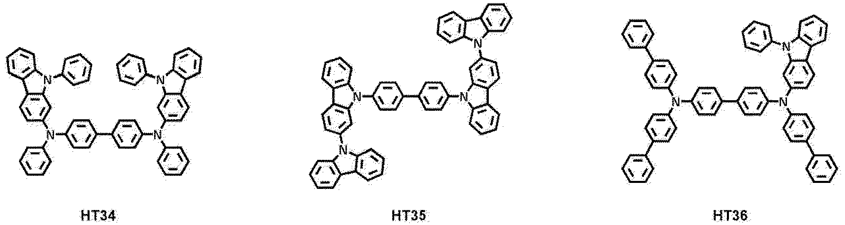

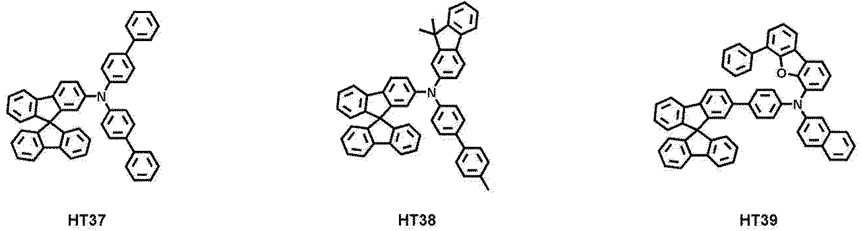

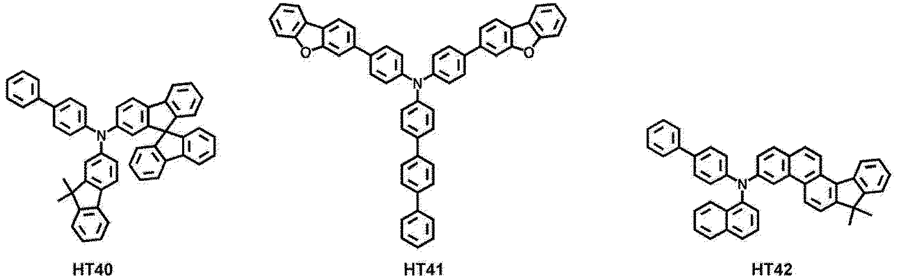

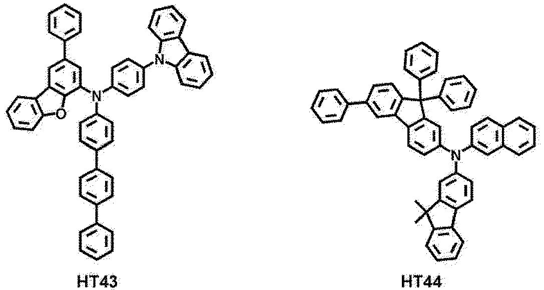

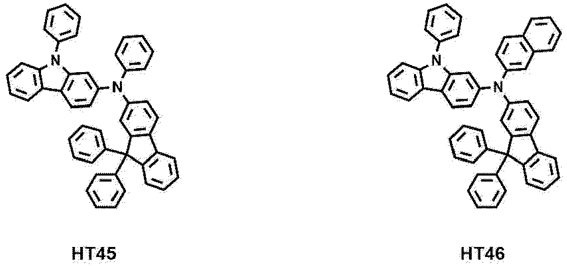

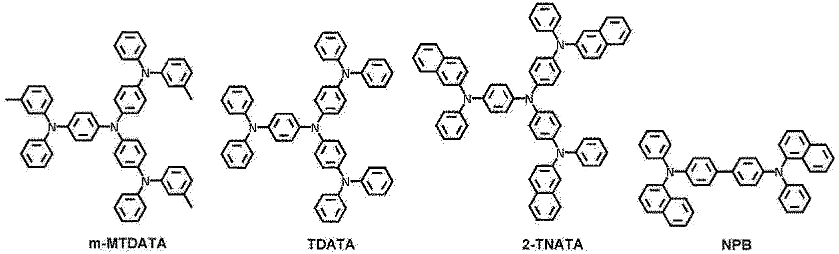

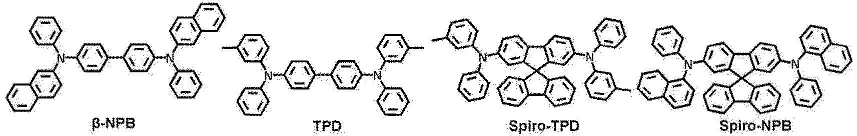

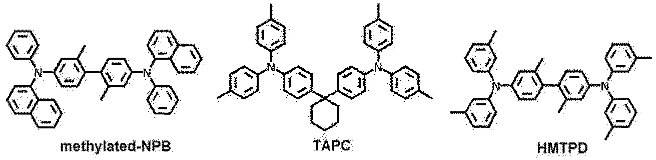

A thickness of the hole transport region may be in a range of about 50 Å to about 10,000 Å, for example, about 100 Å to about 4,000 Å. When the hole transport region includes a hole injection layer, a hole transport layer, or any combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, suitable or satisfactory hole transporting characteristics may be obtained without a substantial increase in driving voltage.

The emission auxiliary layer may increase light-emission efficiency by compensating for an optical resonance distance according to the wavelength of light emitted by the emission layer, and the electron blocking layer may block or reduce the leakage of electrons from the emission layer to the hole transport region. Materials that may be included in the hole transport region may be included in the emission auxiliary layer and the electron blocking layer.

### p-dopant

The hole transport region may further include, in addition to these materials, a charge-generation material for the improvement of conductive properties (e.g., electrically conductive properties). The charge-generation material may be uniformly or non-uniformly dispersed in the hole transport region (for example, in the form of a single layer consisting of a charge-generation material).

The charge-generation material may be, for example, a p-dopant.

For example, the p-dopant may have a LUMO energy level of less than or equal to -3.5 eV.

In an embodiment, the p-dopant may include a quinone derivative, a cyano group-containing compound, a compound including element EL1 and element EL2, or any combination thereof.

Examples of the quinone derivative are TCNQ, F4-TCNQ, and the like.

Examples of the cyano group-containing compound are HAT-CN, a compound represented by Formula 221, and the like: 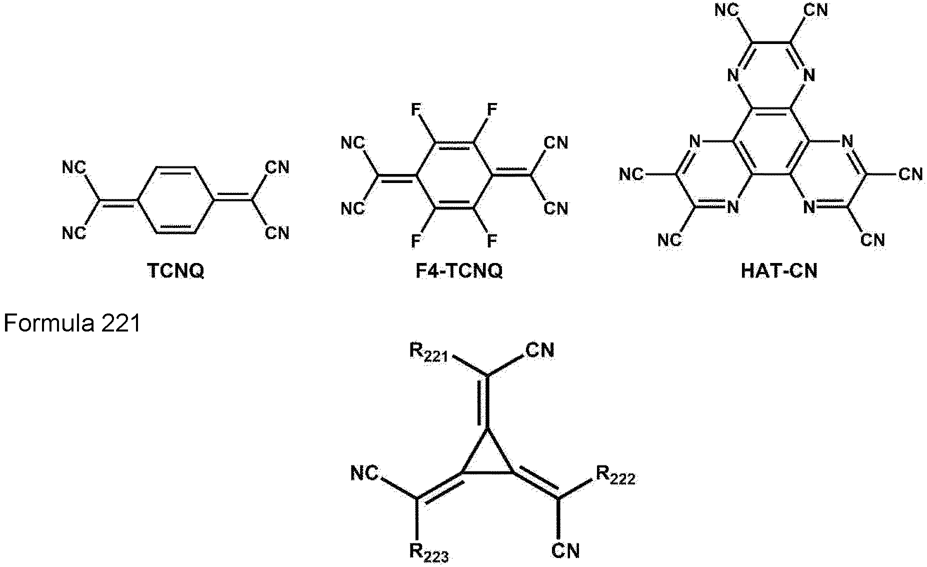 wherein, in Formula 221,
R₂₂₁ to R₂₂₃ may each independently be a C₃-C₆₀ carbocyclic group unsubstituted or substituted with at least one R₁₀ₐ or a C₁-C₆₀ heterocyclic group unsubstituted or substituted with at least one R₁₀ₐ, and
at least one of R₂₂₁ to R₂₂₃ may each independently be a C₃-C₆₀ carbocyclic group or a C₁-C₆₀ heterocyclic group, each substituted with: a cyano group; -F; -Cl; -Br; - I; a C₁-C₂₀ alkyl group substituted with a cyano group, -F, -Cl, -Br, -I, or any combination thereof; or any combination thereof.

In the compound including element EL1 and element EL2, element EL1 may be metal, metalloid, or any combination thereof, and element EL2 may be non-metal, metalloid, or any combination thereof.

Examples of the metal are an alkali metal (for example, lithium (Li), sodium (Na), potassium (K), rubidium (Rb), cesium (Cs), etc.); alkaline earth metal (for example, beryllium (Be), magnesium (Mg), calcium (Ca), strontium (Sr), barium (Ba), etc.); transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); post-transition metal (for example, zinc (Zn), indium (In), tin (Sn), etc.); lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.); and the like.

Examples of the metalloid are silicon (Si), antimony (Sb), tellurium (Te), and the like.

Examples of the non-metal are oxygen (O), halogen (for example, F, Cl, Br, I, etc.), and the like.

Examples of the compound including element EL1 and element EL2 are metal oxide, metal halide (for example, metal fluoride, metal chloride, metal bromide, metal iodide, etc.), metalloid halide (for example, metalloid fluoride, metalloid chloride, metalloid bromide, metalloid iodide, etc.), metal telluride, or any combination thereof.

Examples of the metal oxide are tungsten oxide (for example, WO, W₂O₃, WO₂, WO₃, W₂O₅, etc.), vanadium oxide (for example, VO, V₂O₃, VO₂, V₂O₅, etc.), molybdenum oxide (MoO, Mo₂O₃, MoO₂, MoOs, Mo₂O₅, etc.), rhenium oxide (for example, ReOs, etc.), and the like.

Examples of the metal halide are alkali metal halide, alkaline earth metal halide, transition metal halide, post-transition metal halide, lanthanide metal halide, and the like.

Examples of the alkali metal halide are LiF, NaF, KF, RbF, CsF, LiCl, NaCl, KCl, RbCl, CsCl, LiBr, NaBr, KBr, RbBr, CsBr, Lil, Nal, KI, Rbl, Csl, and the like.

Examples of the alkaline earth metal halide are BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, BaI₂, and the like.

Examples of the transition metal halide are titanium halide (for example, TiF₄, TiCl₄, TiBr₄, TiI₄, etc.), zirconium halide (for example, ZrF₄, ZrCl₄, ZrBr₄, ZrI₄, etc.), hafnium halide (for example, HfF₄, HfCl₄, HfBr₄, HfI₄, etc.), vanadium halide (for example, VF₃, VCl₃, VBr₃, VI₃, etc.), niobium halide (for example, NbF₃, NbCls, NbBr₃, NbI₃, etc.), tantalum halide (for example, TaF₃, TaCls, TaBr₃, TaI₃, etc.), chromium halide (for example, CrF₃, CrCl₃, CrBr₃, CrI₃, etc.), molybdenum halide (for example, MoF₃, MoCls, MoBr₃, MoI₃, etc.), tungsten halide (for example, WF₃, WCl₃, WBr₃, WI₃, etc.), manganese halide (for example, MnF₂, MnCl₂, MnBr₂, MnI₂, etc.), technetium halide (for example, TcF₂, TcCl₂, TcBr₂, TcI₂, etc.), rhenium halide (for example, ReF₂, ReCl₂, ReBr₂, ReI₂, etc.), iron halide (for example, FeF₂, FeCl₂, FeBr₂, FeI₂, etc.), ruthenium halide (for example, RuF₂, RuCl₂, RuBr₂, RuI₂, etc.), osmium halide (for example, OsF₂, OsCl₂, OsBr₂, OsI₂, etc.), cobalt halide (for example, CoF₂, CoCl₂, CoBr₂, CoI₂, etc.), rhodium halide (for example, RhF₂, RhCl₂, RhBr₂, RhI₂, etc.), iridium halide (for example, IrF₂, IrCl₂, IrBr₂, IrI₂, etc.), nickel halide (for example, NiF₂, NiCl₂, NiBr₂, NiI₂, etc.), palladium halide (for example, PdF₂, PdCl₂, PdBr₂, PdI₂, etc.), platinum halide (for example, PtF₂, PtCl₂, PtBr₂, PtI₂, etc.), copper halide (for example, CuF, CuCl, CuBr, Cul, etc.), silver halide (for example, AgF, AgCl, AgBr, Agl, etc.), gold halide (for example, AuF, AuCl, AuBr, Aul, etc.), and the like.

Examples of the post-transition metal halide are zinc halide (for example, ZnF₂, ZnCl₂, ZnBr₂, ZnI₂, etc.), indium halide (for example, InI₃, etc.), tin halide (for example, SnI₂, etc.), and the like.

Examples of the lanthanide metal halide are YbF, YbF₂, YbF₃, SmF₃, YbCl, YbCl₂, YbCl₃, SmCl₃, YbBr, YbBr₂, YbBr₃, SmBr₃, Ybl, YbI₂, YbI₃, and SmI₃.

Examples of the metalloid halide are antimony halide (for example, SbCls, etc.) and the like.

Examples of the metal telluride are alkali metal telluride (for example, Li₂Te, Na₂Te, K2Te, Rb₂Te, Cs₂Te, etc.), alkaline earth metal telluride (for example, BeTe, MgTe, CaTe, SrTe, BaTe, etc.), transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal telluride (for example, ZnTe, etc.), lanthanide metal telluride (for example, LaTe, CeTe, PrTe, NdTe, PmTe, EuTe, GdTe, TbTe, DyTe, HoTe, ErTe, TmTe, YbTe, LuTe, etc.), and the like.

### Emission layer in interlayer 130

When the organic light-emitting device 10 is a full-color organic light-emitting device, the emission layer may be patterned into a red emission layer, a green emission layer, and/or a blue emission layer, according to a sub-pixel. In an embodiment, the emission layer may have a stacked structure of two or more layers of a red emission layer, a green emission layer, and a blue emission layer, in which the two or more layers contact (e.g., physically contact) each other or are separated (e.g., spaced apart) from each other, to emit white light. In one or more embodiments, the emission layer may include two or more materials of a red light-emitting material, a green light-emitting material, and a blue light-emitting material, in which the two or more materials are mixed together with each other in a single layer, to emit white light.

In an embodiment, the emission layer may include a host and a dopant. The dopant may include a phosphorescent dopant, a fluorescent dopant, or any combination thereof.

An amount of the dopant in the emission layer may be from about 0.01 part by weight to about 15 parts by weight based on 100 parts by weight of the host.

In one or more embodiments, the emission layer may include a quantum dot.

In one or more embodiments, the emission layer may include a delayed fluorescence material. The delayed fluorescence material may act as a host or a dopant in the emission layer 120.

A thickness of the emission layer may be in a range of about 100 Å to about 1,000 Å, for example, about 200 Å to about 600 Å. When the thickness of the emission layer is within these ranges, excellent luminescence characteristics may be obtained without a substantial increase in driving voltage.

### Host

In an embodiment, the host may include a compound represented by Formula 301:

Formula 301 [Ar₃₀₁]_{xb11}-[(L₃₀₁)_{xb1}-R₃₀₁]_{xb21}

wherein, in Formula 301,
Ar₃₀₁ and L₃₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xb11 may be 1, 2, or 3,
xb1 may be an integer from 0 to 5,
R₃₀₁ may be hydrogen, deuterium, -F, -Cl, -Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ,-Si(Q₃₀₁)(Q₃₀₂)(Q₃₀₃), -N(Q₃₀₁)(Q₃₀₂), - B(Q₃₀₁)(Q₃₀₂), -C(=O)(Q₃₀₁), -S(=O)₂(Q₃₀₁), or -P(=O)(Q₃₀₁)(Q₃₀₂),
xb21 may be an integer from 1 to 5, and
Q₃₀₁ to Q₃₀₃ may each be the same as described in connection with Q₁.

For example, when xb11 in Formula 301 is 2 or more, two or more of Ar₃₀₁ may be linked to each other via a single bond (e.g., a covalent bond).

In one or more embodiments, the host may include a compound represented by Formula 301-1, a compound represented by Formula 301-2, or any combination thereof: 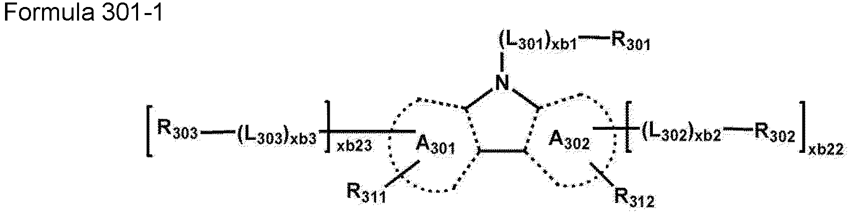 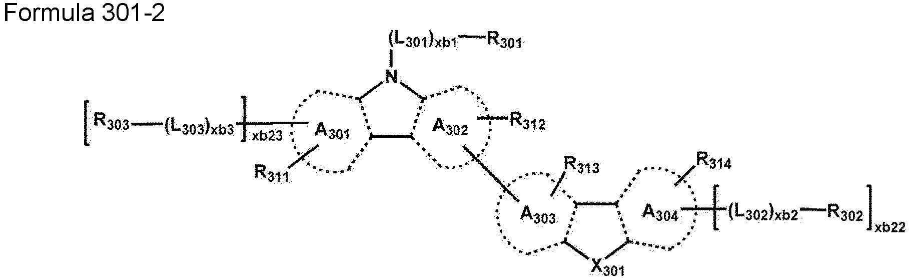 wherein, in Formulae 301-1 and 301-2,
ring A₃₀₁ to ring A₃₀₄ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
X₃₀₁ may be O, S, N-[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ may each be the same as described herein,
L₃₀₂ to L₃₀₄ may each independently be the same as described in connection with L₃₀₁,
xb2 to xb4 may each independently be the same as described in connection with xb1, and
R₃₀₂ to R₃₀₅ and R₃₁₁ to R₃₁₄ may each be the same as described in connection with R₃₀₁.

In one or more embodiments, the host may include an alkali earth metal complex, a post-transition metal complex, or any combination thereof. In one or more embodiments, the host may include a Be complex (for example, Compound H55), an Mg complex, a Zn complex, or any combination thereof.

In one or more embodiments, the host may include: one of Compounds H1 to H124; 9,10-di(2-naphthyl)anthracene (ADN); 2-methyl-9,10-bis(naphthalen-2-yl)anthracene (MADN); 9,10-di-(2-naphthyl)-2-t-butyl-anthracene (TBADN); 4,4'-bis(N-carbazolyl)-1,1'-biphenyl (CBP); 1,3-di-9-carbazolylbenzene (mCP); 1,3,5-tri(carbazol-9-yl)benzene (TCP); or any combination thereof:

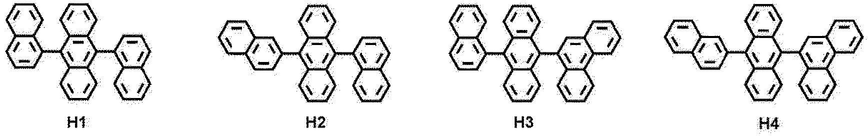

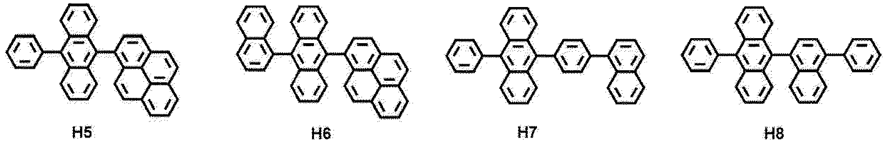

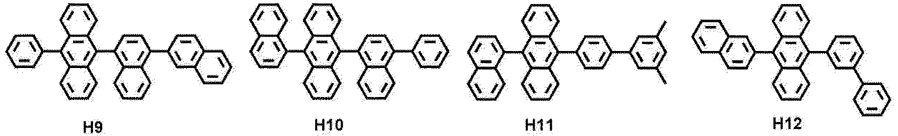

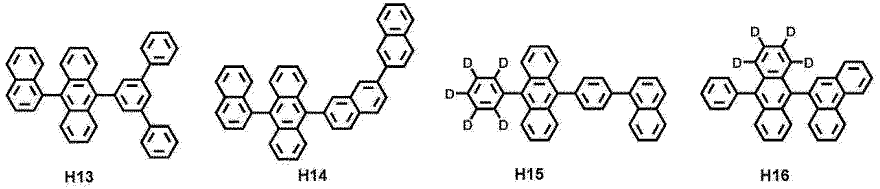

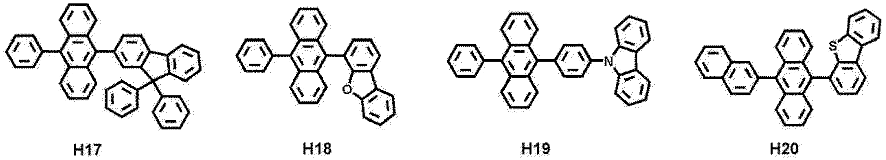

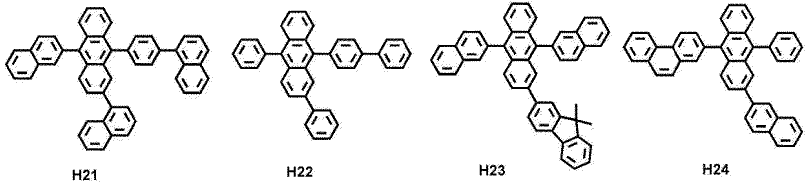

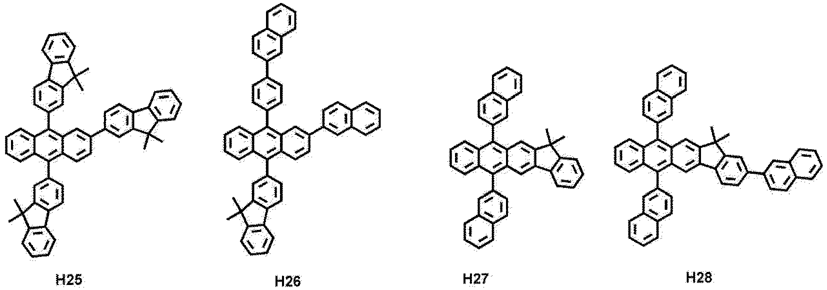

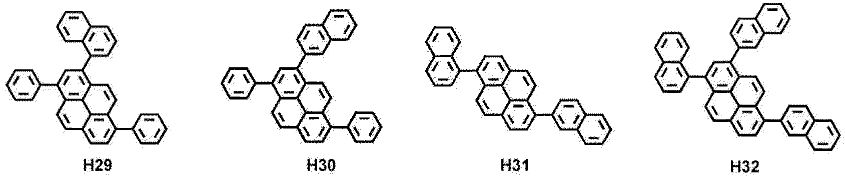

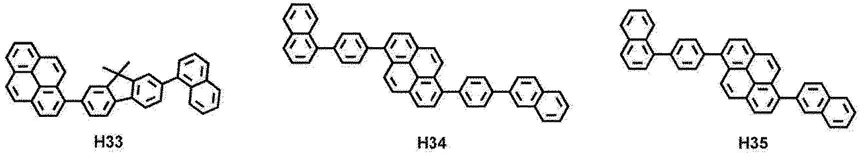

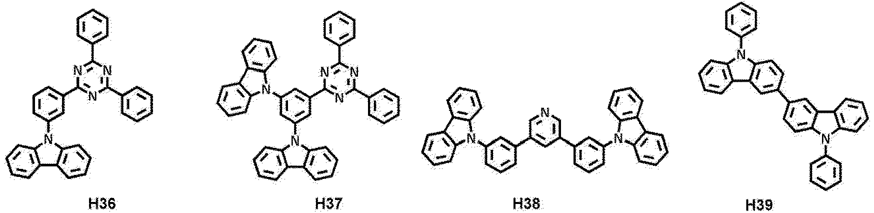

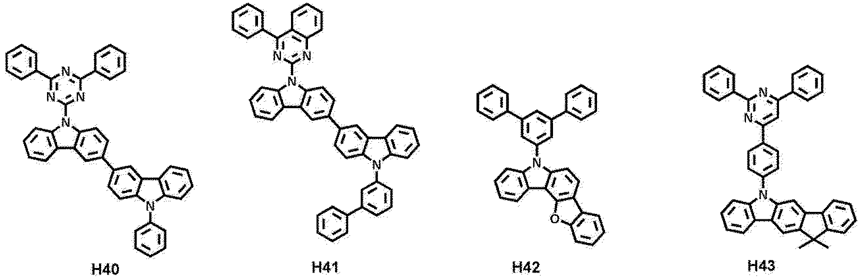

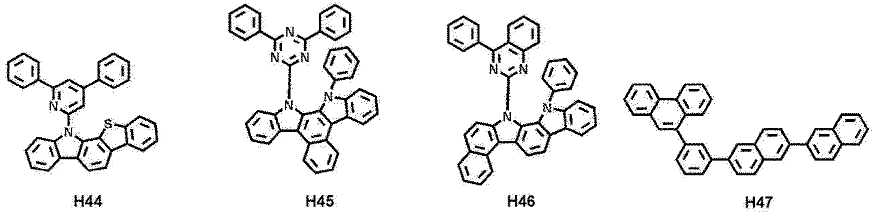

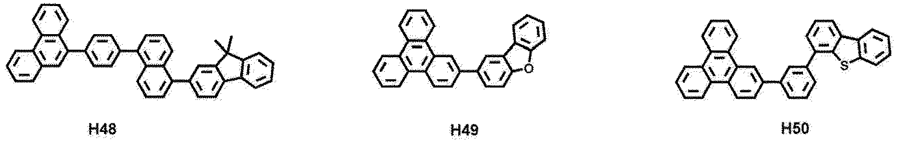

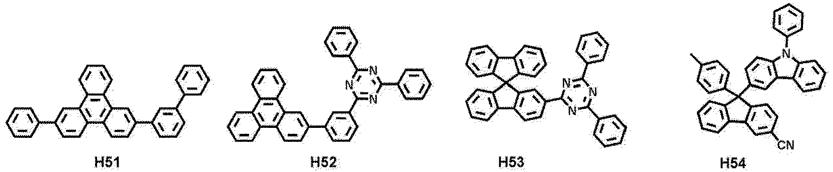

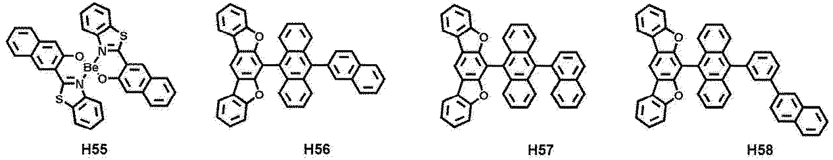

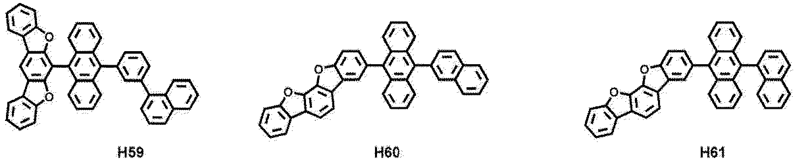

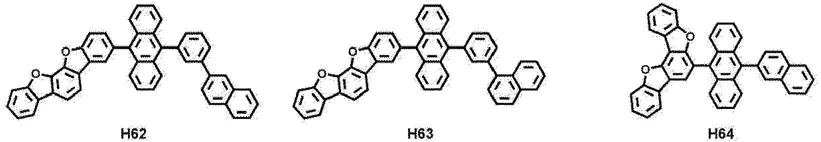

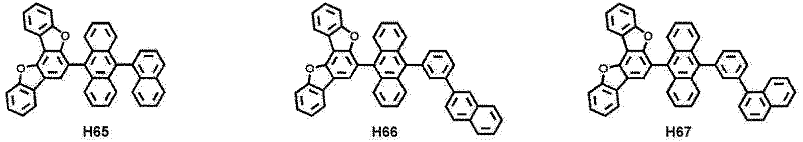

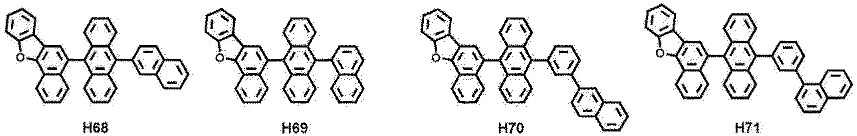

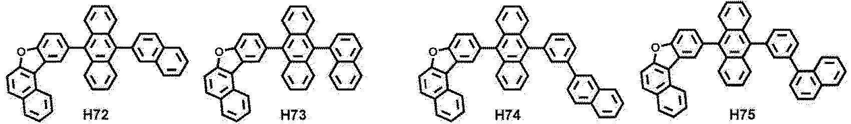

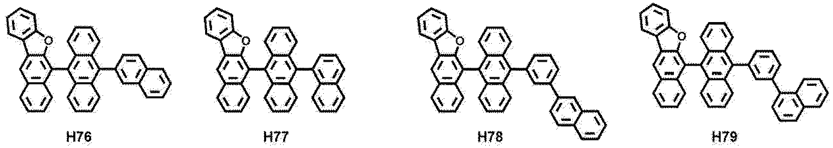

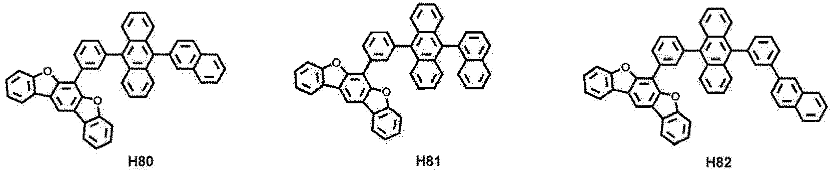

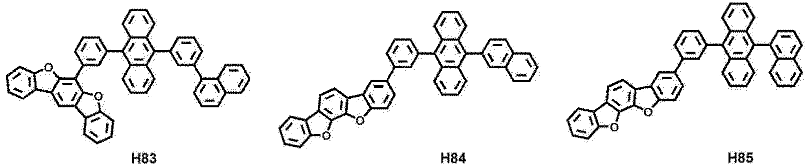

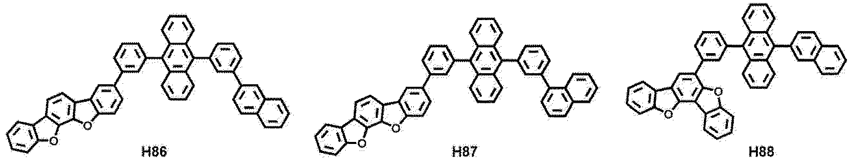

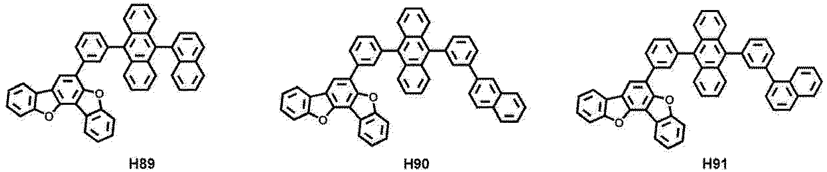

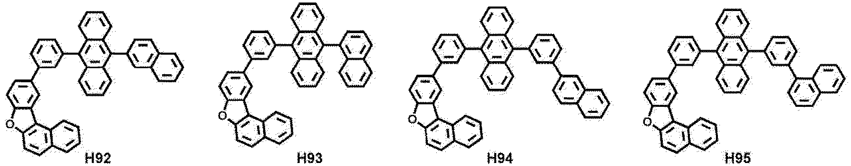

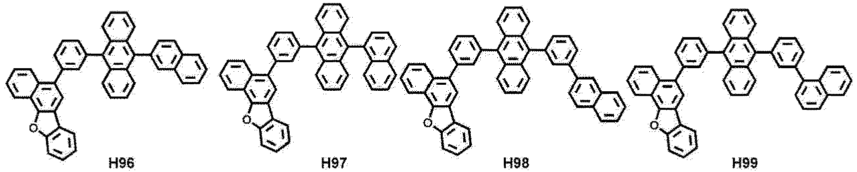

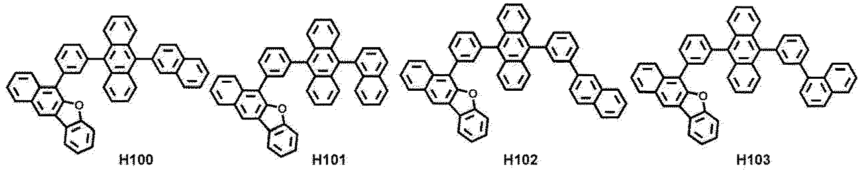

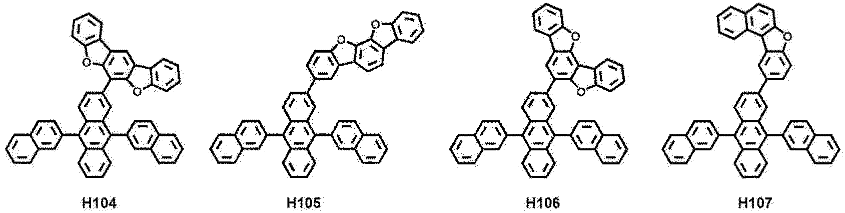

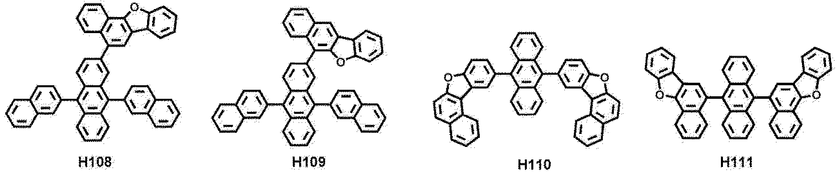

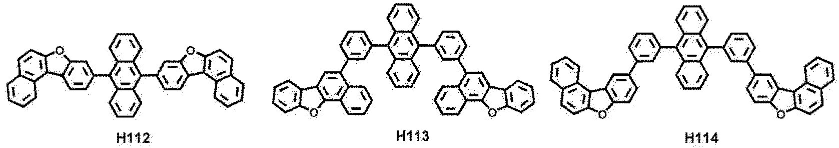

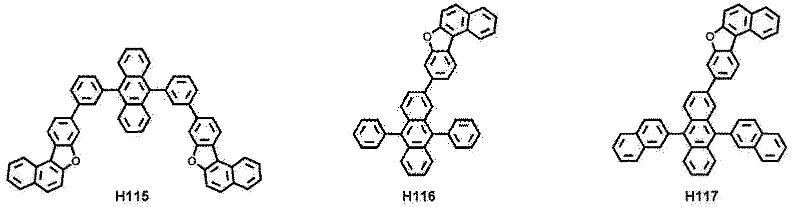

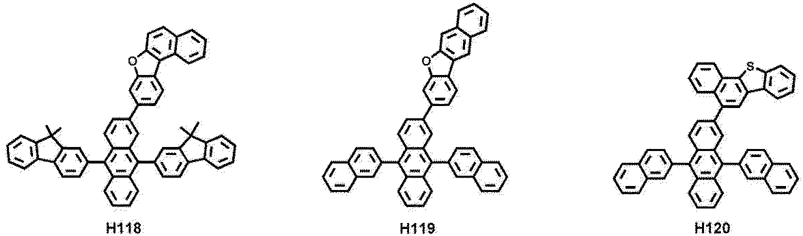

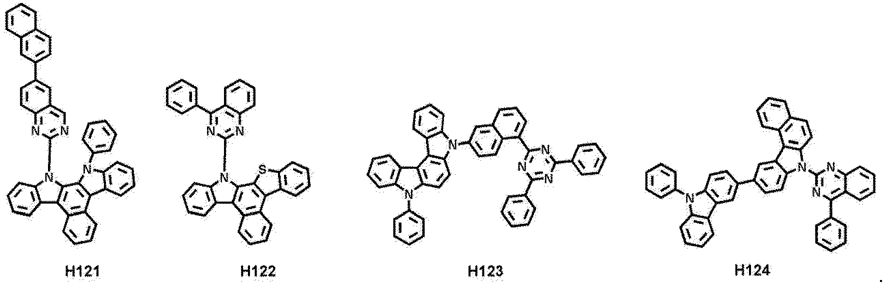

In an embodiment, the host may include a first host compound and a second host compound.

In an embodiment, the first host compound may be a hole-transporting host.

In an embodiment, the second host compound may be an electron-transporting host.

In an embodiment, the term "hole-transporting host" as used herein may be a compound including a hole-transporting moiety.

In an embodiment, the term "electron-transporting host" as used herein may be a compound not only including an electron-transporting moiety but also having bipolar properties.

The terms "hole-transporting host" and "electron-transporting host" as used herein may be understood according to the relative difference in hole mobility and electron mobility therebetween. For example, even when the electron-transporting host does not include an electron-transporting moiety, a bipolar compound exhibiting relatively higher electron mobility than the hole-transporting host may be also understood as the electron-transporting host.

In an embodiment, the hole-transporting host may be represented by one of Formulae 311-1 to 311-6, and the electron-transporting host may be represented by one of Formulae 312-1 to 312-4 and 313: 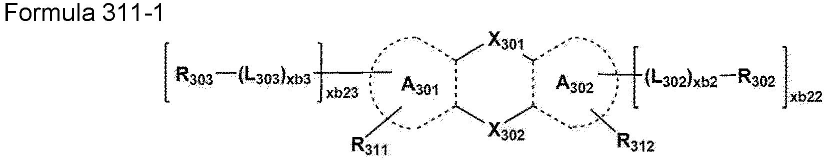 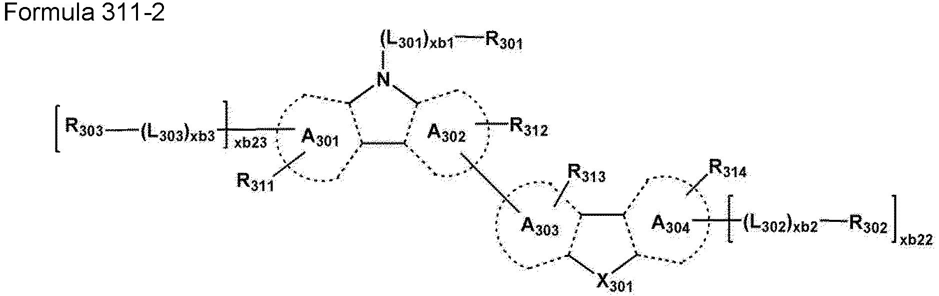 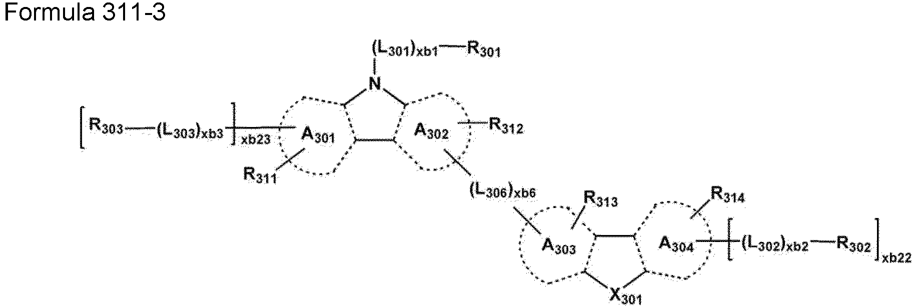 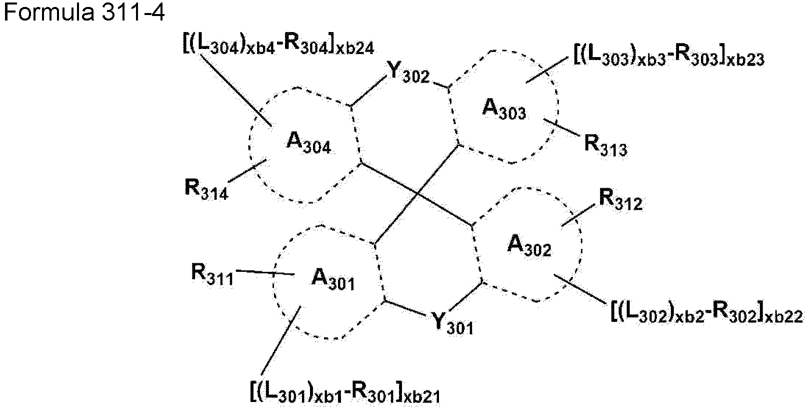 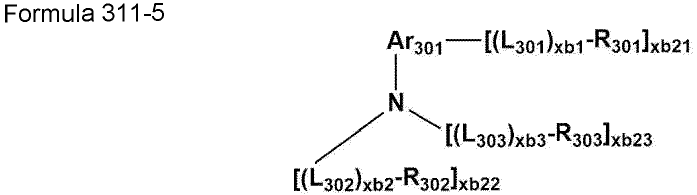 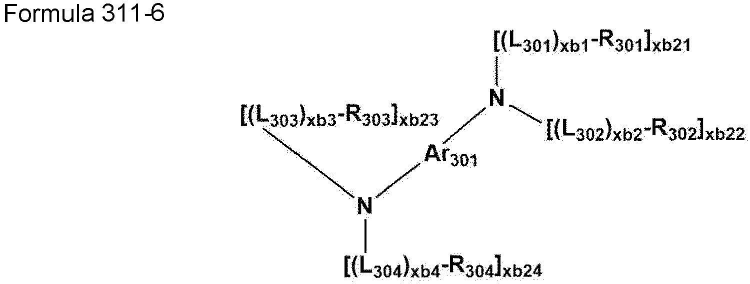 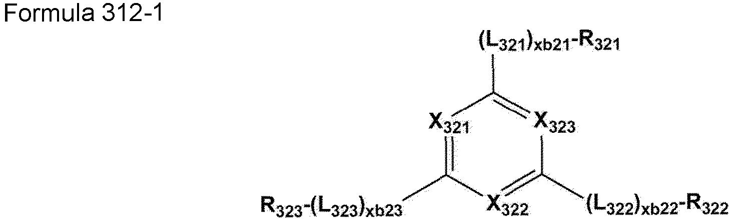 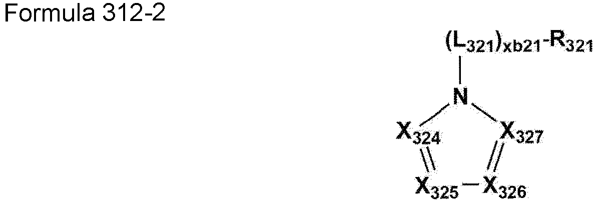 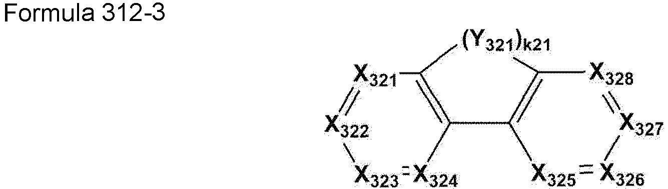 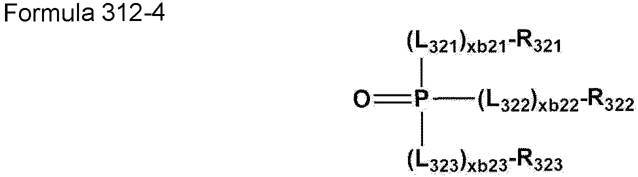 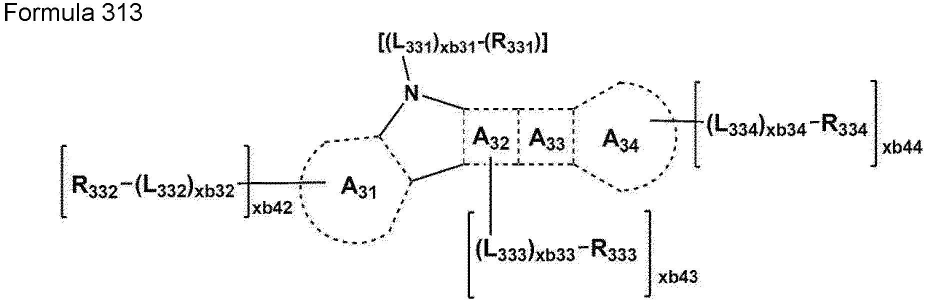 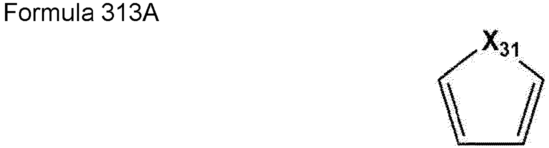 wherein, in Formulae 311-1 to 311-6, 312-1 to 312-4, 313, and 313A,
Ar₃₀₁ may be a C₃-C₆₀ carbocyclic group unsubstituted or substituted with at least one R₁₀ₐ or a C₁-C₆₀ heterocyclic group unsubstituted or substituted with at least one R₁₀ₐ,
A₃₀₁ to A₃₀₄ may each independently be a C₃-C₆₀ carbocyclic group or a C₁-C₆₀ heterocyclic group,
X₃₀₁ may be O, S, N-[(L₃₀₄)_{xb4}-R₃₀₄], C[(L₃₀₄)_{xb4}-R₃₀₄][(L₃₀₅)_{xb5}-R₃₀₅], or Si[(L₃₀₄)_{xb4}-R₃₀₄][(L₃₀₅)_{xb5}-R₃₀₅],
X₃₀₂, Y₃₀₁, and Y₃₀₂ may each independently be a single bond (e.g., a covalent bond), O, S, N-[(L₃₀₅)_{xb5}-R₃₀₅], C[(L₃₀₄)_{xb4}-R₃₀₄][(L₃₀₅)_{xb5}-R₃₀₅], Si[(L₃₀₄)_{xb4}-R₃₀₄][(L₃₀₅)_{xb5}-R₃₀₅], or S(=O)₂,
xb1 to xb5 may each be 0, 1, 2, 3, 4, or 5,
xb6 may be 1, 2, 3, 4, or 5,
X₃₂₁ to X₃₂₈ may each independently be N or C[(L₃₂₄)_{xb24}-R₃₂₄],
Y₃₂₁ may be *-O-*', *-S-*', *-N[(L₃₂₅)_{xb25}-R₃₂₅]-*', *-C[(L325)xb25-R325][(L326)xb26-R326]-*', *-C[(L₃₂₅)_{xb25}-R₃₂₅]=C[(L₃₂₆)_{xb26}-R₃₂₆]-*', *-C[(L₃₂₅)_{xb25}-R₃₂₅]=N-*', or *-N=C[(L₃₂₆)_{xb26}-R₃₂₆]-*', * and *' each indicate a binding site to a neighboring atom,
k21 may be 0, 1, or 2, wherein Y₃₂₁ does not exist when k21 is 0,
xb21 to xb26 may each independently be 0, 1, 2, 3, 4, or 5,
A₃₁, A₃₂, and A₃₄ may each independently be a C₃-C₆₀ carbocyclic group or a C₁-C₃₀ heterocyclic group,
A₃₃ may be a group represented by Formula 313A,
X₃₁ may be N[(L₃₃₅)_{xb35}-(R₃₃₅)], O, S, Se, C[(L₃₃₅)_{xb35}-(R₃₃₅)][(L₃₃₆)_{xb36}-(R₃₃₆)], or Si[(L₃₃₅)_{xb35}-(R₃₃₅)][(L₃₃₆)_{xb36}-(R₃₃₆)],
xb31 to xb36 may each independently be 0, 1, 2, 3, 4, or 5,
xb42 to xb44 may each independently be 0, 1, 2, 3, 4, 5, 6, 7, 8, 9, or 10,
L₃₀₁ to L₃₀₆, L₃₂₁ to L₃₂₆, and L₃₃₁ to L₃₃₆ may each independently be a single bond (e.g., a covalent bond), a C₁-C₂₀ alkylene group that is unsubstituted or substituted with at least one R₁₀ₐ, a C₁-C₂₀ alkenylene group that is unsubstituted or substituted with at least one R₁₀ₐ, a C₁-C₂₀ alkynylene group that is unsubstituted or substituted with at least one R₁₀ₐ, a C₃-C₁₀ cycloalkylene group that is unsubstituted or substituted with at least one R₁₀ₐ, a C₁-C₁₀ heterocycloalkylene group that is unsubstituted or substituted with at least one R₁₀ₐ, a C₃-C₁₀ cycloalkenylene group that is unsubstituted or substituted with at least one R₁₀ₐ, a C₁-C₁₀ heterocycloalkenylene group that is unsubstituted or substituted with at least one R₁₀ₐ, a C₆-C₆₀ arylene group that is unsubstituted or substituted with at least one R₁₀ₐ, a C₁-C₆₀ heteroarylene group that is unsubstituted or substituted with at least one R₁₀ₐ, a divalent non-aromatic condensed polycyclic group that is unsubstituted or substituted with at least one R₁₀ₐ, or a divalent non-aromatic condensed heteropolycyclic group that is unsubstituted or substituted with at least one R₁₀ₐ,
R₃₀₁ to R₃₀₅, R₃₁₁ to R₃₁₄, R₃₂₁ to R₃₂₄, and R₃₃₁ to R₃₃₆ may each independently be hydrogen, deuterium, -F, -Cl, -Br, -I, a hydroxyl group, a cyano group, a nitro group, an amidino group, a hydrazino group, a hydrazono group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₁₀ cycloalkyl group unsubstituted or substituted with at least one R₁₀ₐ, a C₁-C₁₀ heterocycloalkyl group unsubstituted or substituted with at least one R₁₀ₐ, a C₃-C₁₀ cycloalkenyl group unsubstituted or substituted with at least one R₁₀ₐ, a C₁-C₁₀ heterocycloalkenyl group unsubstituted or substituted with at least one R₁₀ₐ, a C₆-C₆₀ aryl group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₁-C₆₀ heteroaryl group unsubstituted or substituted with at least one R₁₀ₐ, a C₁-C₆₀ heteroaryloxy group unsubstituted or substituted with at least one R₁₀ₐ, a C₁-C₆₀ heteroarylthio group unsubstituted or substituted with at least one R₁₀ₐ, a monovalent non-aromatic condensed polycyclic group unsubstituted or substituted with at least one R₁₀ₐ, a monovalent non-aromatic condensed heteropolycyclic group unsubstituted or substituted with at least one R₁₀ₐ, - Si(Q₁)(Q₂)(Q₃), -B(Q₁)(Q₂), -N(Q₁)(Q₂), -P(Q₁)(Q₂), -C(=O)(Q₁), -S(=O)(Q₁), -S(=O)₂(Q₁), -P(=O)(Q₁)(Q₂), or -P(=S)(Q₁)(Q₂),
neighboring two or more of R₃₂₁ to R₃₂₄ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
R₁₀ₐ may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, or a C₁-C₆₀ heteroarylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₁-C₆ heteroaryloxy group, a C₁-C₆₀ heteroarylthio group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁₁ to Q₁₃, Q₂₁ to Q₂₃, Q₃₁ to Q₃₃, Q₄₁ to Q₄₃, Q₃₀₁ to Q₃₀₃, Q₃₂₁ to Q₃₂₃, and Q₃₃₁ to Q₃₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

The first host compound may be a compound represented by Formula 350: 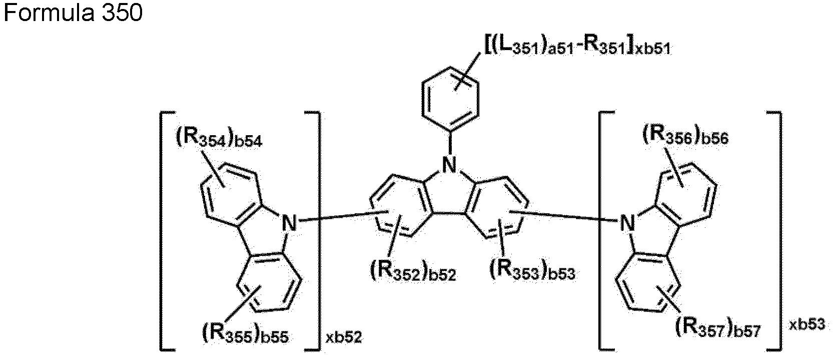
wherein, in Formula 350, L₃₅₁ may be a single bond (e.g., a covalent bond), a C₁-C₂₀ alkylene group that is unsubstituted or substituted with at least one R₁₀ₐ, a C₁-C₂₀ alkenylene group that is unsubstituted or substituted with at least one R₁₀ₐ, a C₁-C₂₀ alkynylene group that is unsubstituted or substituted with at least one R₁₀ₐ, a C₃-C₁₀ cycloalkylene group that is unsubstituted or substituted with at least one R₁₀ₐ, a C₁-C₁₀ heterocycloalkylene group that is unsubstituted or substituted with at least one R₁₀ₐ, a C₃-C₁₀ cycloalkenylene group that is unsubstituted or substituted with at least one R₁₀ₐ, a C₁-C₁₀ heterocycloalkenylene group that is unsubstituted or substituted with at least one R₁₀ₐ, a C₆-C₆₀ arylene group that is unsubstituted or substituted with at least one R₁₀ₐ, a C₁-C₆₀ heteroarylene group that is unsubstituted or substituted with at least one R₁₀ₐ, a divalent non-aromatic condensed polycyclic group that is unsubstituted or substituted with at least one R₁₀ₐ, or a divalent non-aromatic condensed heteropolycyclic group that is unsubstituted or substituted with at least one R₁₀ₐ,
a1 may be 0, 1, 2, 3, 4, or 5,
R₃₅₁ to R₃₅₇ may each independently be hydrogen, deuterium, -F, -Cl, -Br, -I, a hydroxyl group, a cyano group, a nitro group, an amidino group, a hydrazino group, a hydrazono group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₁₀ cycloalkyl group unsubstituted or substituted with at least one R₁₀ₐ, a C₁-C₁₀ heterocycloalkyl group unsubstituted or substituted with at least one R₁₀ₐ, a C₃-C₁₀ cycloalkenyl group unsubstituted or substituted with at least one R₁₀ₐ, a C₁-C₁₀ heterocycloalkenyl group unsubstituted or substituted with at least one R₁₀ₐ, a C₆-C₆₀ aryl group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₁-C₆₀ heteroaryl group unsubstituted or substituted with at least one R₁₀ₐ, a C₁-C₆₀ heteroaryloxy group unsubstituted or substituted with at least one R₁₀ₐ, a C₁-C₆₀ heteroarylthio group unsubstituted or substituted with at least one R₁₀ₐ, a monovalent non-aromatic condensed polycyclic group unsubstituted or substituted with at least one R₁₀ₐ, a monovalent non-aromatic condensed heteropolycyclic group unsubstituted or substituted with at least one R₁₀ₐ, -Si(Q₁)(Q₂)(Q₃), -B(Q₁)(Q₂), -N(Q₁)(Q₂), -P(Q₁)(Q₂), - C(=O)(Q₁), -S(=O)(Q₁), -S(=O)₂(Q₁), -P(=O)(Q₁)(Q₂), or -P(=S)(Q₁)(Q₂),
neighboring two or more of R₃₅₁ to R₃₅₇ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
xb51 may be 1, 2, 3, 4, or 5,
xb52 and xb53 may each independently be 0, 1, 2, or 3,
b52 and b53 may each independently be 0, 1, 2, or 3,
b54 to b57 may each independently be 0, 1, 2, 3, or 4,
R₁₀ₐ may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, or a C₁-C₆₀ heteroarylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₁-C₆ heteroaryloxy group, a C₁-C₆₀ heteroarylthio group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In an embodiment, the first host compound may be selected from Compounds HTH1 to HTH40:

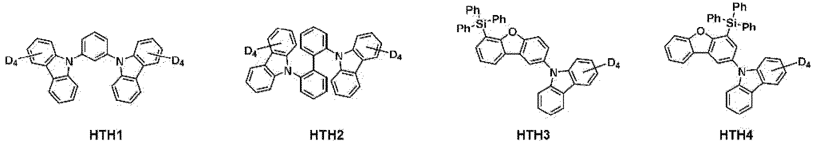

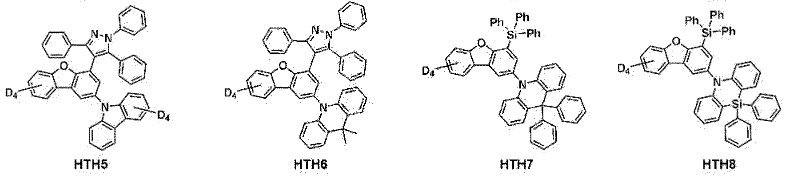

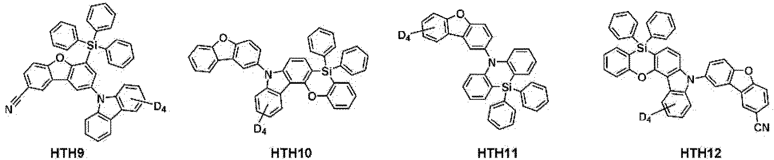

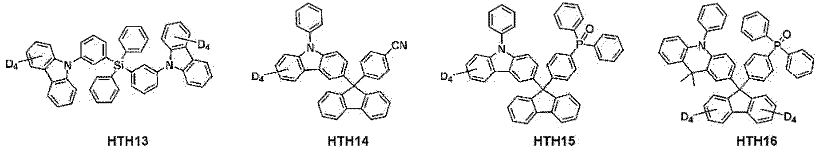

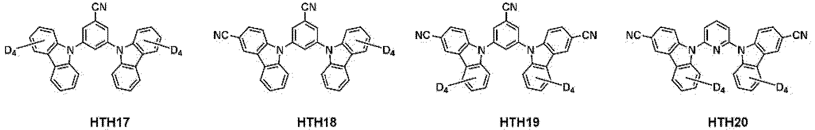

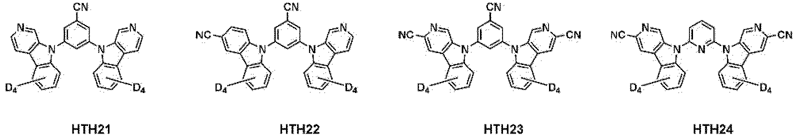

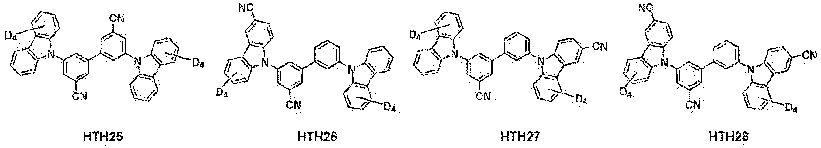

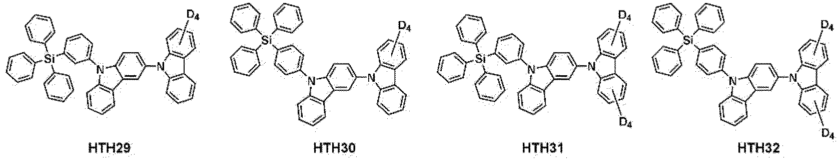

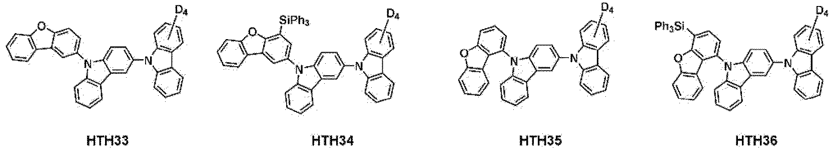

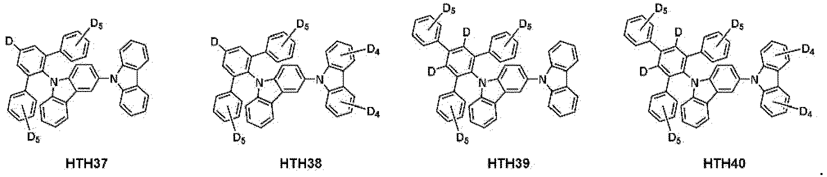

In an embodiment, the second host compound may be an electron-transporting host.

In an embodiment, the second host compound may be a compound represented by Formula 360: 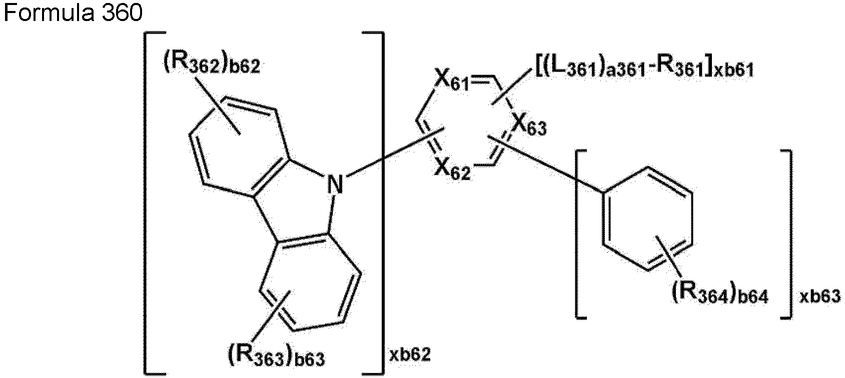
wherein, in Formula 360, X₆₁ to X₆₃ may each independently be C or N,
L₃₆₁ may be a single bond (e.g., a covalent bond), a C₁-C₂₀ alkylene group that is unsubstituted or substituted with at least one R₁₀ₐ, a C₁-C₂₀ alkenylene group that is unsubstituted or substituted with at least one R₁₀ₐ, a C₁-C₂₀ alkynylene group that is unsubstituted or substituted with at least one R₁₀ₐ, a C₃-C₁₀ cycloalkylene group that is unsubstituted or substituted with at least one R₁₀ₐ, a C₁-C₁₀ heterocycloalkylene group that is unsubstituted or substituted with at least one R₁₀ₐ, a C₃-C₁₀ cycloalkenylene group that is unsubstituted or substituted with at least one R₁₀ₐ, a C₁-C₁₀ heterocycloalkenylene group that is unsubstituted or substituted with at least one R₁₀ₐ, a C₆-C₆₀ arylene group that is unsubstituted or substituted with at least one R₁₀ₐ, a C₁-C₆₀ heteroarylene group that is unsubstituted or substituted with at least one R₁₀ₐ, a divalent non-aromatic condensed polycyclic group that is unsubstituted or substituted with at least one R₁₀ₐ, or a divalent non-aromatic condensed heteropolycyclic group that is unsubstituted or substituted with at least one R₁₀ₐ,
a361 may be 0, 1, 2, 3, 4, or 5,
R₃₆₁ to R₃₆₄ may each independently be hydrogen, deuterium, -F, -Cl, -Br, -I, a hydroxyl group, a cyano group, a nitro group, an amidino group, a hydrazino group, a hydrazono group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₁₀ cycloalkyl group unsubstituted or substituted with at least one R₁₀ₐ, a C₁-C₁₀ heterocycloalkyl group unsubstituted or substituted with at least one R₁₀ₐ, a C₃-C₁₀ cycloalkenyl group unsubstituted or substituted with at least one R₁₀ₐ, a C₁-C₁₀ heterocycloalkenyl group unsubstituted or substituted with at least one R₁₀ₐ, a C₆-C₆₀ aryl group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₁-C₆₀ heteroaryl group unsubstituted or substituted with at least one R₁₀ₐ, a C₁-C₆₀ heteroaryloxy group unsubstituted or substituted with at least one R₁₀ₐ, a C₁-C₆₀ heteroarylthio group unsubstituted or substituted with at least one R₁₀ₐ, a monovalent non-aromatic condensed polycyclic group unsubstituted or substituted with at least one R₁₀ₐ, a monovalent non-aromatic condensed heteropolycyclic group unsubstituted or substituted with at least one R₁₀ₐ, -Si(Q₁)(Q₂)(Q₃), -B(Q₁)(Q₂), -N(Q₁)(Q₂), -P(Q₁)(Q₂), - C(=O)(Q₁), -S(=O)(Q₁), -S(=O)₂(Q₁), -P(=O)(Q₁)(Q₂), or -P(=S)(Q₁)(Q₂),
neighboring two or more of R₃₆₁ to R₃₆₄ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
xb61 to xb63 may each independently be 0, 1, 2, 3, 4, 5, or 6,
the sum of xb61 to xb63 may be 1, 2, 3, 4, 5, or 6,
b62 and b63 may each independently be 0, 1, 2, 3, or 4,
b64 may be 0, 1, 2, 3, 4, or 5,
R₁₀ₐ may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, or a C₁-C₆₀ heteroarylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₁-C₆ heteroaryloxy group, a C₁-C₆₀ heteroarylthio group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In an embodiment, the second host compound may be selected from Compounds ETH1 to ETH32:

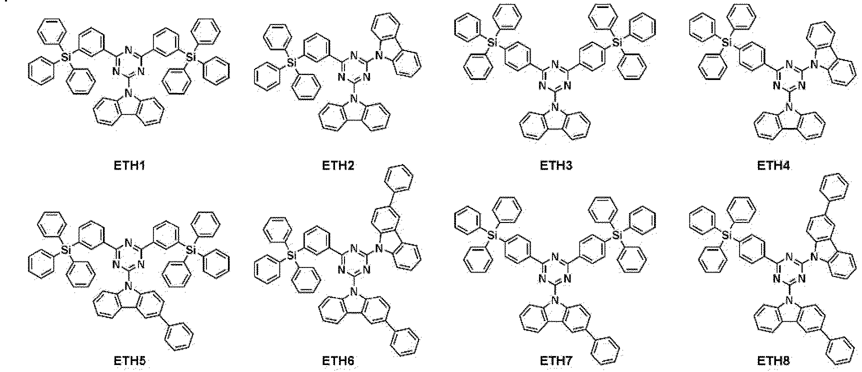

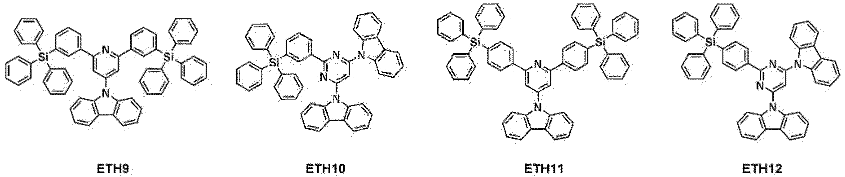

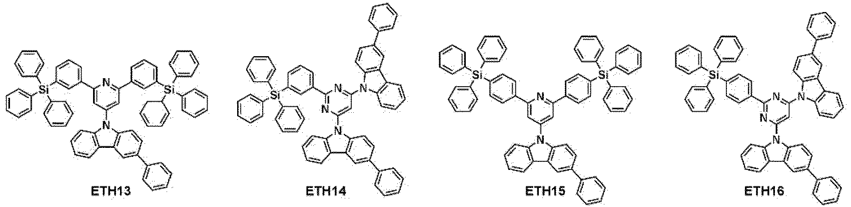

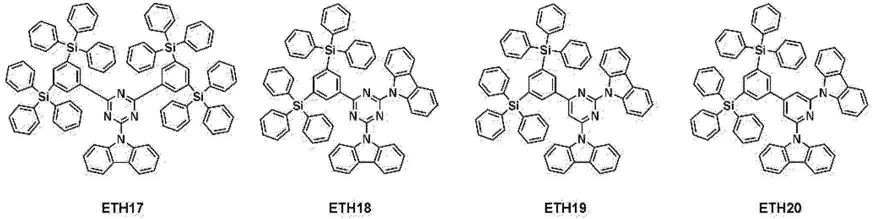

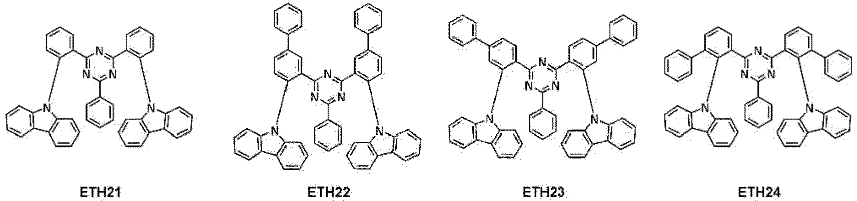

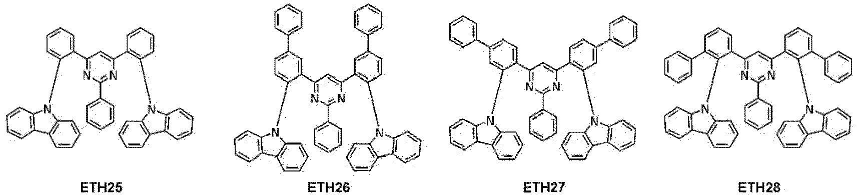

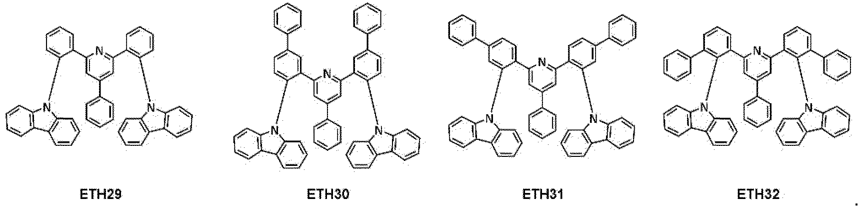

In an embodiment, the first host compound and the second host compound may form an exciplex.

### Phosphorescent dopant

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or any combination thereof.

The phosphorescent dopant may be electrically neutral.

In an embodiment, the phosphorescent dopant may include the organometallic compound represented by Formula 1.

In an embodiment, the phosphorescent dopant may include an organometallic compound represented by Formula 401:

Formula 401 M(L₄₀₁)_{xc1}(L₄₀₂)_{xc2}

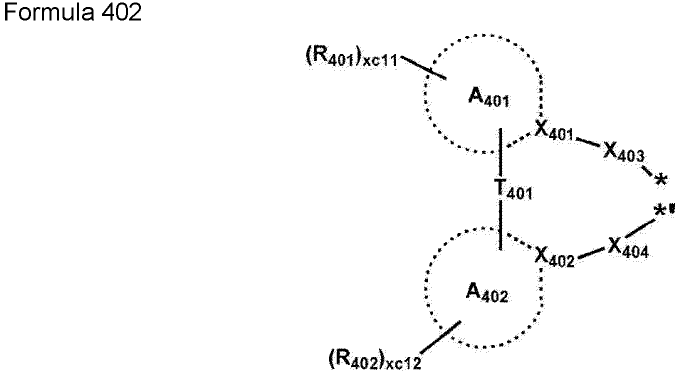

wherein, in Formulae 401 and 402,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein, when xc1 is 2 or more, two or more of L₄₀₁ may be identical to or different from each other,
L₄₀₂ may be an organic ligand, and xc2 may be 0, 1, 2, 3, or 4, and when xc2 is 2 or more, two or more of L₄₀₂ may be identical to or different from each other,
X₄₀₁ and X₄₀₂ may each independently be N or C,
ring A₄₀₁ and ring A₄₀₂ may each independently be a C₃-C₆₀ carbocyclic group or a C₁-C₆₀ heterocyclic group,
T₄₀₁ may be a single bond (e.g., a covalent bond), *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*', * and *' each indicate a binding site to a neighboring atom,
X₄₀₃ and X₄₀₄ may each independently be a chemical bond (for example, a covalent bond or a coordination bond, which may also be referred to as a coordinate covalent bond or dative bond), O, S, N(Q₄₁₃), B(Q₄₁₃), P(Q₄₁₃), C(Q₄₁₃)(Q₄₁₄), or Si(Q413)(Q414),
Q₄₁₁ to Q₄₁₄ may each be the same as described in connection with Q₁,
R₄₀₁ and R₄₀₂ may each independently be hydrogen, deuterium, -F, -Cl, -Br, -I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or -P(=O)(Q₄₀₁)(Q₄₀₂),
Q₄₀₁ to Q₄₀₃ may each be the same as described in connection with Q₁,
xc11 and xc12 may each independently be an integer from 0 to 10, and
* and *' in Formula 402 each indicate a binding site to M in Formula 401.

For example, in Formula 402, i) X₄₀₁ may be nitrogen and X₄₀₂ may be carbon, or ii) each of X₄₀₁ and X₄₀₂ may be nitrogen.

In an embodiment, when xc1 in Formula 401 is 2 or more, two ring A₄₀₁(s) among two or more of L₄₀₁ may optionally be linked to each other via T₄₀₂, which is a linking group, and two ring A₄₀₂(s) among two or more of L₄₀₁ may optionally be linked to each other via T₄₀₃, which is a linking group (see Compounds PD1 to PD4 and PD7). T₄₀₂ and T₄₀₃ may each be the same as described in connection with T₄₀₁.

In Formula 401, L₄₀₂ may be an organic ligand. For example, L₄₀₂ may include a halogen group, a diketone group (for example, an acetylacetonate group), a carboxylic acid group (for example, a picolinate group), -C(=O), an isonitrile group, a -CN group, a phosphorus-containing group (for example, a phosphine group, a phosphite group, etc.), or any combination thereof.

The phosphorescent dopant may include, for example, one of Compounds PD1 to PD39, or any combination thereof:

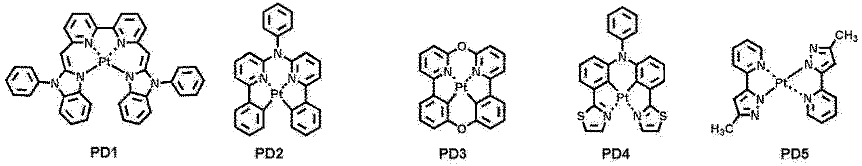

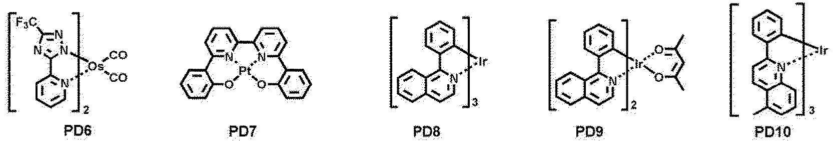

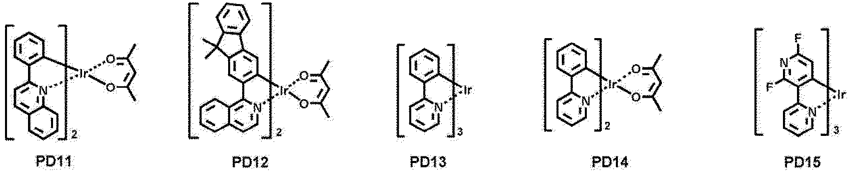

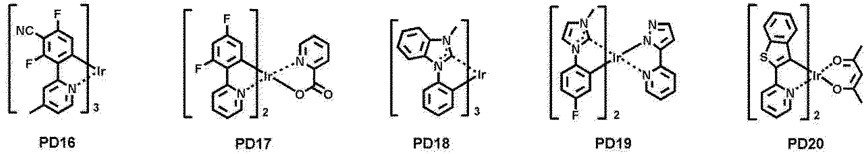

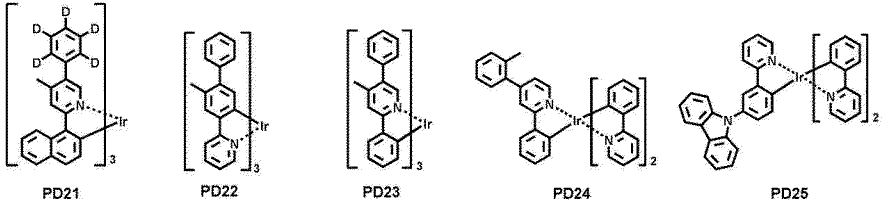

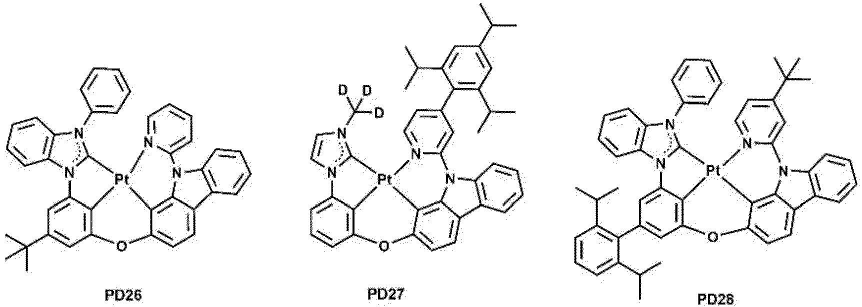

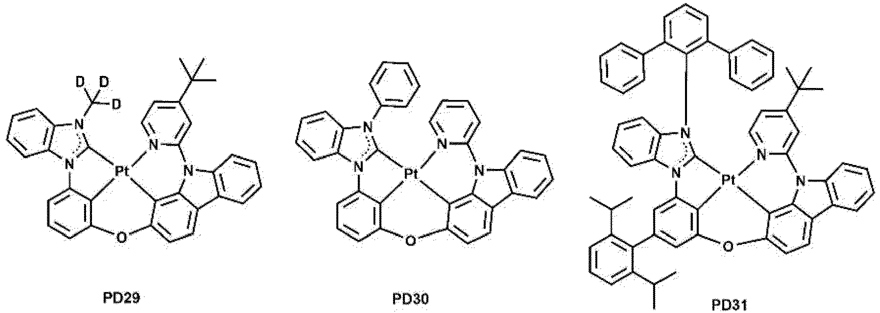

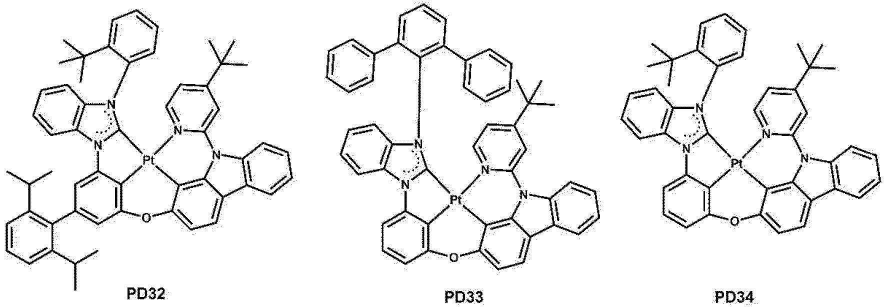

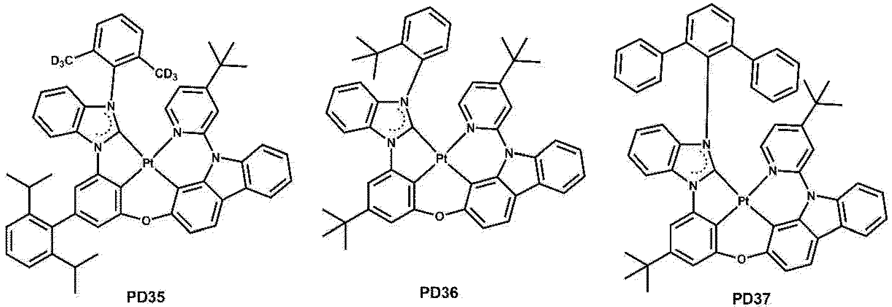

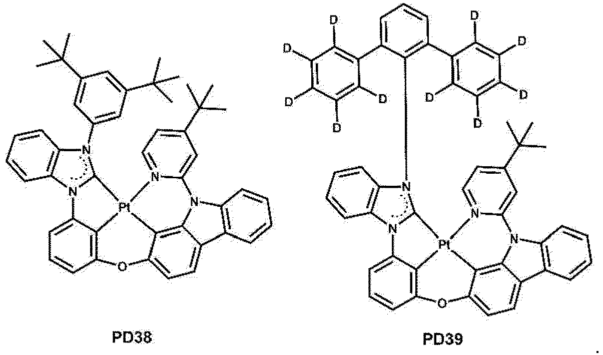

### Fluorescent dopant

The fluorescent dopant may include an amine group-containing compound, a styryl group-containing compound, or any combination thereof.

For example, the fluorescent dopant may include a compound represented by Formula 501: 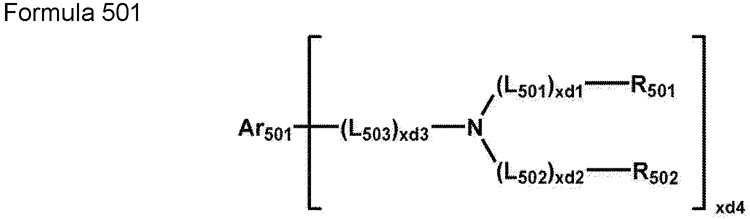
wherein, in Formula 501, Ar₅₀₁, L₅₀₁ to L₅₀₃, R₅₀₁, and R₅₀₂ may each independently be a C₃-C₆₀ carbocyclic group unsubstituted or substituted with at least one R₁₀ₐ or a C₁-C₆₀ heterocyclic group unsubstituted or substituted with at least one R10a,
xd1 to xd3 may each independently be 0, 1, 2, or 3, and
xd4 may be 1, 2, 3, 4, 5, or 6.

In an embodiment, Ar₅₀₁ in Formula 501 may be a condensed cyclic group (for example, an anthracene group, a chrysene group, a pyrene group, etc.) in which three or more monocyclic groups are condensed together.

In an embodiment, xd4 in Formula 501 may be 2.

For example, the fluorescent dopant may include: one of Compounds FD1 to FD36; DPVBi; DPAVBi; or any combination thereof:

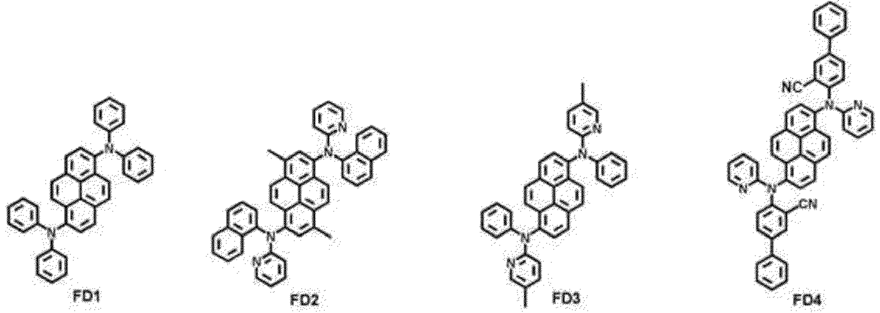

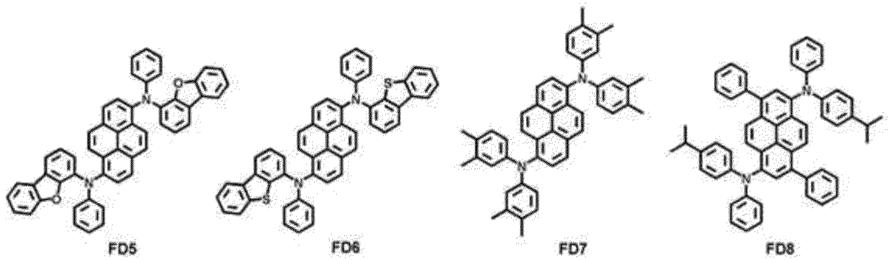

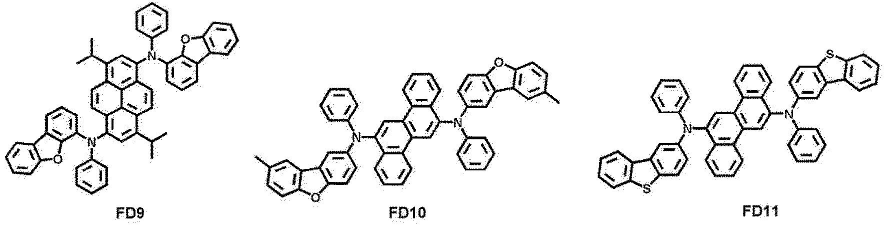

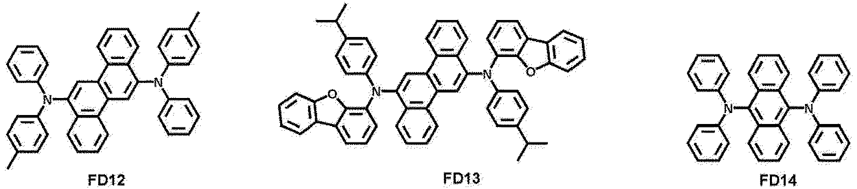

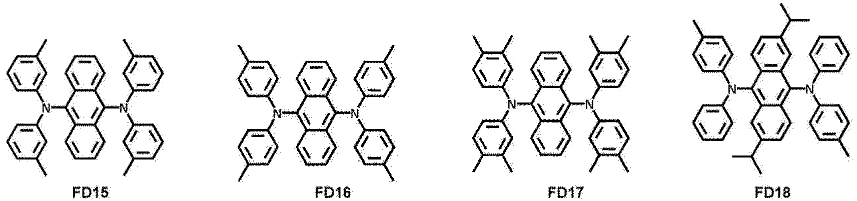

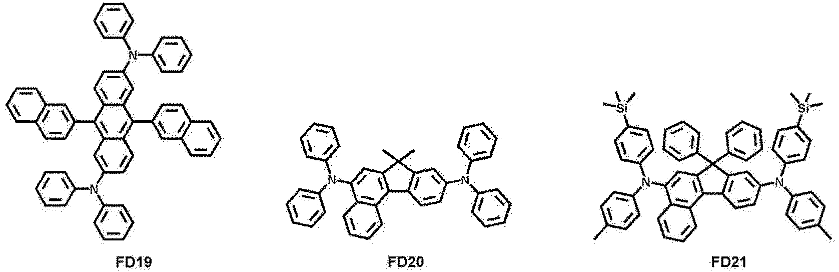

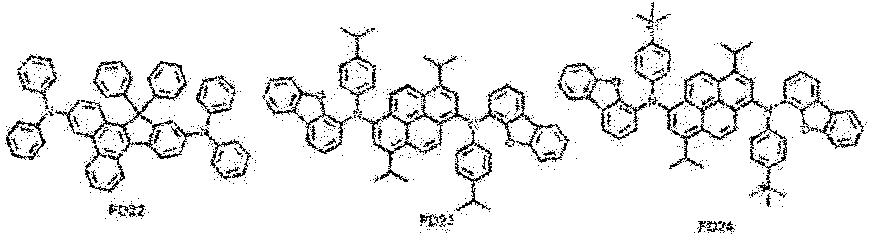

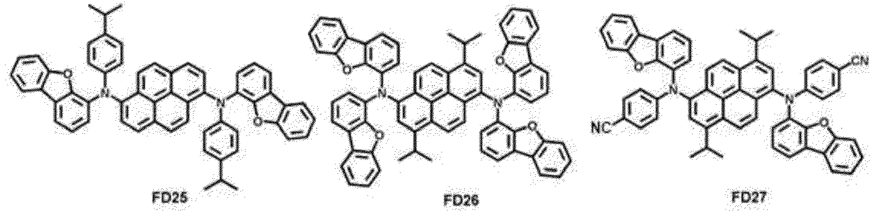

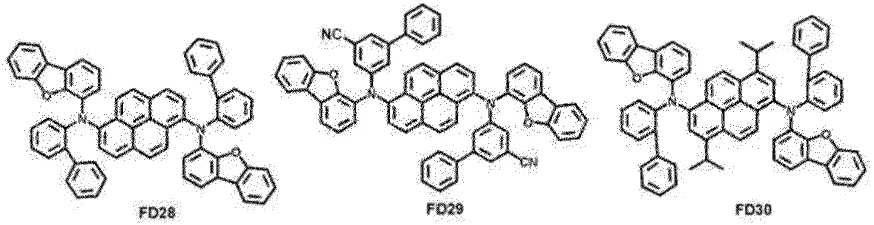

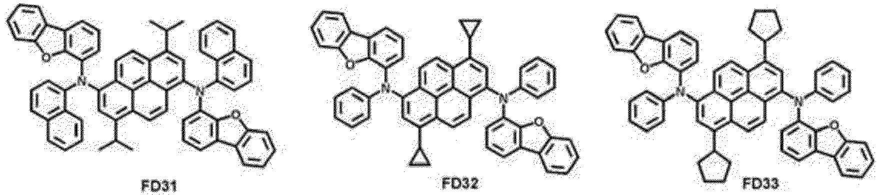

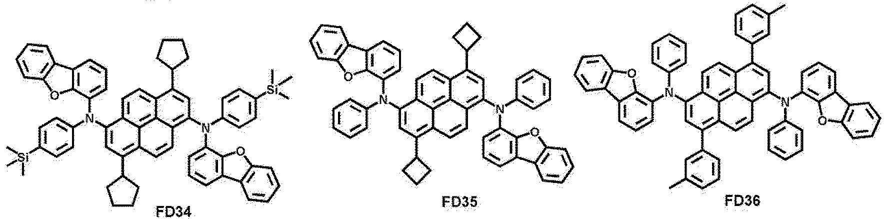

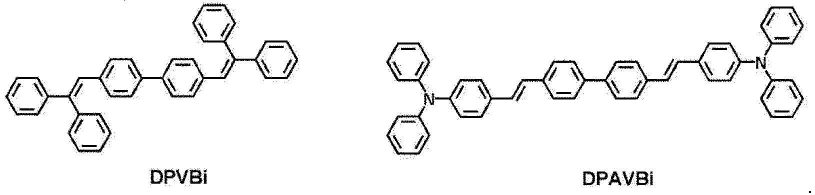

### Delayed fluorescence material

The emission layer may further include a delayed fluorescence material.

In the specification, the delayed fluorescence material may be selected from compounds capable of emitting delayed fluorescence based on a delayed fluorescence emission mechanism.

The delayed fluorescence material included in the emission layer may act as a host or a dopant depending on the type (or kind) of other materials included in the emission layer.

In an embodiment, a difference between a triplet energy level (eV) of the delayed fluorescence material and the singlet energy level (eV) of the delayed fluorescence material may be greater than or equal to 0 eV and less than or equal to 0.5 eV. When the difference between the triplet energy level (eV) of the delayed fluorescence material and the singlet energy level (eV) of the delayed fluorescence material is satisfied within the range above, up-conversion from the triplet state to the singlet state of the delayed fluorescence materials may effectively occur, and thus, the light-emitting device 10 may have improved luminescence efficiency.

For example, the delayed fluorescence material may include: i) a material including at least one electron donor (for example, a π electron-rich C₃-C₆₀ cyclic group and/or the like, such as a carbazole group) and at least one electron acceptor (for example, a sulfoxide group, a cyano group, a π electron-deficient nitrogen-containing C₁-C₆₀ cyclic group, and/or the like), ii) a material including a C₈-C₆₀ polycyclic group including at least two cyclic groups condensed to each other while sharing boron (B), and/or the like.

Examples of the delayed fluorescence material may include at least one of the following compounds DF1 to DF9:

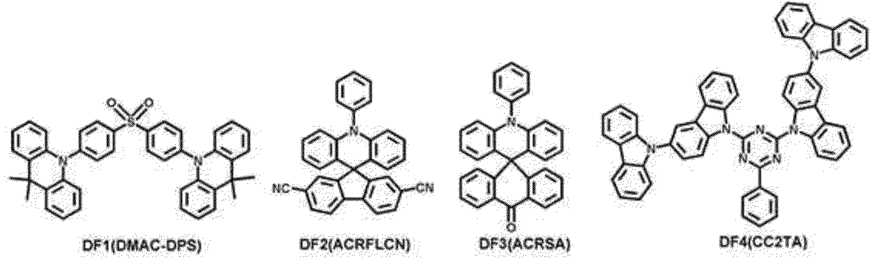

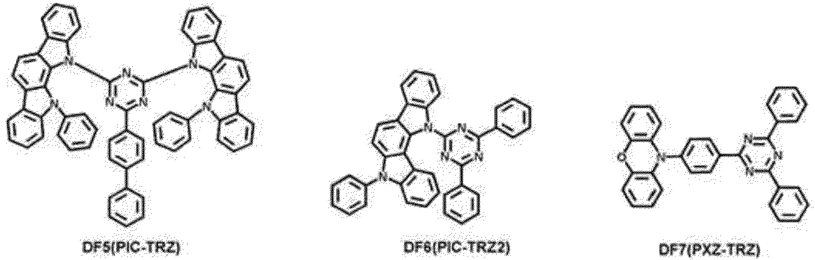

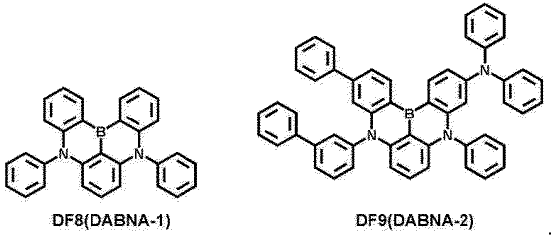

In an embodiment, the delayed fluorescence compound may be represented by Formula 551 or 552: 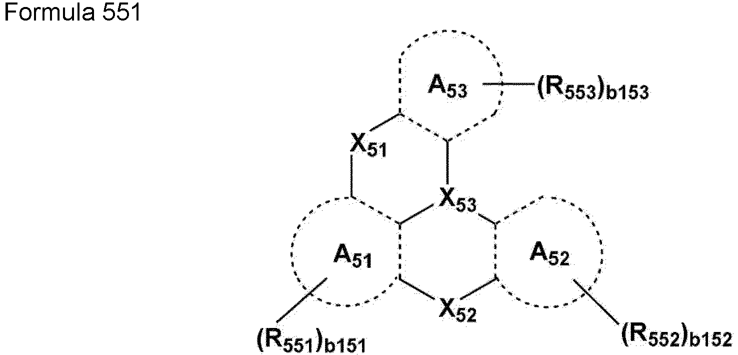 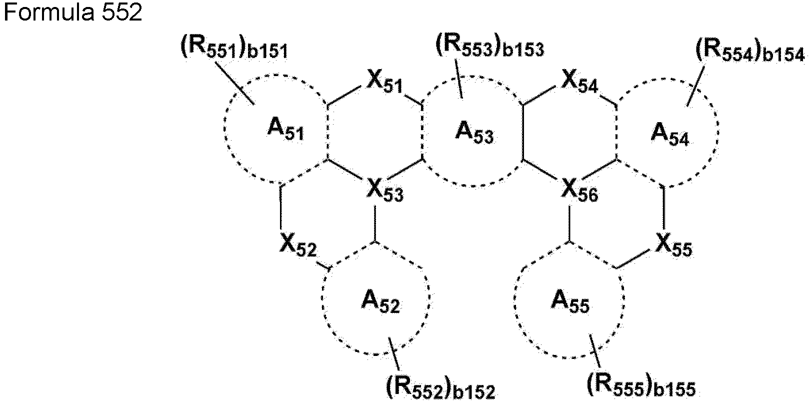
wherein, in Formulae 551 and 552, A₅₁ to A₅₅ may each independently be a C₃-C₆₀ carbocyclic group or a C₁-C₆₀ heterocyclic group,
X₅₁, X₅₂, X₅₄, and X₅₅ may each independently be a single bond (e.g., a covalent bond), -O-, -S-, -C(R₅₅₆)(R₅₅₇)-, -N(R₅₅₆)-, Si(R₅₅₆)(R₅₅₇)-, -C(=O)₂-, -S(=O)₂-, - B(R₅₅₆)-, -P(R₅₅₆)-, or -P(=O)(R₅₅₆)-,
X₅₃ and X₅₆ may each independently be N, B, P, P(=O), or P(=S),
R₅₅₁ to R₅₅₇ may each independently be hydrogen, deuterium, -F, -Cl, -Br, -I, a hydroxyl group, a cyano group, a nitro group, an amidino group, a hydrazino group, a hydrazono group, a substituted or unsubstituted C₁-C₂₀ alkyl group, a C₁-C₂₀ alkoxy group unsubstituted or substituted with at least one R₁₀ₐ, a C₃-C₁₀ cycloalkyl group unsubstituted or substituted with at least one R₁₀ₐ, a C₁-C₁₀ heterocycloalkyl group unsubstituted or substituted with at least one R₁₀ₐ, a C₃-C₁₀ cycloalkenyl group unsubstituted or substituted with at least one R₁₀ₐ, a C₁-C₁₀ heterocycloalkenyl group unsubstituted or substituted with at least one R₁₀ₐ, a C₆-C₆₀ aryl group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₁-C₆₀ heteroaryl group unsubstituted or substituted with at least one R₁₀ₐ, a monovalent non-aromatic condensed polycyclic group unsubstituted or substituted with at least one R₁₀ₐ, a monovalent non-aromatic condensed heteropolycyclic group unsubstituted or substituted with at least one R₁₀ₐ, -Si(Q₄₁)(Q₄₂)(Q₄₃), -N(Q₄₁)(Q₄₂), - B(Q₄₁)(Q₄₂), -C(=O)(Q₄₁), -S(=O)₂(Q₄₁), or -P(=O)(Q₄₁)(Q₄₂),
b151 to b155 may each independently be 1, 2, 3, 4, 5, 6, 7, or 8,
neighboring two or more of R₅₅₁ to R₅₅₇ may optionally be bonded to each other to form a C₃-C₆₀ carbocyclic group unsubstituted or substituted with at least one R₁₀ₐ or a C₁-C₆₀ heterocyclic group unsubstituted or substituted with at least one R₁₀ₐ,
R₁₀ₐ may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, a C₁-C₆₀ heteroarylthio group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₁-C₆₀ heteroaryloxy group, or a C₁-C₆₀ heteroarylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₁-C₆ heteroaryloxy group, a C₁-C₆₀ heteroarylthio group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q₁₁ to Q₁₃, Q₂₁ to Q₂₃, Q₃₁ to Q₃₃, Q₄₁ to Q₄₃, Q₃₀₁ to Q₃₀₃, Q₃₂₁ to Q₃₂₃, and Q₃₃₁ to Q₃₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof.

In an embodiment, the delayed fluorescence material may be selected from Compounds DFD1 to DFD30:

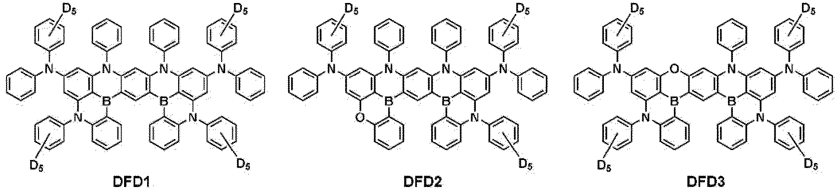

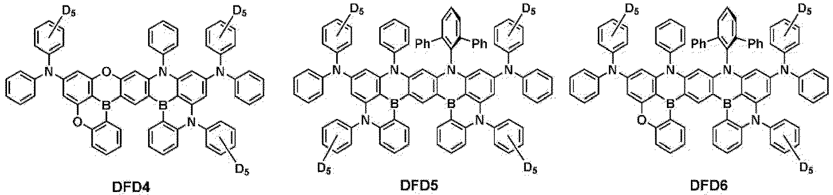

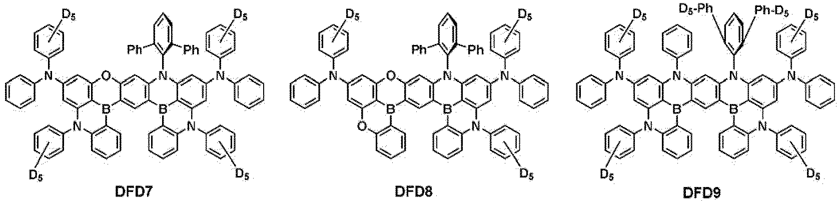

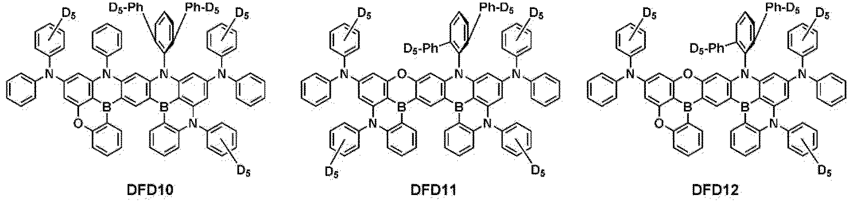

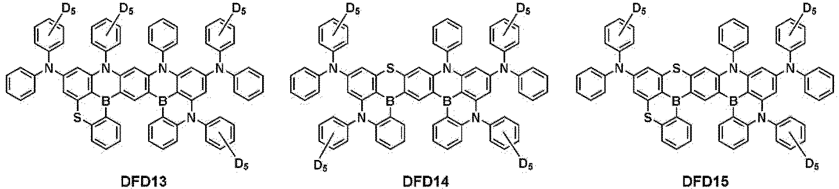

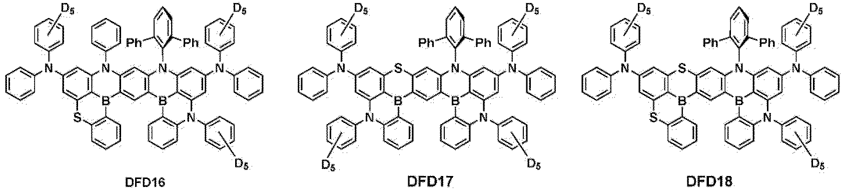

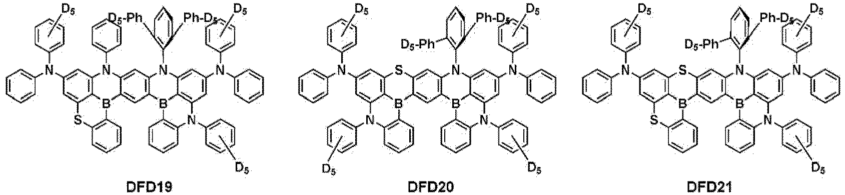

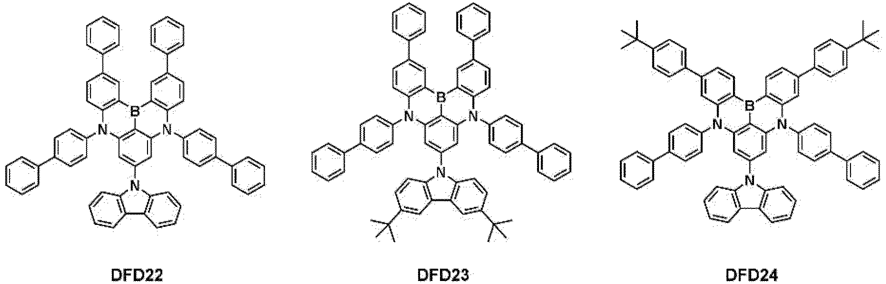

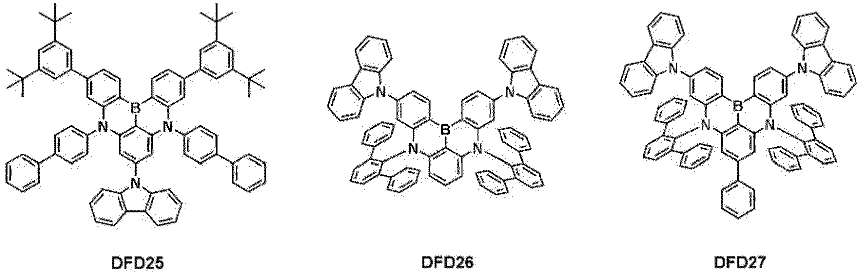

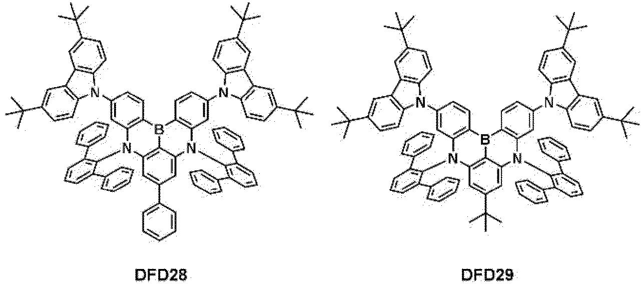

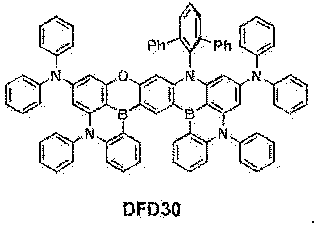

### Quantum dots

The emission layer may include quantum dots.

The term "quantum dot" as used herein refers to a crystal of a semiconductor compound, and may include any suitable material capable of emitting light of various suitable emission wavelengths according to the size of the crystal.

A diameter of the quantum dots may be, for example, in a range of about 1 nm to about 10 nm.

The quantum dots may be synthesized by a wet chemical process, a metal organic chemical vapor deposition process, a molecular beam epitaxy process, and/or any process similar thereto.

The wet chemical process is a method including mixing together a precursor material with an organic solvent and then growing quantum dot particle crystals. When the crystals grow, the organic solvent naturally acts as a dispersant coordinated on the surface of the quantum dot crystals and controls the growth of the crystals so that the growth of quantum dot particles may be controlled through a process which costs lower and is easier than vapor deposition methods, such as metal organic chemical vapor deposition (MOCVD) or molecular beam epitaxy (MBE).

The quantum dots may include: a Group II-VI semiconductor compound; a Group III-V semiconductor compound; a Group III-VI semiconductor compound; a Group I-III-VI semiconductor compound; a Group IV-VI semiconductor compound; a Group IV element or compound; or any combination thereof.

Examples of the Group II-VI semiconductor compound are: a binary compound, such as CdS, CdSe, CdTe, ZnS, ZnSe, ZnTe, ZnO, HgS, HgSe, HgTe, MgSe, MgS, and the like; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and the like; a quaternary compound, such as CdZnSeS, CdZnSeTe, CdZnSTe, CdHgSeS, CdHgSeTe, CdHgSTe, HgZnSeS, HgZnSeTe, HgZnSTe, and the like; or any combination thereof.

Examples of the Group III-V semiconductor compound are: a binary compound, such as GaN, GaP, GaAs, GaSb, AlN, AlP, AlAs, AlSb, InN, InP, InAs, InSb, and the like; a ternary compound, such as GaNP, GaNAs, GaNSb, GaPAs, GaPSb, AlNP, AlNAs, AlNSb, AlPAs, AlPSb, InGaP, InNP, InAlP, InNAs, InNSb, InPAs, InPSb, and the like; a quaternary compound, such as GaAlNP, GaAlNAs, GaAlNSb, GaAlPAs, GaAlPSb, GalnNP, GalnNAs, GalnNSb, GalnPAs, GalnPSb, InAlNP, InAlNAs, InAlNSb, InAlPAs, InAlPSb, and the like; or any combination thereof. In an embodiment, the Group III-V semiconductor compound may further include a Group II element. Examples of the Group III-V semiconductor compound further including the Group II element are InZnP, InGaZnP, InAlZnP, and the like.

Examples of the Group III-VI semiconductor compound are: a binary compound, such as GaS, GaSe, Ga₂Se₃, GaTe, InS, InSe, In₂S₃, In₂Se₃, InTe, and the like; a ternary compound, such as InGaS₃, InGaSe₃, and the like; or any combination thereof.

Examples of the Group I-III-VI semiconductor compound are: a ternary compound, such as AgInS, AgInS₂, CuInS, CuInS₂, CuGaO₂, AgGaO₂, AgAlO₂, and the like; or any combination thereof.

Examples of the Group IV-VI semiconductor compound are: a binary compound, such as SnS, SnSe, SnTe, PbS, PbSe, PbTe, and the like; a ternary compound, such as SnSeS, SnSeTe, SnSTe, PbSeS, PbSeTe, PbSTe, SnPbS, SnPbSe, SnPbTe, and the like; a quaternary compound, such as SnPbSSe, SnPbSeTe, SnPbSTe, and the like; or any combination thereof.

Examples of the Group IV element or compound are: a single element compound, such as Si, Ge, and the like; a binary compound, such as SiC, SiGe, and the like; or any combination thereof.

Each element included in a multi-element compound, such as the binary compound, the ternary compound, and the quaternary compound, may be present at a uniform concentration or non-uniform concentration in a particle.

In an embodiment, the quantum dot may have a single structure in which the concentration of each element in the quantum dot is uniform, or may have a core-shell dual structure. For example, a material included in the core and a material included in the shell may be different from each other.

The shell of the quantum dot may act as a protective layer which prevents or reduces chemical denaturation of the core to maintain semiconductor characteristics, and/or as a charging layer which impart electrophoretic characteristics to the quantum dot. The shell may be single-layered or multi-layered. The interface between the core and the shell may have a concentration gradient in which the concentration of an element existing in the shell decreases along a direction toward the center of the core.

Examples of the shell of the quantum dot are an oxide of metal, metalloid, and/or non-metal, a semiconductor compound, or a combination thereof. Examples of the oxide of metal, metalloid, and/or non-metal are: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, NiO, and the like; a ternary compound, such as MgAl₂O₄, CoFe₂O₄, NiFe₂O₄, CoMn₂O₄, and the like; or any combination thereof. Examples of the semiconductor compound are: as described herein, a Group II-VI semiconductor compound; a Group III-V semiconductor compound; a Group III-VI semiconductor compound; a Group I-III-VI semiconductor compound; a Group IV-VI semiconductor compound; or any combination thereof. Examples of the semiconductor compound are CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or any combination thereof.

A full width at half maximum (FWHM) of an emission wavelength spectrum of the quantum dots may be about 45 nm or less, for example, about 40 nm or less, and for example, about 30 nm or less, and within these ranges, color purity and/or color reproducibility of the quantum dots may be improved. In addition, since light emitted through the quantum dots is emitted in all (e.g., substantially all) directions, the wide viewing angle may be improved.

In addition, the quantum dots may be in the form of a spherical particle, a pyramidal particle, a multi-arm particle, a cubic nanoparticle, a nanotube particle, a nanowire particle, a nanofiber particle, a nanoplate particle, and/or the like.

By controlling the size of the quantum dot, an energy band gap may be adjustable so that light having various suitable wavelength bands may be obtained from the emission layer including the quantum dot. Accordingly, by using quantum dots of different sizes, the organic light-emitting device that emits light of various suitable wavelengths may be implemented. In an embodiment, the size of quantum dots may be selected to emit red light, green light, and/or blue light. In addition, the size of quantum dots may be configured to emit white light by combining light of various suitable colors.

### Electron transport region in interlayer 130

The electron transport region may have: i) a single-layer structure consisting of a single layer consisting of a single material, ii) a single-layer structure consisting of a single layer consisting of a plurality of materials that are different from each other, or iii) a multi-layer structure including a plurality of layers including multiple materials that are different from each other.

The electron transport region may include a buffer layer, a hole blocking layer, an electron control layer, an electron transport layer, an electron injection layer, or any combination thereof.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein constituent layers of each structure are sequentially stacked from the emission layer.

In an embodiment, the electron transport region (for example, the buffer layer, the hole blocking layer, the electron control layer, and/or the electron transport layer in the electron transport region) may include a metal-free compound including at least one π electron-deficient nitrogen-containing C₁-C₆₀ cyclic group.

For example, the electron transport region may include a compound represented by Formula 601:

Formula 601 [Ar₆₀₁]ₓₑ₁₁-[(L₆₀₁)ₓₑ₁-R₆₀₁]ₓₑ₂₁.

wherein, in Formula 601,
Ar₆₀₁ and L₆₀₁ may each independently be a C₃-C₆₀ carbocyclic group unsubstituted or substituted with at least one R₁₀ₐ or a C₁-C₆₀ heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ carbocyclic group unsubstituted or substituted with at least one R₁₀ₐ, a C₁-C₆₀ heterocyclic group unsubstituted or substituted with at least one R₁₀ₐ, -Si(Q₆₀₁)(Q₆₀₂)(Q₆₀₃), -C(=O)(Q₆₀₁), -S(=O)₂(Q₆₀₁), or -P(=O)(Q₆₀₁)(Q₆₀₂),
Q₆₀₁ to Q₆₀₃ may each be the same as described in connection with Q₁,
xe21 may be 1, 2, 3, 4, or 5, and
at least one of Ar₆₀₁, L₆₀₁, and R₆₀₁ may each independently be a π electron-deficient nitrogen-containing C₁-C₆₀ cyclic group unsubstituted or substituted with at least one R₁₀ₐ.

In an embodiment, when xe11 in Formula 601 is 2 or more, two or more of Ar₆₀₁ may be linked to each other via a single bond (e.g., a covalent bond).

In an embodiment, Ar₆₀₁ in Formula 601 may be a substituted or unsubstituted anthracene group.

In one or more embodiments, the electron transport region may include a compound represented by Formula 601-1: 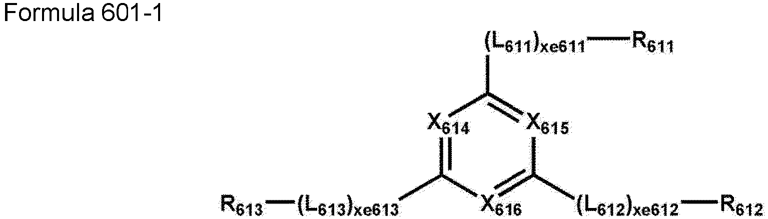 wherein, in Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ may each be the same as described in connection with L₆₀₁,
xe611 to xe613 may each be the same as described in connection with xe1,
R₆₁₁ to R₆₁₃ may each be the same as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ alkyl group, a C₁-C₂₀ alkoxy group, a C₃-C₆₀ carbocyclic group unsubstituted or substituted with at least one R₁₀ₐ, or a C₁-C₆₀ heterocyclic group unsubstituted or substituted with at least one R₁₀ₐ.

For example, xe1 and xe611 to xe613 in Formulae 601 and 601-1 may each independently be 0, 1, or 2.

In one or more embodiments, the electron transport region may include: one of Compounds ET1 to ET45; 2,9-dimethyl-4,7-diphenyl-1,10-phenanthroline (BCP); 4,7-diphenyl-1,10-phenanthroline (Bphen); Alq₃; BAlq; TAZ; NTAZ; or any combination thereof:

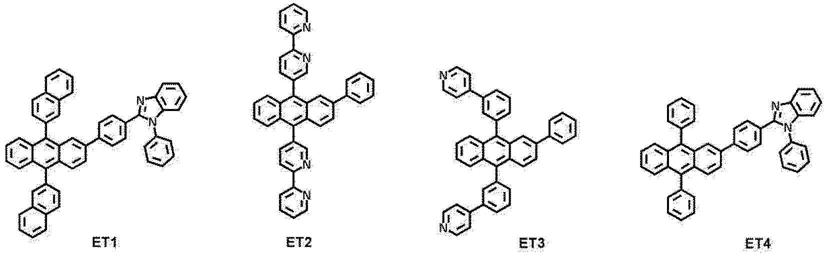

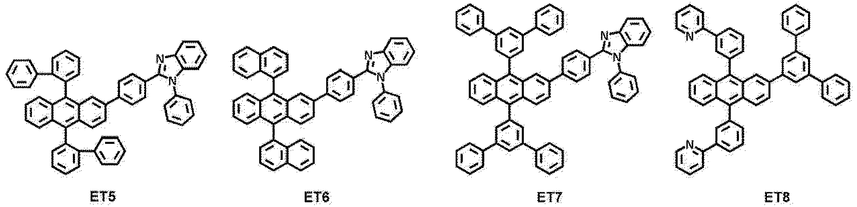

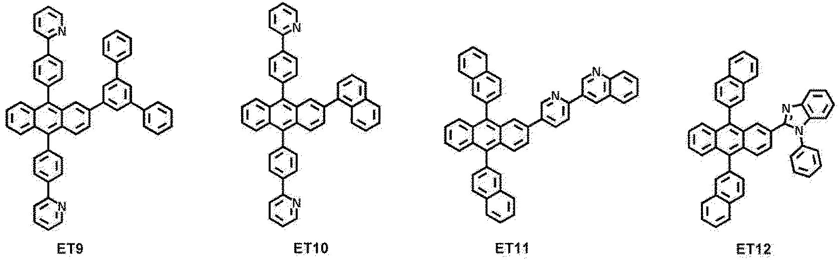

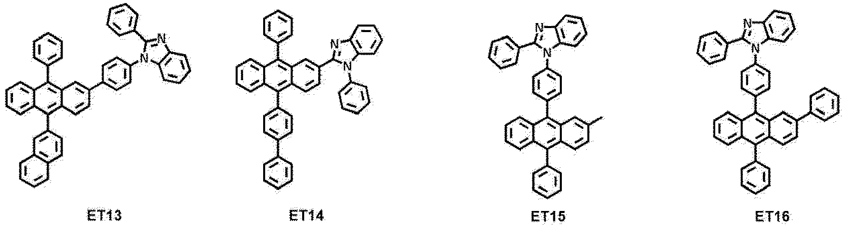

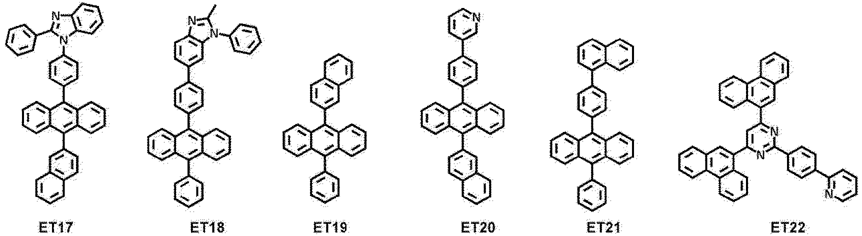

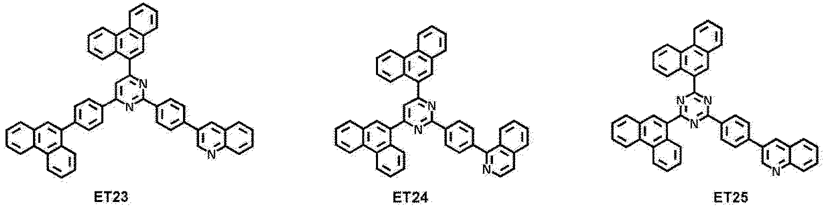

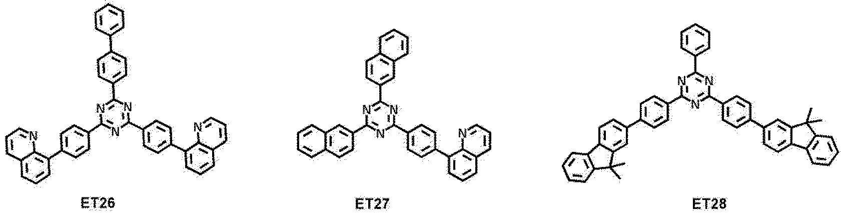

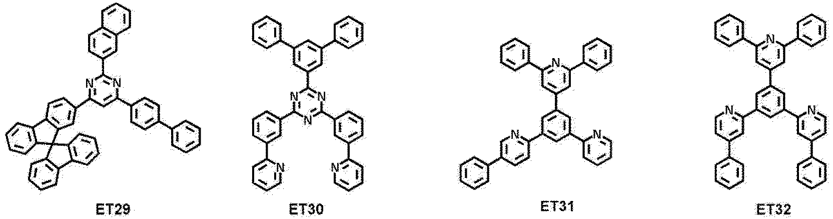

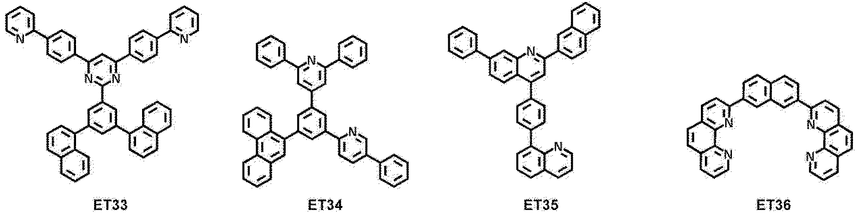

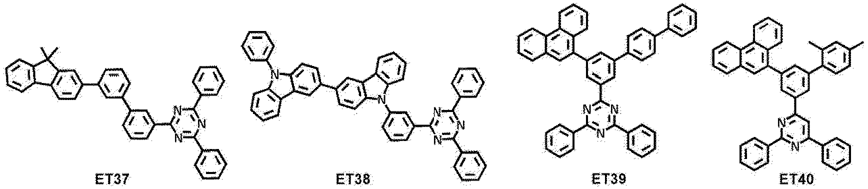

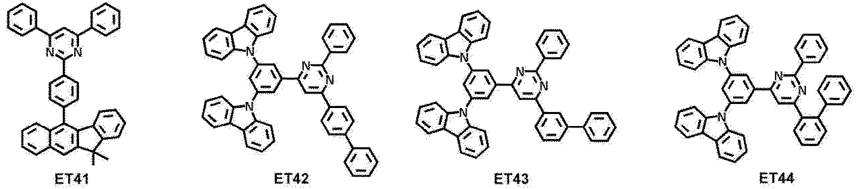

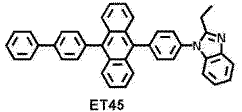

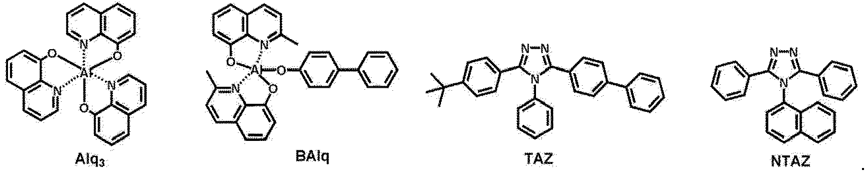

A thickness of the electron transport region may be in a range of about 100 Å to about 5,000 Å, for example, about 160 Å to about 4,000 Å. When the electron transport region includes a buffer layer, a hole blocking layer, an electron control layer, an electron transport layer, or any combination thereof, a thickness of the buffer layer, the hole blocking layer, or the electron control layer may be in a range of about 20 Å to about 1,000 Å, for example, about 30 Å to about 300 Å, and a thickness of the electron transport layer may be in a range of about 100 Å to about 1,000 Å, for example, about 150 Å to about 500 Å. When the thicknesses of the buffer layer, the hole blocking layer, the electron control layer, the electron transport layer, and/or the electron transport region are within these ranges, suitable or satisfactory electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or any combination thereof. The metal ion of an alkali metal complex may be a Li ion, a Na ion, a K ion, a Rb ion, and/or a Cs ion, and the metal ion of an alkaline earth metal complex may be a Be ion, a Mg ion, a Ca ion, a Sr ion, and/or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

For example, the metal-containing material may include a Li complex. The Li complex may include, for example, Compound ET-D1 (LiQ) or ET-D2:

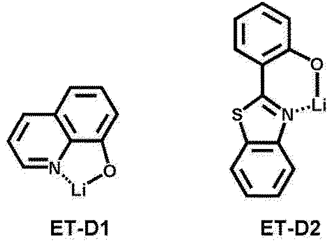

The electron transport region may include an electron injection layer that facilitates the injection of electrons from the second electrode 150. The electron injection layer may directly contact (e.g., directly physically contact) the second electrode 150.

The electron injection layer may have: i) a single-layered structure consisting of a single layer consisting of a single material, ii) a single-layered structure consisting of a single layer consisting of a plurality of layers that are different from each other, or iii) a multi-layered structure including a plurality of layers including multiple materials that are different from each other.

The electron injection layer may include an alkali metal, alkaline earth metal, a rare earth metal, an alkali metal-containing compound, alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may be oxides, halides (for example, fluorides, chlorides, bromides, iodides, etc.), and/or tellurides of the alkali metal, the alkaline earth metal, and the rare earth metal, or any combination thereof.

The alkali metal-containing compound may include: an alkali metal oxide, such as Li₂O, Cs₂O, K₂O, and/or the like; alkali metal halides, such as LiF, NaF, CsF, KF, Lil, Nal, Csl, KI, and/or the like; or any combination thereof. The alkaline earth metal-containing compound may include an alkaline earth metal compound, such as BaO, SrO, CaO, BaₓSr₁₋ₓO (wherein x is a real number satisfying 0<x<1), BaₓCa₁₋ₓO (wherein x is a real number satisfying 0<x<1), and/or the like. The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In an embodiment, the rare earth metal-containing compound may include lanthanide metal telluride. Examples of the lanthanide metal telluride are LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, and the like.

The alkali metal complex, the alkaline earth-metal complex, and the rare earth metal complex may include i) one of ions of the alkali metal, the alkaline earth metal, and/or the rare earth metal and ii), as a ligand bonded to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any combination thereof.

In an embodiment, the electron injection layer may include or consist of an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In one or more embodiments, the electron injection layer may further include an organic material (for example, a compound represented by Formula 601).

In an embodiment, the electron injection layer may include or consist of i) an alkali metal-containing compound (for example, alkali metal halide), or ii) a) an alkali metal-containing compound (for example, alkali metal halide); and b) an alkali metal, an alkaline earth metal, a rare earth metal, or any combination thereof. For example, the electron injection layer may be a KI:Yb co-deposited layer, an RbI:Yb co-deposited layer, a LiF:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof may be uniformly or non-uniformly dispersed in a matrix including the organic material.

A thickness of the electron injection layer may be in a range of about 1 Å to about 100 Å, and, for example, about 3 Å to about 90 Å. When the thickness of the electron injection layer is within these ranges, suitable or satisfactory electron injection characteristics may be obtained without a substantial increase in driving voltage.

### Second electrode 150

The second electrode 150 is on the interlayer 130 having the aforementioned structure. The second electrode 150 may be a cathode, which is an electron injection electrode, and as a material for forming the second electrode 150, a metal, an alloy, an electrically conductive compound, or any combination thereof, each having a low-work function, may be used.

The second electrode 150 may include Li, Ag, Mg, Al, Al-Li, Ca, Mg-In, Mg-Ag, Yb, Ag-Yb, ITO, IZO, or any combination thereof. The second electrode 150 may be a transmissive electrode, a transflective electrode, or a reflective electrode.

The second electrode 150 may have a single-layer structure or a multi-layer structure including a plurality of layers.

### Capping layer

The first capping layer may be outside the first electrode 110, and/or the second capping layer may be outside the second electrode 150. In particular, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in the emission layer of the interlayer 130 of the organic light-emitting device 10 may be extracted toward the outside through the first electrode 110 which is a transflective electrode or a transmissive electrode, and the first capping layer. Light generated in the emission layer of the interlayer 130 of the organic light-emitting device 10 may be extracted toward the outside through the second electrode 150 which is a transflective electrode or a transmissive electrode, and the second capping layer.

The first capping layer and the second capping layer may increase external emission efficiency according to the principle of constructive interference. Accordingly, the light extraction efficiency of the light-emitting device 10 is increased, so that the luminescence efficiency of the light-emitting device 10 may be improved.

Each of the first capping layer and the second capping layer may include a material having a refractive index of greater than or equal to 1.6 (at a wavelength of 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer and the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may optionally be substituted with a substituent including O, N, S, Se, Si, F, Cl, Br, I, or any combination thereof.

In an embodiment, at least one of the first capping layer and/or the second capping layer may each independently include an amine group-containing compound.

In one or more embodiments, at least one of the first capping layer and the second capping layer may each independently include a compound represented by Formula 201, a compound represented by Formula 202, or any combination thereof.

In one or more embodiments, at least one of the first capping layer and the second capping layer may each independently include one of Compounds HT28 to HT33, one of Compounds CP1 to CP6, β-NPB, or any combination thereof:

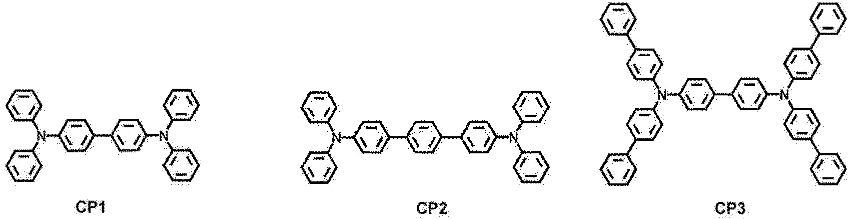

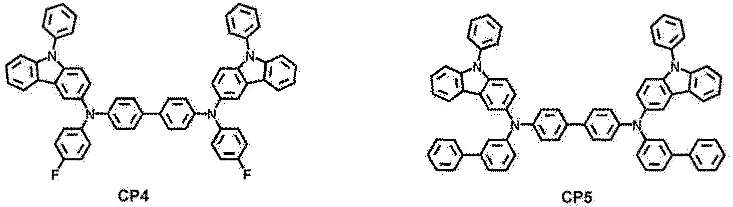

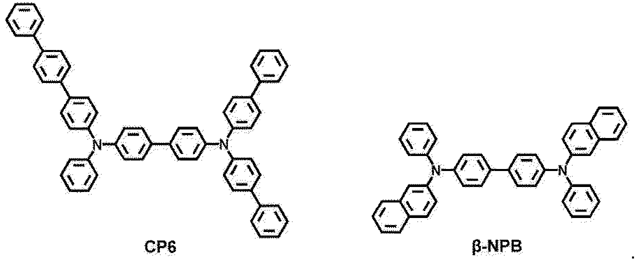

### Film

The organometallic compound represented by Formula 1 may be included in various suitable films. Accordingly, another aspect of the disclosure provides a film including an organometallic compound represented by Formula 1. The film may be, for example, an optical member (e.g., a light control means) (for example, a color filter, a color conversion member, a capping layer, a light extraction efficiency enhancement layer, a selective light absorbing layer, a polarizing layer, a quantum dot-containing layer, and/or the like), a light-blocking member (for example, a light reflective layer, a light absorbing layer, and/or the like), a protective member (for example, an insulating layer (e.g., an electrically insulating layer), a dielectric layer, and/or the like).

### Electronic apparatus

The organic light-emitting device may be included in various suitable electronic apparatuses. For example, the electronic apparatus including the organic light-emitting device may be a light-emitting apparatus, an authentication apparatus, and/or the like.

The electronic apparatus (for example, a light-emitting apparatus) may further include, in addition to the organic light-emitting device, i) a color filter, ii) a color conversion layer, or iii) a color filter and a color conversion layer. The color filter and/or the color conversion layer may be provided in at least one traveling direction of light emitted from the organic light-emitting device. For example, the light emitted from the organic light-emitting device may be blue light or white light. The organic light-emitting device may be the same as described above. In an embodiment, the color conversion layer may include a quantum dot. The quantum dot may be, for example, the quantum dot as described herein.

The electronic apparatus may include a first substrate. The first substrate may include a plurality of subpixel areas, the color filter may include a plurality of color filter areas respectively corresponding to the subpixel areas, and the color conversion layer may include a plurality of color conversion areas respectively corresponding to the subpixel areas.

A pixel-defining film may be provided among the subpixel areas to define each of the subpixel areas.

The color filter may further include a plurality of color filter areas and light-shielding patterns provided among the color filter areas, and the color conversion layer may further include a plurality of color conversion areas and light-shielding patterns provided among the color conversion areas.

The plurality of color filter areas (or the plurality of color conversion areas) may include a first area that emits a first color light, a second area that emits a second color light, and/or a third area that emits a third color light, wherein the first color light, the second color light, and/or the third color light may have different maximum emission wavelengths from one another. For example, the first color light may be red light, the second color light may be green light, and the third color light may be blue light. For example, the plurality of color filter areas (or the plurality of color conversion areas) may include quantum dots. In some embodiments, the first area may include a red quantum dot, the second area may include a green quantum dot, and the third area may not include a quantum dot. Details on the quantum dot may be referred to the descriptions provided herein. The first area, the second area, and/or the third area may each further include a scatterer (e.g., a light scatterer).

For example, the organic light-emitting device may emit a first light, the first area may absorb the first light to emit a first-first color light, the second area may absorb the first light to emit a second-first color light, and the third area may absorb the first light to emit a third-first color light. Here, the first-first color light, the second-first color light, and the third-first color light may have different maximum emission wavelengths. In some embodiments, the first light may be blue light, the first-first color light may be red light, the second-first color light may be green light, and the third-first color light may be blue light.

The electronic apparatus may further include a thin-film transistor in addition to the organic light-emitting device as described above. The thin-film transistor may include a source electrode, a drain electrode, and an activation layer, wherein any one of the source electrode and/or the drain electrode may be electrically connected to any one of the first electrode and/or the second electrode of the organic light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

The electronic apparatus may further include a sealing portion for sealing the organic light-emitting device. The sealing portion may be between the color filter and/or the color conversion layer and the organic light-emitting device. The sealing portion allows light from the organic light-emitting device to be extracted to the outside, and concurrently (e.g., simultaneously) prevents or reduces penetration of ambient air and/or moisture into the light-emitting device. The sealing portion may be a sealing substrate including a transparent glass substrate and/or a plastic substrate. The sealing portion may be a thin-film encapsulation layer including at least one layer of an organic layer and/or an inorganic layer. When the sealing portion is a thin film encapsulation layer, the electronic apparatus may be flexible.

Various suitable functional layers may be additionally on the sealing portion, in addition to the color filter and/or the color conversion layer, according to the use of the electronic apparatus. The functional layers may include a touch screen layer, a polarizing layer, and/or the like. The touch screen layer may be a pressure-sensitive touch screen layer, a capacitive touch screen layer, and/or an infrared touch screen layer.

The authentication apparatus may further include, in addition to the light-emitting device as described above, a biometric information collector. The authentication apparatus may be, for example, a biometric authentication apparatus that authenticates an individual by using biometric information of a living body (for example, fingertips, pupils, etc.).

The electronic apparatus may be applied to various suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, and/or endoscope displays), fish finders, various measuring instruments, meters (for example, meters for a vehicle, an aircraft, and/or a vessel), projectors, and/or the like.

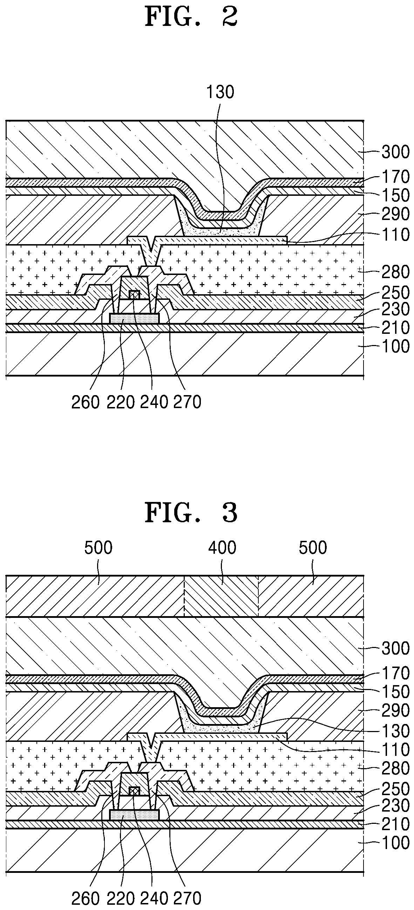

### Description of FIGS. 2 and 3

FIG. 2 is a cross-sectional view showing a light-emitting apparatus according to an embodiment.

The light-emitting apparatus of FIG. 2 includes a substrate 100, a thin-film transistor (TFT), an organic light-emitting device, and an encapsulation portion that encapsulates the organic light-emitting device.

The substrate 100 may be a flexible substrate, a glass substrate, and/or a metal substrate. A buffer layer 210 may be on the substrate 100. The buffer layer 210 may prevent or reduce penetration of impurities through the substrate 100 and may provide a flat surface on the substrate 100.

A TFT may be on the buffer layer 210. The TFT may include an activation layer 220, a gate electrode 240, a source electrode 260, and a drain electrode 270.

The activation layer 220 may include an inorganic semiconductor, such as silicon and/or polysilicon, an organic semiconductor, and/or an oxide semiconductor, and may include a source region, a drain region, and a channel region.

A gate insulating film 230 for insulating the activation layer 220 from the gate electrode 240 may be on the activation layer 220, and the gate electrode 240 may be on the gate insulating film 230.

An interlayer insulating film 250 may be on the gate electrode 240. The interlayer insulating film 250 may be between the gate electrode 240 and the source electrode 260 and between the gate electrode 240 and the drain electrode 270, to insulate (e.g., electrically insulate) from one another.

The source electrode 260 and the drain electrode 270 may be on the interlayer insulating film 250. The interlayer insulating film 250 and the gate insulating film 230 may expose the source region and the drain region of the activation layer 220, and the source electrode 260 and the drain electrode 270 may be in contact with the exposed portions of the source region and the drain region of the activation layer 220, respectively.

The TFT may be electrically connected to the organic light-emitting device to drive the organic light-emitting device, and may be covered and protected by a passivation layer 280. The passivation layer 280 may include an inorganic insulating film (e.g., an inorganic electrically insulating film), an organic insulating film (e.g., an organic electrically insulating film), or any combination thereof. The passivation layer 280 may include an inorganic insulating film (e.g., an inorganic electrically insulating film), an organic insulating film (e.g., an organic electrically insulating film), or any combination thereof. The organic light-emitting device may include the first electrode 110, the interlayer 130, and the second electrode 150.

The first electrode 110 may be on the passivation layer 280. The passivation layer 280 may expose a portion of the drain electrode 270, not fully covering the drain electrode 270, and the first electrode 110 may be connected to the exposed portion of the drain electrode 270.

A pixel defining layer 290 including an insulating material (e.g., an electrically insulating material) may be arranged on the first electrode 110. The pixel defining layer 290 may expose a certain region of the first electrode 110, and an interlayer 130 may be in the exposed region of the first electrode 110. The pixel defining layer 290 may be a polyimide-based organic film and/or a polyacrylic-based organic film. In some embodiments, at least some layers of the interlayer 130 may extend beyond the upper portion of the pixel defining layer 290 to be in the form of a common layer.

The second electrode 150 may be on the interlayer 130, and a capping layer 170 may be additionally on the second electrode 150. The capping layer 170 may cover the second electrode 150.

The encapsulation portion 300 may be on the capping layer 170. The encapsulation portion 300 may be on the organic light-emitting device to protect the organic light-emitting device from moisture and/or oxygen. The encapsulation portion 300 may include: an inorganic film including silicon nitride (SiNₓ), silicon oxide (SiOₓ), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or any combination thereof; or any combination of the inorganic films and the organic films.

FIG. 3 shows a cross-sectional view showing a light-emitting apparatus according to another embodiment.

The light-emitting apparatus of FIG. 3 is the same as the light-emitting apparatus of FIG. 2, except that a light-shielding pattern 500 and a functional region 400 are additionally on the encapsulation portion 300. The functional region 400 may be i) a color filter area, ii) a color conversion area, or iii) a combination of the color filter area and the color conversion area. In an embodiment, the organic light-emitting device included in the light-emitting apparatus of FIG. 3 may be a tandem organic light-emitting device.

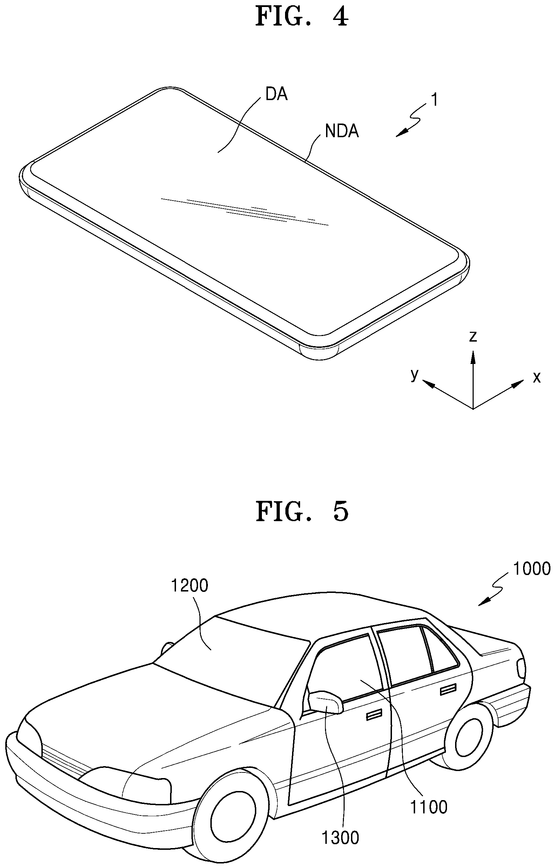

### Description of FIG. 4

FIG. 4 is a schematic perspective view of electronic equipment 1 including the organic light-emitting device according to an embodiment. The electronic equipment 1 may be, as a device apparatus that displays a moving image and/or still image, a portable electronic equipment, such as a mobile phone, a smart phone, a tablet personal computer (PC), a mobile communication terminal, an electronic notebook, an electronic book, a portable multimedia player (PMP), a navigation, and/or a ultra-mobile PC (UMPC), as well as various suitable products, such as a television, a laptop, a monitor, a billboards, and/or an Internet of things (IOT) device. The electronic equipment 1 may be such a product above or a part thereof. In addition, the electronic equipment 1 may be a wearable device, such as a smart watch, a watch phone, a glasses-type display, and/or a head mounted display (HMD), or a part of the wearable device. However, embodiments are not limited thereto. For example, the electronic equipment 1 may include a dashboard of a vehicle, a center fascia of a vehicle, a center information display on a dashboard of a vehicle, a room mirror display replacing a side mirror of a vehicle, an entertainment display for the rear seat of a vehicle and/or a display arranged on the back of the front seat, and/or a head up display (HUD) installed in the front of a vehicle and/or projected on a front window glass, a computer generated hologram augmented reality head up display (CGH AR HUD). FIG. 4 illustrates a case in which the electronic equipment 1 is a smart phone for convenience of explanation.

The electronic equipment 1 may include a display area DA and a non-display area NDA outside the display area DA. A display device may implement an image through an array of a plurality of pixels that are provided two-dimensionally in the display area DA.

The non-display area NDA is an area that does not display an image, and may entirely surround the display area DA. On the non-display area NDA, a driver for providing electrical signals and/or power to display devices on the display area DA may be provided. On the non-display area NDA, a pad, which is an area to which an electronic element or a printing circuit board, may be electrically connected may be provided.

In the electronic equipment 1, a length in the x-axis direction and a length in the y-axis direction may be different from each other. In an embodiment, as shown in FIG. 4, the length in the x-axis direction may be shorter than the length in the y-axis direction. In one or more embodiments, the length in the x-axis direction may be the same as the length in the y-axis direction. In one or more embodiments, the length in the x-axis direction may be longer than the length in the y-axis direction.

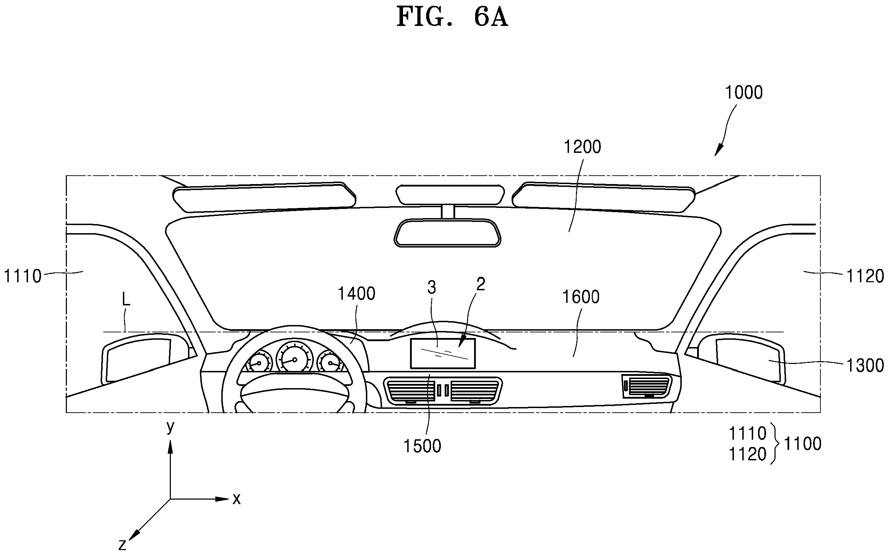

### Descriptions of FIGS. 5 and 6A to 6C

FIG. 5 is a diagram illustrating the exterior of a vehicle 1000 as electronic equipment including the organic light-emitting device according to an embodiment. FIGS. 6A to 6C are each a schematic view of the interior of the vehicle 1000 according to one or more embodiments.

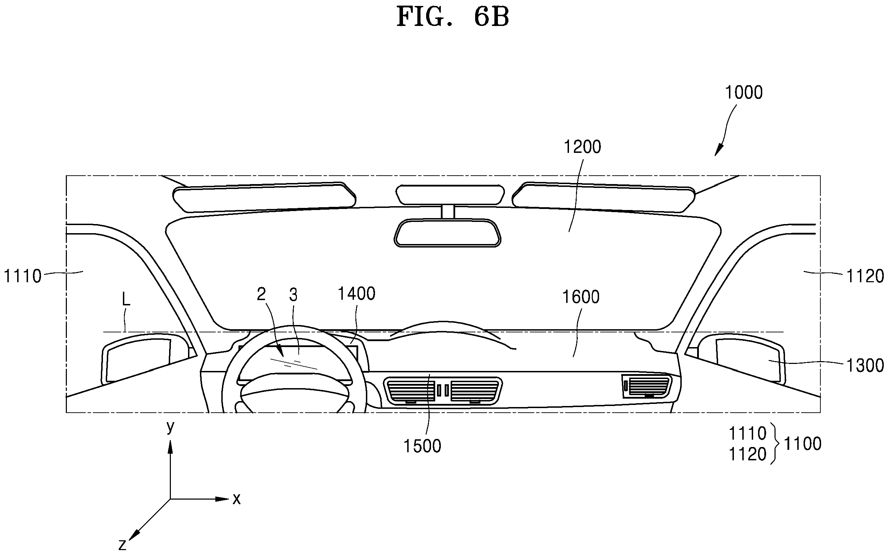

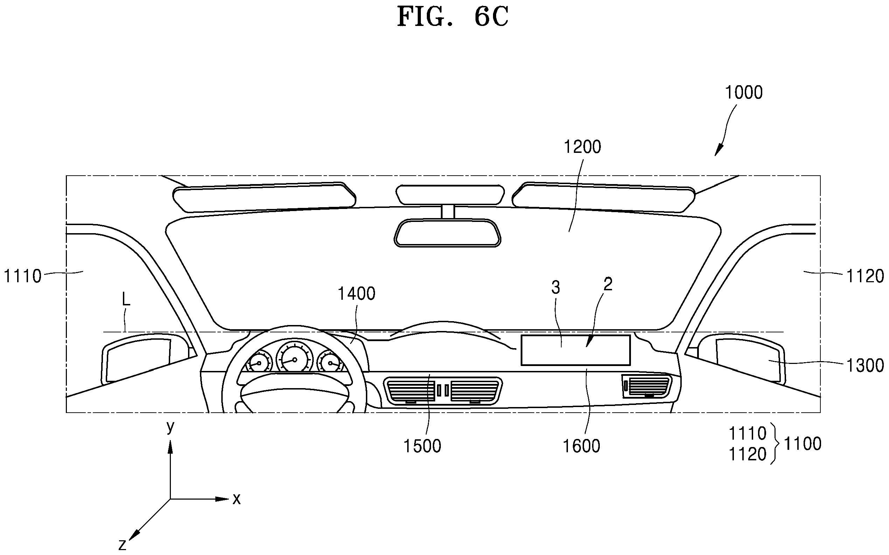

Referring to FIGS. 5, 6A, 6B, and 6C, the vehicle 1000 may refer to various suitable apparatuses for moving a subject to be transported, such as a human, an object, and/or an animal, from a departure point to a destination point. The vehicle 1000 may include a vehicle traveling on a road and/or track, a vessel moving over the sea and/or river, an airplane flying in the sky using the action of air, and/or the like.

The vehicle 1000 may travel on a road and/or a track. The vehicle 1000 may move in a set or predetermined direction according to rotation of at least one wheel. For example, the vehicle 1000 may include a three-wheeled or four-wheeled vehicle, a construction machine, a two-wheeled vehicle, a prime mover device, a bicycle, and/or a train running on a track.

The vehicle 1000 may include a body having an interior and an exterior, and a chassis in which mechanical apparatuses useful or necessary for driving are installed as other parts except for the body. The exterior of the body may include a front panel, a bonnet, a roof panel, a rear panel, a trunk, a pillar provided at a boundary between doors, and/or the like. The chassis of the vehicle 1000 may include a power generating device, a power transmitting device, a driving device, a steering device, a braking device, a suspension device, a transmission device, a fuel device, front and rear left and right wheels, and/or the like.

The vehicle 1000 may include a side window glass 1100, a front window glass 1200, a side mirror 1300, a cluster 1400, a center fascia 1500, a passenger seat dashboard 1600, and/or a display device 2.

The side window glass 1100 and the front window glass 1200 may be partitioned by a pillar between the side window glass 1100 and the front window glass 1200.

The side window glass 1100 may be installed on the side of the vehicle 1000. In an embodiment, the side window glass 1100 may be installed on a door of the vehicle 1000. A plurality of side window glasses 1100 may be provided and may face each other. In an embodiment, the side window glass 1100 may include a first side window glass 1110 and a second side window glass 1120. In an embodiment, the first side window glass 1110 may be adjacent to the cluster 1400. The second side window glass 1120 may be adjacent to the passenger seat dashboard 1600.

In an embodiment, the side window glasses 1100 may be spaced apart from each other in the x-direction or the -x-direction. For example, the first side window glass 1110 and the second side window glass 1120 may be spaced apart from each other in the x direction or the -x direction. In other words, an imaginary straight line L connecting the side window glasses 1100 may extend in the x-direction or the -x-direction. For example, an imaginary straight line L connecting the first side window glass 1110 and the second side window glass 1120 to each other may extend in the x direction or the -x direction.

The front window glass 1200 may be installed in front of the vehicle 1000. The front window glass 1200 may be between the side window glasses 1100 facing each other.

The side mirror 1300 may provide a rear view of the vehicle 1000. The side mirror 1300 may be installed on the exterior of the vehicle body. In one embodiment, a plurality of side mirrors 1300 may be provided. Any one of the plurality of side mirrors 1300 may be outside the first side window glass 1110. The other one of the plurality of side mirrors 1300 may be outside the second side window glass 1120.

The cluster 1400 may be in front of the steering wheel. The cluster 1400 may include a tachometer, a speedometer, a coolant thermometer, a fuel gauge turn indicator, a high beam indicator, a warning lamp, a seat belt warning lamp, an odometer, a tachograph, an automatic shift selector indicator lamp, a door open warning lamp, an engine oil warning lamp, and/or a low fuel warning light.

The center fascia 1500 may include a control panel on which a plurality of buttons for adjusting an audio device, an air conditioning device, and a heater of a seat are provided. The center fascia 1500 may be on one side of the cluster 1400.

A passenger seat dashboard 1600 may be spaced apart from the cluster 1400 with the center fascia 1500 therebetween. In an embodiment, the cluster 1400 may correspond to a driver seat, and the passenger seat dashboard 1600 may correspond to a passenger seat. In an embodiment, the cluster 1400 may be adjacent to the first side window glass 1110, and the passenger seat dashboard 1600 may be adjacent to the second side window glass 1120.

In an embodiment, the display device 2 may include a display panel 3, and the display panel 3 may display an image. The display device 2 may be inside the vehicle 1000. In an embodiment, the display device 2 may be between the side window glasses 1100 facing each other. The display device 2 may be on at least one of the cluster 1400, the center fascia 1500, and the passenger seat dashboard 1600.

The display device 2 may include an organic light-emitting display device, an inorganic electroluminescent display device, a quantum dot display device, and/or the like. Hereinafter, as the display device 2 according to an embodiment, an organic light-emitting display apparatus including the aforementioned organic light-emitting device will be described as an example, but various suitable types (or kinds) of the aforementioned display apparatus may be used in embodiments.

Referring to FIG. 6A, the display device 2 may be on the center fascia 1500. In an embodiment, the display device 2 may display navigation information. In an embodiment, the display device 2 may display audio, video, and/or information regarding vehicle settings.

Referring to FIG. 6B, the display device 2 may be on the cluster 1400. When the display device 2 is on the cluster 1400, the cluster 1400 may display driving information and/or the like through the display device 2. For example, the cluster 1400 may be implemented digitally. The digital cluster 1400 may display vehicle information and/or driving information as images. For example, a needle and/or a gauge of a tachometer and/or various suitable warning light icons may be displayed by a digital signal.

Referring to FIG. 6C, the display device 2 may be on the passenger seat dashboard 1600. The display device 2 may be embedded in the passenger seat dashboard 1600 or on the passenger seat dashboard 1600. In an embodiment, the display device 2 on the passenger seat dashboard 1600 seat may display an image related to information displayed on the cluster 1400 and/or information displayed on the center fascia 1500. In one or more embodiments, the display device 2 on the passenger seat dashboard 1600 may display information different from information displayed on the cluster 1400 and/or information displayed on the center fascia 1500.

### Manufacturing method

The layers constituting the hole transport region, the emission layer, and the layers constituting the electron transport region may be in a certain region by using various suitable methods such as vacuum deposition, spin coating, casting, Langmuir-Blodgett (LB) deposition, ink-jet printing, laser-printing, laser-induced thermal imaging, and/or the like.

When layers constituting the hole transport region, the emission layer, and the layers constituting the electron transport region are formed by vacuum deposition, the deposition may be performed at a deposition temperature in a range of about 100 °C to about 500 °C, at a vacuum degree in a range of about 10⁻⁸ torr to about 10⁻³ torr, and at a deposition speed in a range of about 0.01 Å/sec to about 100 Å/sec, depending on a material to be included in a layer to be formed and the structure of a layer to be formed.

### Definition of terms

The term "C₃-C₆₀ carbocyclic group" as used herein refers to a cyclic group consisting of carbon only as a ring-forming atom and having three to sixty carbon atoms, and the term "C₁-C₆₀ heterocyclic group" as used herein refers to a cyclic group that has one to sixty carbon atoms and further has, in addition to carbon, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed together with each other. For example, the number of ring-forming atoms of the C₁-C₆₀ heterocyclic group may be from 3 to 61.

The "cyclic group" as used herein may include both the C₃-C₆₀ carbocyclic group and the C₁-C₆₀ heterocyclic group.

The term "π electron-rich C₃-C₆₀ cyclic group" as used herein refers to a cyclic group that has three to sixty carbon atoms and does not include *-N=*' as a ring-forming moiety, and the term "π electron-deficient nitrogen-containing C₁-C₆₀ cyclic group" as used herein refers to a heterocyclic group that has one to sixty carbon atoms and includes *-N=*' as a ring-forming moiety.

For example, the C₃-C₆₀ carbocyclic group may be i) Group T1 or ii) a condensed cyclic group in which two or more of Group T1 are condensed together with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) Group T2, ii) a condensed cyclic group in which at least two of Group T2 are condensed together with each other, or iii) a condensed cyclic group in which at least one Group T2 and at least one Group T1 are condensed together with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, or the like),
the π electron-rich C₃-C₆₀ cyclic group may be i) Group T1, ii) a condensed cyclic group in which two or more of Group T1 are condensed together with each other, iii) Group T3, iv) a condensed cyclic group in which two or more of Group T3 are condensed together with each other, or v) a condensed cyclic group in which at least one Group T3 and at least one Group T1 are condensed together with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, or the like),
the π electron-deficient nitrogen-containing C₁-C₆₀ cyclic group may be i) Group T4, ii) a condensed cyclic group in which at least two of Groups T4 are condensed together with each other, iii) a condensed cyclic group in which at least one Group T4 and at least one Group T1 are condensed together with each other, iv) a condensed cyclic group in which at least one Group T4 and at least one Group T3 are condensed together with each other, or v) a condensed cyclic group in which at least one Group T4, at least one Group T1, and at least one Group T3 are condensed together with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and the like),
Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
Group T3 may be a furan group, a thiophene group, a 1H-pyrrole group, a silole group, or a borole group, and
Group T4 may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the C₃-C₆₀ carbocyclic group, the C₁-C₆₀ heterocyclic group, the π electron-rich C₃-C₆₀ cyclic group, or the π electron-deficient nitrogen-containing C₁-C₆₀ cyclic group" as used herein refer to a group condensed to any cyclic group, a monovalent group, or a polyvalent group (for example, a divalent group, a trivalent group, a tetravalent group, etc.) according to the structure of a formula for which the corresponding term is used. In an embodiment, "a benzene group" may be a benzo group, a phenyl group, a phenylene group, or the like, which may be easily understand by one of ordinary skill in the art according to the structure of a formula including the "benzene group."

Examples of the monovalent C₃-C₆₀ carbocyclic group and monovalent C₁-C₆₀ heterocyclic group are a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group, and examples of the divalent C₃-C₆₀ carbocyclic group and the monovalent C₁-C₆₀ heterocyclic group may include a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a substituted or unsubstituted divalent non-aromatic condensed heteropolycyclic group.

The term "C₁-C₆₀ alkyl group" as used herein refers to a linear or branched aliphatic hydrocarbon monovalent group that has one to sixty carbon atoms, and specific examples thereof are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group" as used herein refers to a divalent group having the same structure as the C₁-C₆₀ alkyl group.

The term "C₂-C₆₀ alkenyl group" as used herein refers to a monovalent hydrocarbon group having at least one carbon-carbon double bond at a main chain (e.g., in the middle) or at a terminal end (e.g., the terminus) of the C₂-C₆₀ alkyl group, and examples thereof are an ethenyl group, a propenyl group, a butenyl group, and the like. The term "C₂-C₆₀ alkenylene group" as used herein refers to a divalent group having the same structure as the C₂-C₆₀ alkenyl group.

The term "C₂-C₆₀ alkynyl group" as used herein refers to a monovalent hydrocarbon group having at least one carbon-carbon triple bond at a main chain (e.g., in the middle) or at a terminal end (e.g., the terminus) of the C₂-C₆₀ alkyl group, and examples thereof are an ethynyl group, a propynyl group, and the like. The term "C₂-C₆₀ alkynylene group" as used herein refers to a divalent group having the same structure as the C₂-C₆₀ alkynyl group.

The term "C₁-C₆₀ alkoxy group" as used herein refers to a monovalent group represented by -OA₁₀₁ (wherein A₁₀₁ is the C₁-C₆₀ alkyl group), and examples thereof are a methoxy group, an ethoxy group, an isopropyloxy group, and the like.

The term "C₃-C₁₀ cycloalkyl group" as used herein refers to a monovalent saturated hydrocarbon cyclic group having 3 to 10 carbon atoms, and examples thereof are a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, a bicyclo[2.2.2]octyl group, and the like. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent cyclic group of 1 to 10 carbon atoms, further including, in addition to carbon atoms, at least one heteroatom, as ring-forming atoms, and examples thereof are a 1,2,3,4-oxatriazolidinyl group, a tetrahydrofuranyl group, a tetrahydrothiophenyl group, and the like. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent cyclic group that has three to ten carbon atoms and at least one carbon-carbon double bond in the ring thereof and no aromaticity (e.g., is not aromatic), and examples thereof are a cyclopentenyl group, a cyclohexenyl group, a cycloheptenyl group, and the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent cyclic group of 1 to 10 carbon atoms, further including, in addition to carbon atoms, at least one heteroatom, as ring-forming atoms, and having at least one carbon-carbon double bond in the cyclic structure thereof. Examples of the C₁-C₁₀ heterocycloalkenyl group are a 4,5-dihydro-1,2,3,4-oxatriazolyl group, a 2,3-dihydrofuranyl group, a 2,3-dihydrothiophenyl group, and the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system of 6 to 60 carbon atoms, and the term "C₆-C₆₀ arylene group" as used herein refers to a divalent group having a carbocyclic aromatic system of 6 to 60 carbon atoms. Examples of the C₆-C₆₀ aryl group are a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, an ovalenyl group, and the like. When the C₆-C₆₀ aryl group and the C₆-C₆₀ arylene group each include two or more rings, the rings may be condensed together with each other.

The term "C₁-C₆₀ heteroaryl group" as used herein refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group" as used herein refers to a divalent group having a heterocyclic aromatic system of 1 to 60 carbon atoms, further including, in addition to carbon atoms, at least one heteroatom, as ring-forming atoms. Examples of the C₁-C₆₀ heteroaryl group are a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the rings may be condensed together with each other.

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure (e.g., is not aromatic when considered as a whole). Examples of the monovalent non-aromatic condensed polycyclic group are an indenyl group, a fluorenyl group, a spiro-bifluorenyl group, a benzofluorenyl group, an indenophenanthrenyl group, an indeno anthracenyl group, and the like. The term "divalent non-aromatic condensed polycyclic group" as used herein refers to a divalent group having the same structure as the monovalent non-aromatic condensed polycyclic group described above.

The term "monovalent non-aromatic condensed heteropolycyclic group" as used herein refers to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure (e.g., is not aromatic when considered as a whole). Examples of the monovalent non-aromatic condensed heteropolycyclic group are a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as used herein refers to a divalent group having the same structure as the monovalent non-aromatic condensed heteropolycyclic group described above.

The term "C₆-C₆₀ aryloxy group" as used herein indicates -OA₁₀₂ (wherein A₁₀₂ is the C₆-C₆₀ aryl group), and the term "C₆-C₆₀ arylthio group" as used herein indicates - SA₁₀₃ (wherein A₁₀₃ is the C₆-C₆₀ aryl group).

The term "C₇-C₆₀ arylalkyl group" as used herein refers to -A₁₀₄A₁₀₅ (wherein A₁₀₄ is a C₁-C₅₄ alkylene group, and A₁₀₅ is a C₆-C₅₉ aryl group), and the term "C₂-C₆₀ heteroarylalkyl group" as used herein refers to -A₁₀₆A₁₀₇ (wherein A₁₀₆ is a C₁-C₅₉ alkylene group, and A₁₀₇ is a C₁-C₅₉ heteroaryl group).

The term "R₁₀ₐ" as used herein may be:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, or a C₂-C₆₀ heteroarylalkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ arylalkyl group, a C₂-C₆₀ heteroarylalkyl group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).

In the specification, Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof; a C₇-C₆₀ arylalkyl group; or a C₂-C₆₀ heteroarylalkyl group.

The term "heteroatom" as used herein refers to any atom other than a carbon atom. Examples of the heteroatom are O, S, N, P, Si, B, Ge, Se, and any combination thereof.

The term "Ph" as used herein refers to a phenyl group, the term "Me" as used herein refers to a methyl group, the term "Et" as used herein refers to an ethyl group, the term "tert-Bu" or "Bu^{t}" as used herein refers to a tert-butyl group, and the term "OMe" as used herein refers to a methoxy group.

The term "biphenyl group" as used herein refers to "a phenyl group substituted with a phenyl group." In other words, the "biphenyl group" is a substituted phenyl group having a C₆-C₆₀ aryl group as a substituent.

The term "terphenyl group" as used herein refers to "a phenyl group substituted with a biphenyl group". In other words, the "terphenyl group" is a substituted phenyl group having, as a substituent, a C₆-C₆₀ aryl group substituted with a C₆-C₆₀ aryl group.

In the specification, the x-axis, y-axis, and z-axis are not limited to three axes in an orthogonal coordinate system, and may be interpreted in a broad sense including these axes. For example, the x-axis, y-axis, and z-axis may refer to those orthogonal to each other, or may refer to those in different directions that are not orthogonal to each other.

* and *' as used herein, unless defined otherwise, each refer to a binding site to a neighboring atom in a corresponding formula or moiety.

Hereinafter, a compound according to embodiments and an organic light-emitting device according to embodiments will be described in more detail with reference to Synthesis Examples and Examples. The wording "B was used instead of A" used in describing Synthesis Examples refers to that an identical molar equivalent of B was used in place of A.

### Synthesis Examples

### Synthesis Example 1: Synthesis of Compound 13

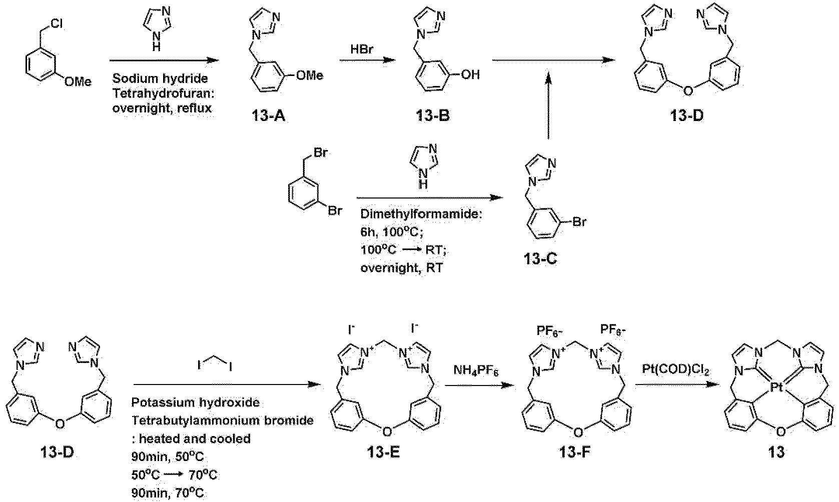

### (1) Synthesis of Intermediate Compound [13-A]

10.92 g (70 mmol) of 1-(chloromethyl)-3-methoxybenzene, 3.40 g (50 mmol) of imidazole, and 23 g (100 mmol) of sodium hydride were added to a reaction vessel, and then suspended in 100 mL of tetrahydrofuran. The resultant reaction mixture was heated to 100 °C and stirred for 36 hours. After completion of the reaction, the resultant solution was cooled to room temperature, and 300 mL of distilled water was added thereto for extraction with ethyl acetate. An organic layer extracted therefrom was washed with a saturated aqueous sodium chloride solution, and dried by using sodium sulfate. The residue from which the solvent was removed was separated by column chromatography, so as to obtain 7.52 g (40 mmol) of Intermediate Compound [13-A].

### (2) Synthesis of Intermediate Compound [13-B]

7.52 g (40 mmol) of Intermediate Compound [13-A] was suspended in an excess amount of bromic acid solution. The resultant reaction mixture was heated to 130 °C and stirred for 24 hours. After completion of the reaction, the resultant solution was cooled to room temperature, and hydrobromic acid was neutralized with an appropriate amount of NaHCO solution. 300 mL of distilled water was added thereto for extraction with ethyl acetate. An organic layer extracted therefrom was washed with a saturated aqueous sodium chloride solution, and dried by using sodium sulfate. The residue from which the solvent was removed was separated by column chromatography, so as to obtain 5.22 g (30 mmol) of Intermediate Compound [13-B].

### (3) Synthesis of Intermediate Compound 13-C

25.0 g (100 mmol) of m-bromobenzyl bromide and 3.4 g (50 mmol) of imidazole were added to a reaction vessel, and then suspended in 100 mL of dimethylformamide. The resultant reaction mixture was heated to 100 °C and stirred for 6 hours. After completion of the reaction, the resultant solution was cooled at room temperature, and 300 ml of distilled water was added thereto for extraction with ethyl acetate. An organic layer extracted therefrom was washed with a saturated aqueous sodium chloride solution, and dried by using sodium sulfate. The residue from which the solvent was removed was separated by column chromatography, so as to obtain Intermediate Compound [13-C] with a yield of 90 %.

### (4) Synthesis of Intermediate Compound [13-D]

5.22 g (30 mmol) of Intermediate Compound [13-B], 9.95 g (42 mmol) of Intermediate Compound [13-C], 16.1 g (70 mmol) of tripotassium phosphate, 1.28 g (7 mmol) of iodo copper, and 0.82 g (7 mmol) of picolinic acid were added to a reaction vessel, and then suspended in 70 mL of dimethylsulfoxide. The resultant reaction mixture was heated to a temperature of 160 °C and stirred for 12 hours. After completion of the reaction, the resultant solution was cooled at room temperature, and 300 ml of distilled water was added thereto and an extraction process was performed thereon by using ethyl acetate. An organic layer extracted therefrom was washed with a saturated aqueous sodium chloride solution, and dried by using sodium sulfate. The residue from which the solvent was removed was separated by column chromatography, so as to obtain 10.56 g (32 mmol) of Intermediate Compound [13-D].

### (5) Synthesis of Intermediate Compound [13-E]

10.56 g (32 mmol) of Intermediate Compound [13-D] and 10.71 g (40 mmol) of diiodomethane were added to a reaction vessel, and then suspended in 100 mL of toluene. The resultant reaction mixture was heated to 100 °C and stirred for 24 hours. After completion of the reaction, the resultant solution was cooled to room temperature, and the resultant solid was filtered and washed with ether. The washed solid was then dried, so as to obtain 10.28 g (17.2 mmol) of Intermediate Compound [13-E].

### (6) Synthesis of Intermediate Compound 13-F

10.28 g (17.2 mmol) of Intermediate Compound [13-E] and 9.58 g (58.8 mmol) of hexafluorophosphate ammonium were added to a reaction vessel, and then suspended in a mixed solution containing 50 mL of methyl alcohol and 50 mL of water. The resultant reaction mixture was stirred at room temperature for 24 hours. After completion of the reaction, the resultant solid was filtered and washed with ether. The washed solid was then dried, so as to obtain 7.92 g (12.5 mmol) of Intermediate Compound [13-F],

### (7) Synthesis of Compound 13

7.92 g (12.5 mmol) of Intermediate Compound [13-F], 5.6 g (15 mmol) of dichloro(1,5-cyclooctadiene)platinum, and 3.4 g of sodium acetate were suspended in 160 ml of dioxane. The resultant reaction mixture was heated to 120 °C and stirred for 72 hours. After completion of the reaction, the resultant solution was cooled at room temperature, and 300 ml of distilled water was added thereto for extraction with ethyl acetate. An organic layer extracted therefrom was washed with a saturated aqueous sodium chloride solution, and dried by using sodium sulfate. The residue from which the solvent was removed was separated by column chromatography, so as to obtain 2.78 g (5.2 mmol) of Compound 13.

### Synthesis Example 2: Synthesis of Compound 27

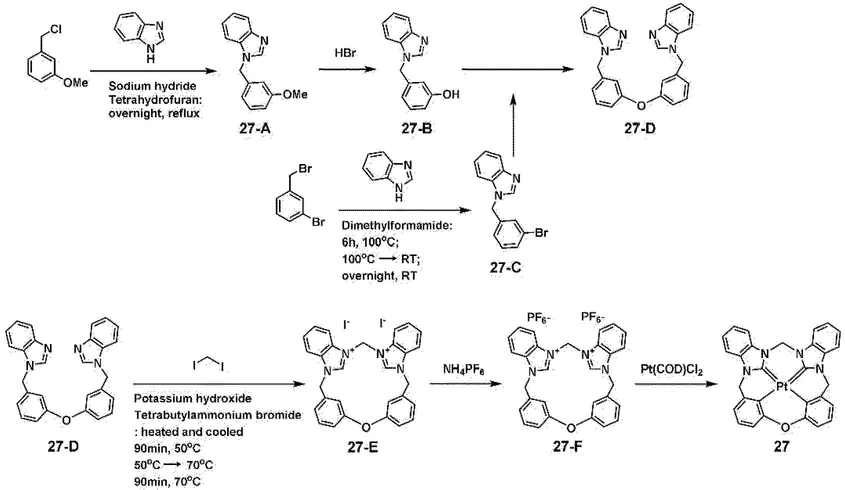

Compound 27 was obtained in the same manner as in Synthesis Example 1, except that benzimidazole was used instead of imidazole.

### Synthesis Example 3: Synthesis of Compound 37

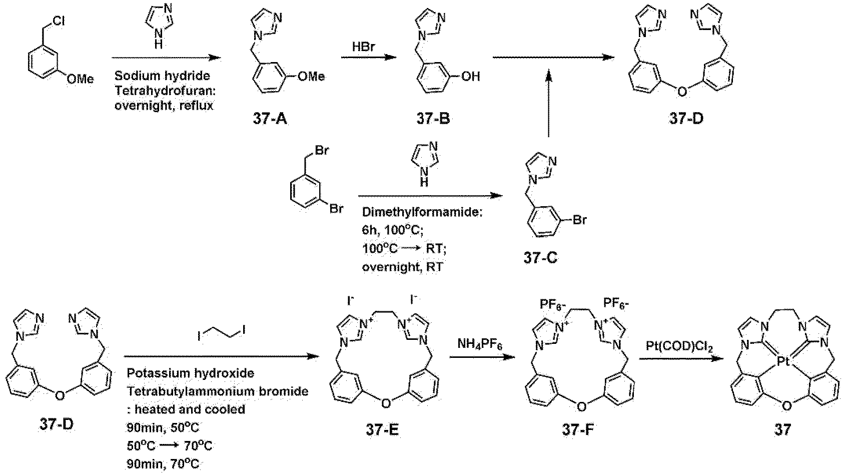

Intermediate Compounds [37-A], [37-B], [37-C], and [37-D] were obtained in the same manner as in the synthesis of Compound 13.

### (1) Synthesis of Intermediate Compound [37-E]

10.56 g (32 mmol) of Intermediate Compound [37-D] and 10.71 g (40 mmol) of 1-2-diiodoethane were added to a reaction vessel, and then suspended in 100 mL of toluene. The resultant reaction mixture was heated to 100 °C and stirred for 24 hours. After completion of the reaction, the resultant mixture was cooled to room temperature, and the resultant solid was filtered and washed with ether. The washed solid was then dried, so as to obtain 11.02 g (18 mmol) of Intermediate Compound [37-E].

### (2) Synthesis of Intermediate Compound 37-F

11.02 g (18 mmol) of Intermediate Compound [37-E] and 9.58 g (58.8 mmol) of hexafluorophosphate ammonium were added to a reaction vessel, and then suspended in a mixed solution containing 50 mL of methyl alcohol and 50 mL of water. The resultant reaction mixture was stirred at room temperature for 24 hours. After completion of the reaction, the resultant solid was filtered and washed with ether. The washed solid was then dried, so as to obtain 6.8 g (10.5 mmol) of Intermediate Compound [37-F],

### (3) Synthesis of Compound 37

6.8 g (10.5 mmol) of Intermediate Compound [37-F], 5.6 g (15 mmol) of dichloro(1,5-cyclooctadiene)platinum, and 3.4 g of sodium acetate were suspended in 160 ml of dioxane. The resultant reaction mixture was heated to 120 °C and stirred for 72 hours. After completion of the reaction, the resultant solution was cooled at room temperature, and 300 ml of distilled water was added thereto for extraction with ethyl acetate. An organic layer extracted therefrom was washed with a saturated aqueous sodium chloride solution, and dried by using sodium sulfate. The residue from which the solvent was removed was separated by column chromatography, so as to obtain 2.47 g (4.5 mmol) of Compound 37.

### Synthesis Example 4: Synthesis of Compound 44

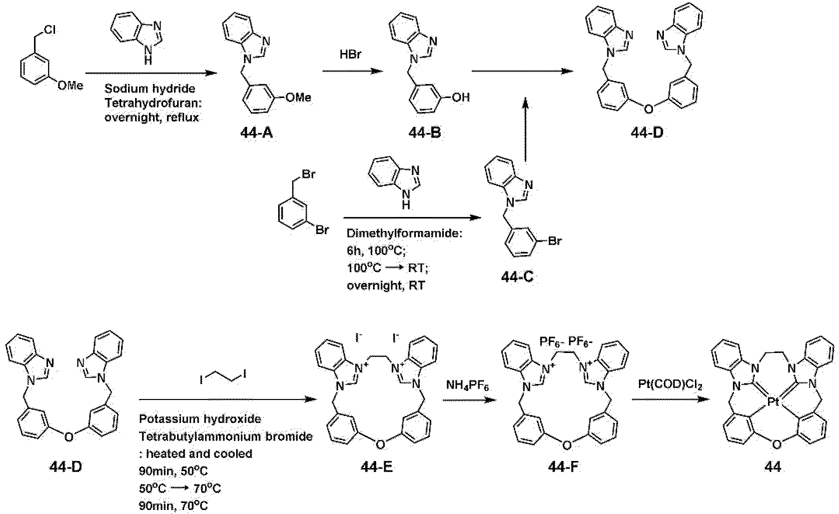

Compound 44 was obtained in the same manner as in Synthesis Example 3, except that benzimidazole was used instead of imidazole.

The 1H NMR and MS/FAB results for the compounds of Synthesis Examples 1 to 4 are shown in Table 1. Those skilled in the art may easily recognize the synthesis methods for compounds other than the compounds shown in Table 1 by referring to the aforementioned synthesis methods and raw materials.

**Table 1**

| Compound | ¹H NMR (CDCl₃, 400 MHz) | MS/FAB | |
|---|---|---|---|
| | | found | calc. |
| 13 | 7.37(4H, m), 7.19-7.21(6H, m), 6.97-7.00(4H, m), 4.96(2H, s), 4.83(1H,s) | 535.10 | 535.47 |
| 27 | 7.48(4H, s), 7.21(2H, m), 6.97-7.00(4H, m), 4.97(1H, s), 4.39(2H, s) | 635.13 | 635.59 |
| 37 | 7.48(4H, s), 7.21(2H, m), 6.97-7.00(4H, m), 4.39(2H, s), 3.37(2H, s) | 549.11 | 549.50 |
| 44 | 7.37(4H, m), 7.19-7.21(6H, m), 6.97-7.00(4H, m), 4.96(2H, s), 3.29(2H, s) | 649.14 | 649.62 |

### Examples

### Evaluation Example 1: Evaluation of energy characteristics of organometallic compound

For the compounds of the Synthesis Examples above, i) maximum emission wavelength (λₘₐₓ^{sim}), ii) spin-orbit coupling matrix elements (SOCME) at T₁ geometry, iii) triplet metal-centered state (³MC) energy level, and iv) FRET radius were simulated by quantum chemistry according to the B3LYP DFT calculation method (e.g., by calculation using density functional theory utilizing the B3LYP hybrid functional, basis set: 6-311G(d,p)), and results are shown in Table 2.

**Table 2**

| | λₘₐₓ^{sim} (nm) | λₘₐₓ^{exp} (nm) | SOCME at T₁ geom. 〈*T*₁\|*H_{SO}*\|*S*₁〉 | ³MC (eV) | FRET radius (nm) |
|---|---|---|---|---|---|
| | | | (cm⁻¹) | | |
| Compound 13 | 427.70 | 444 | 85.19 | 1.51 | 4.23 |
| Compound 27 | 445.68 | 463 | 65.42 | 1.56 | 3.15 |
| Compound 37 | 419.61 | 435 | 71.03 | 1.67 | 4.41 |
| Compound 44 | 435.25 | 452 | 59.40 | 1.71 | 4.26 |
| Compound A | 467.60 | - | 68.17 | 1.84 | 2.38 |
| Compound B | 446.03 | 485 | 25.81 | 1.81 | 3.06 |
| Compound C | 437.71 | - | 88.50 | 0.83 | 3.05 |
| Compound D | 455.43 | - | 0.47 | 1.65 | 3.09 |
| Compound E | 496.52 | - | 62.10 | -0.44 | 1.53 |
| Compound F | 470.39 | - | 2.49 | 1.61 | 2.46 |

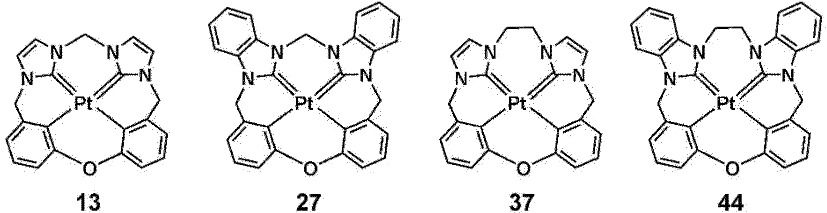

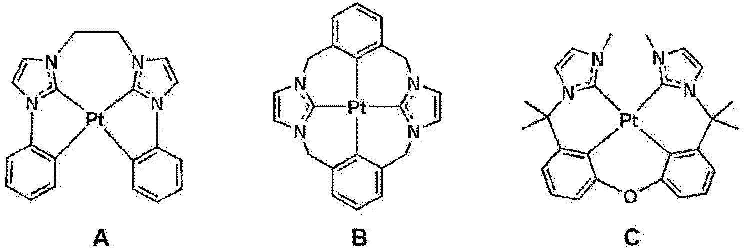

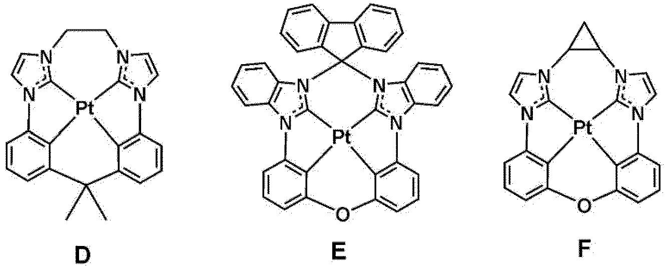

Referring to Table 2, it can be seen that the organometallic compound was suitable for blue light emission because it had a short maximum emission wavelength, and that, when used as a sensitizer in the organic light-emitting device, the efficiency and lifespan can be improved because it had a longer FRET radius compared to Compounds A to F.

### Example 1

As a cathode, a Corning 15 Ω/cm² (1,200 Å) ITO glass substrate was cut to a size of 50 mm x 50 mm x 0.7 mm, sonicated with isopropyl alcohol and pure water each for 5 minutes, and then cleaned by exposure to ultraviolet rays and ozone for 30 minutes. The ITO glass substrate was provided to a vacuum deposition apparatus. On the glass substrate, first, 2-TNATA was vacuum-deposited to form a hole injection layer having a thickness of 600 Å, and 4,4'-bis[N-(1-naphthyl)-N-phenylamino]biphenyl (hereinafter referred to as NPB) was vacuum-deposited as a hole transport compound to form a hole transport layer having a thickness of 300 Å. On the hole transport layer, Compound 13 (13 wt% with respect to an emission layer) as a phosphorescent sensitizer was co-deposited together with a mixed host of ETH2:HTH29 (at a weight ratio of 3.5:6.5) on the hole transport layer, and DFT30 was deposited thereon to form an emission layer having a thickness of 350 Å. Then, Compound HBL-1 was vacuum-deposited on the emission layer to form a hole blocking layer having a thickness of 50 Å. Subsequently, a mixed layer of CNNPTRZ and LiQ (at a weight ratio of 4:6) was deposited on the emission layer to form an electron transport layer having a thickness of 310 Å, Yb was deposited on the electron transport layer to form an electron injection layer having a thickness of 15 Å, and Mg was vacuum-deposited on the electron injection layer to a thickness of 800 Å (anode), thereby completing the manufacture of an organic light-emitting device.

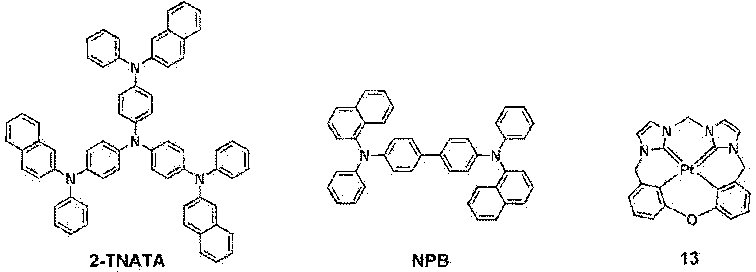

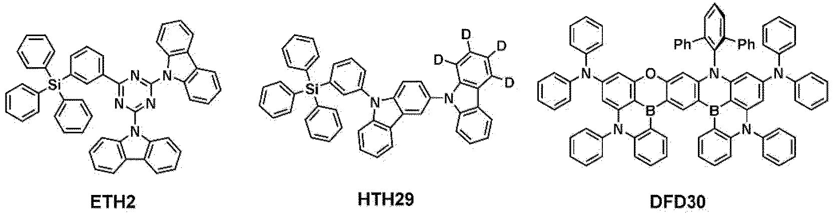

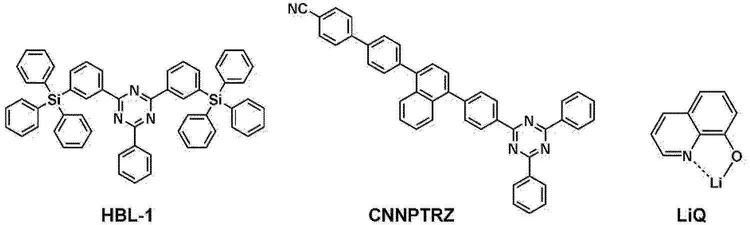

### Examples 2 to 4 and Comparative Examples 1 to 6

Organic light-emitting devices were manufactured in the same manner as in Example 1, except that compounds shown in Table 3 were used as a host and a dopant in forming the emission layer.

### Evaluation Example: 3 Characterization of organic light-emitting device

The driving voltage (V) at luminance of 1,000 cd/m², efficiency (cd/A), color purity (CIEx,y), emission efficiency (cd/A/y), maximum emission wavelength (nm), and lifespan (T₉₀) of the organic light-emitting devices of Examples 1 to 4 and Comparative Examples 1 to 6 were each measured by using a Keithley SMU 236 meter and a luminance meter PR650, and results thereof are shown in Table 3. In Table 3, the lifespan (T₉₀) is a measure of the time (hr) taken for the luminance to reach 90 % of the initial luminance.

**Table 3**

| No. | Dopant in sensitizer | Driving voltage (V) | CIE(x, y) | Luminescenc e efficiency (cd/A) | Maximum emission wavelength (nm) | Lifespan (T₉₀, hr) |
|---|---|---|---|---|---|---|
| Example 1 | Compound 13 | 4.0 | 0.134, 0.119 | 25.5 | 462 | 235 |
| Example 2 | Compound 27 | 3.9 | 0.136, 0.122 | 23.0 | 462 | 232 |
| Example 3 | Compound 37 | 4.1 | 0.134, 0.118 | 26.3 | 462 | 242 |
| Example 4 | Compound 44 | 4.0 | 0.132, 0.120 | 24.7 | 462 | 229 |
| Comparative Example 1 | Compound A | 4.1 | 0.133, 0.147 | 22.1 | 462 | 218 |
| Comparative Example 2 | Compound B | 4.2 | 0.136, 0.206 | 22.9 | 462 | 230 |
| Comparative Example 3 | Compound C | 4.4 | 0.135, 0.188 | 21.8 | 462 | 224 |
| Comparative Example 4 | Compound D | 4.3 | 0.135, 0.180 | 12.3 | 462 | 152 |
| Comparative Example 5 | Compound E | 4.5 | 0.135, 0.180 | 20.7 | 462 | 127 |
| Comparative Example 6 | Compound F | 4.4 | 0.135, 0.201 | 18.9 | 462 | 188 |

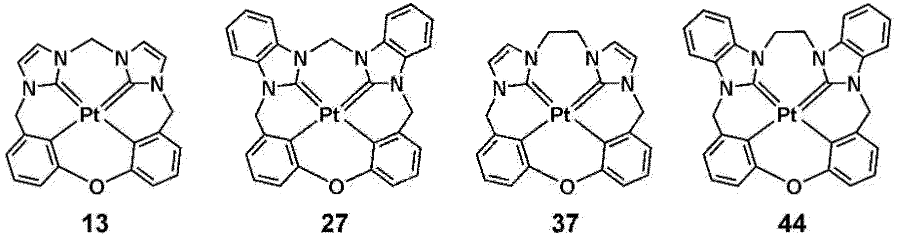

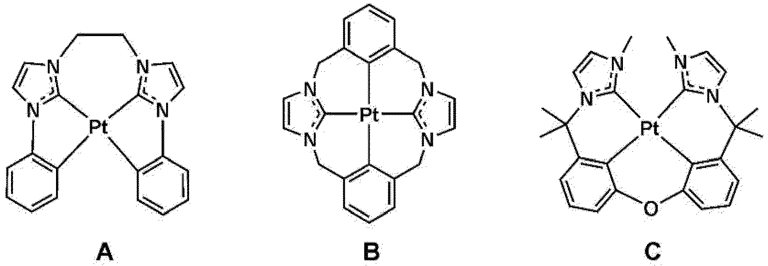

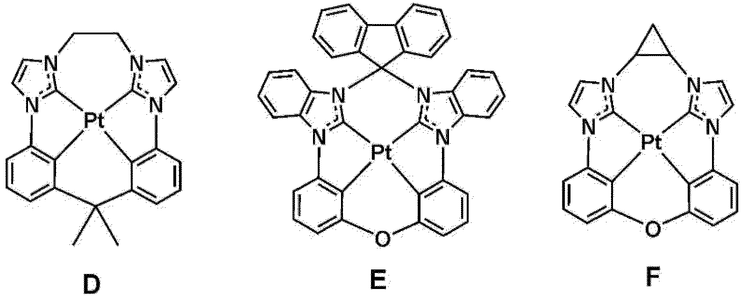

Referring to Table 3, it can be seen that the organic light-emitting devices of Examples 1 to 4 had a lower or equivalent driving voltage, higher luminescence efficiency, and longer or equivalent lifespan compared to the organic light-emitting devices of Comparative Examples 1 to 6.

According to the one or more embodiments, an organic light-emitting device including an organometallic compound may have low driving voltage, high efficiency, high color purity and long lifespan. In addition, a high-quality electronic apparatus and a consumer product may be manufactured by using this organic light-emitting device.

## Claims

1. An organometallic compound represented by Formula 1: 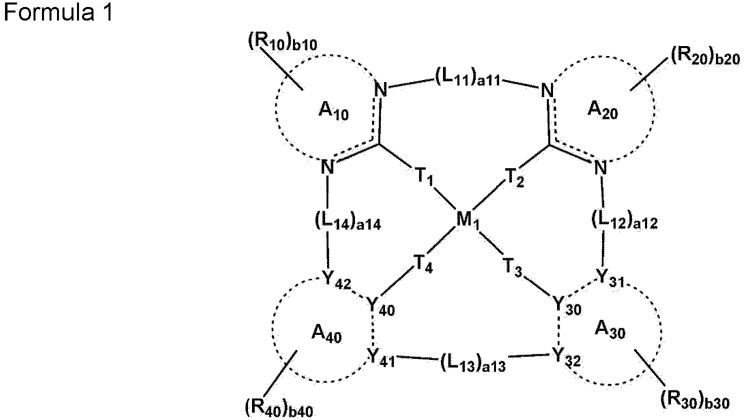
wherein, in Formula 1, M₁ is platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), or thulium (Tm),
A₁₀ and A₂₀ are each independently an N-containing C₁-C₆₀ heterocyclic group,
A₃₀ and A₄₀ are each independently a C₅-C₆₀ carbocyclic group or a C₁-C₆₀ heterocyclic group,
Y₃₀ and Y₄₀ are each independently C or N,
Y₃₁, Y₃₂, Y₄₁, and Y₄₂ are each independently N or C,
T₁ to T₄ each indicate a chemical bond,
L₁₁ is *-O-*', *-S-*', *-C(R₁)(R₂)-*', *-C(R₁)=*', *=C(R₁)-*', *-C(R₁)=C(R₂)-*', *-C(=O)-*', *-C(=S)-*', *-C≡C-*', *-B(R₁)-*', *-N(R₁)-*', *-P(R₁)-*', *-Si(R₁)(R₂)-*', *-P(R₁)(R₂)-*', *-Ge(R₁)(R₂)-*', a C₅-C₆₀ carbocyclic group unsubstituted or substituted with at least one R₁₀ₐ, or a C₁-C₆₀ heterocyclic group unsubstituted or substituted with at least one R₁₀ₐ, L₁₂ to L₁₄ are each independently *-O-*', *-S-*', *-C(R₃)(R₄)-*', *-C(R₃)=*', *=C(R₃)-*', *-C(R₃)=C(R₄)-*', *-C(=O)-*', *-C(=S)-*', *-C≡C-*', *-B(R₃)-*', *-N(R₃)-*', *-P(R₃)-*', *-Si(R₃)(R₄)-*', *-P(R₃)(R₄)-*', *-Ge(R₃)(R₄)-*', a C₅-C₆₀ carbocyclic group unsubstituted or substituted with at least one R₁₀ₐ, or a C₁-C₆₀ heterocyclic group unsubstituted or substituted with at least one R₁₀ₐ,
a11 is 1, 2, 3, 4, or 5,
a12, a13, and a14 are each independently 0, 1, 2, 3, 4, or 5,
R₁ to R₄, R₁₀, R₂₀, R₃₀, and R₄₀ are each independently hydrogen, deuterium, -F, -Cl, -Br, -I, a hydroxyl group, a cyano group, a nitro group, an amidino group, a hydrazino group, a hydrazono group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₁₀ cycloalkyl group unsubstituted or substituted with at least one R₁₀ₐ, a C₁-C₁₀ heterocycloalkyl group unsubstituted or substituted with at least one R₁₀ₐ, a C₃-C₁₀ cycloalkenyl group unsubstituted or substituted with at least one R₁₀ₐ, a C₁-C₁₀ heterocycloalkenyl group unsubstituted or substituted with at least one R₁₀ₐ, a C₆-C₆₀ aryl group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, a C₁-C₆₀ heteroaryl group unsubstituted or substituted with at least one R₁₀ₐ, a C₁-C₆₀ heteroaryloxy group unsubstituted or substituted with at least one R₁₀ₐ, a C₁-C₆₀ heteroarylthio group unsubstituted or substituted with at least one R₁₀ₐ, a monovalent non-aromatic condensed polycyclic group unsubstituted or substituted with at least one R₁₀ₐ, a monovalent non-aromatic condensed heteropolycyclic group unsubstituted or substituted with at least one R₁₀ₐ, -Si(Q₁)(Q₂)(Q₃), -B(Q₁)(Q₂), -N(Q₁)(Q₂), -P(Q₁)(Q₂), - C(=O)(Q₁), -S(=O)(Q₁), -S(=O)₂(Q₁), -P(=O)(Q₁)(Q₂), or -P(=S)(Q₁)(Q₂),
b10, b20, b30, and b40 are each independently 1, 2, 3, 4, 5, 6, 7, or 8,
neighboring two or more of R₁ to R₄, R₁₀, R₂₀, R₃₀, and R₄₀ are optionally bonded together to form a C₅-C₆₀ carbocyclic group unsubstituted or substituted with at least one R₁₀ₐ or a C₁-C₆₀ heterocyclic group unsubstituted or substituted with at least one R₁₀ₐ, R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, -Si(Q₁₁)(Q₁₂)(Q₁₃), -N(Q₁₁)(Q₁₂), - B(Q₁₁)(Q₁₂), -C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, or a C₆-C₆₀ arylthio group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, - Si(Q₂₁)(Q₂₂)(Q₂₃), -N(Q₂₁)(Q₂₂), -B(Q₂₁)(Q₂₂), -C(=O)(Q₂₁), -S(=O)₂(Q₂₁), - P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂), and
Q1 to Q₃, Q₁₁ to Q₁₃, Q₂₁ to Q₂₃, and Q₃₁ to Q₃₃ are each independently hydrogen; deuterium; -F; -Cl; -Br; -I; a hydroxyl group; a cyano group; a nitro group; a C₁-C₆₀ alkyl group; a C₂-C₆₀ alkenyl group; a C₂-C₆₀ alkynyl group; a C₁-C₆₀ alkoxy group; or a C₃-C₆₀ carbocyclic group or a C₁-C₆₀ heterocyclic group, each unsubstituted or substituted with deuterium, -F, a cyano group, a C₁-C₆₀ alkyl group, a C₁-C₆₀ alkoxy group, a phenyl group, a biphenyl group, or any combination thereof,
* and *' each indicate a binding site to a neighboring atom.

2. The organometallic compound of claim 1, wherein M₁ is Pt, Pd, Cu, Ag, or Au.

3. The organometallic compound of claim 1 or 2, wherein A₁₀ and A₂₀ are each independently an imidazole group, a benzimidazole group, a 4,5,6,7-tetrahydrobenzimidazole group, a 2,3-dihydrobenzimidazole group, an imidazopyridine group, a 2,3-dihydroimidazopyridine group, an imidazopyrimidine group, a 2,3-dihydroimidazopyrimidine group, an imidazopyrazine group, or a 2,3-dihydroimidazopyrazine group.

4. The organometallic compound of any one of the preceding claims, wherein A₁₀ is a group represented by Formula 10-1 or 10-2, and A₂₀ is a group represented by Formula 20-1 or 20-2: 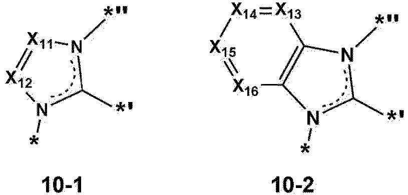 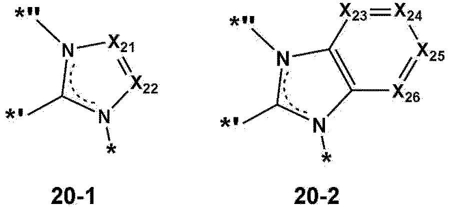 wherein, in Formulae 10-1, 10-2, 20-1, and 20-2,
X₁₁ is C(R₁₁) or N, X₁₂ is C(R₁₂) or N, X₁₃ is C(R₁₃) or N, X₁₄ is C(R₁₄) or N, X₁₅ is C(R₁₅) or N, and X₁₆ is C(R₁₆) or N,
X₂₁ is C(R₂₁) or N, X₂₂ is C(R₂₂) or N, X₂₃ is C(R₂₃) or N, X₂₄ is C(R₂₄) or N, X₂₅ is C(R₂₅) or N, and X₂₆ is C(R₂₆) or N,
R₁₁ to R₁₆ are each defined as for R₁₀ in claim 1,
R₂₁ to R₂₆ are each defined as for R₂₀ in claim 1, and
*, *', and *" each indicate a binding site to a neighboring atom.

5. The organometallic compound of any one of the preceding claims, wherein A₃₀ and A₄₀ are each independently a group represented by one of Formulae 2-1 to 2-43: 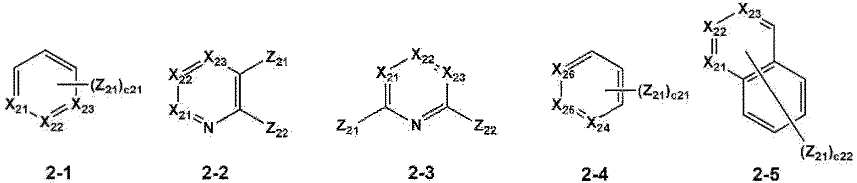 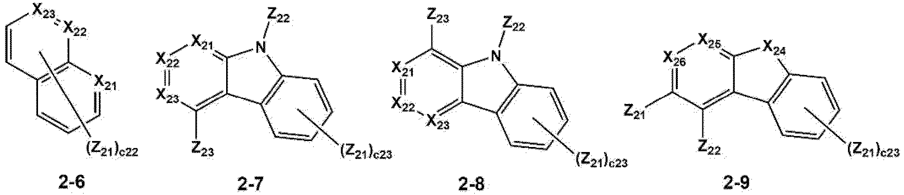 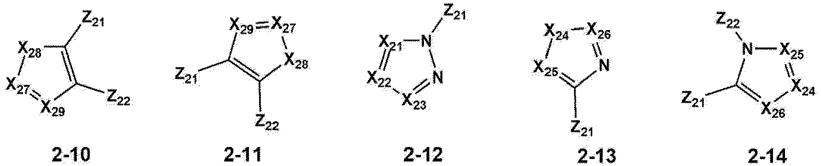 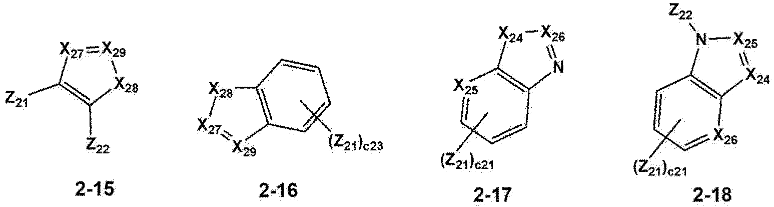 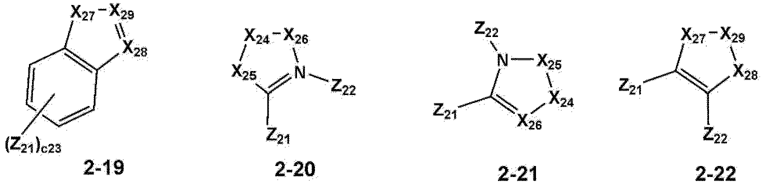 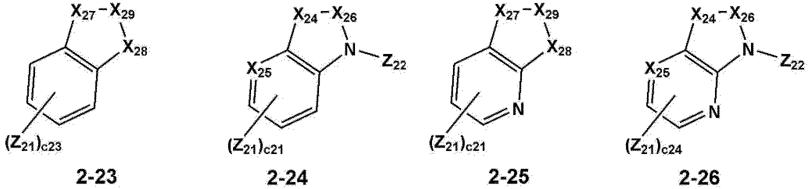 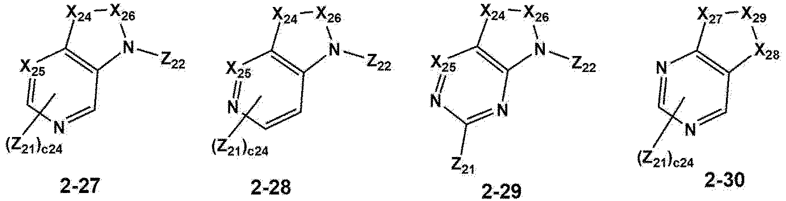 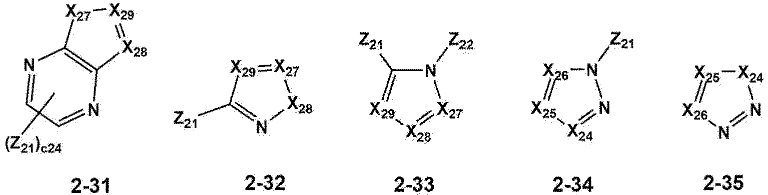 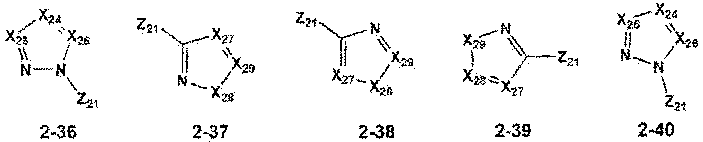 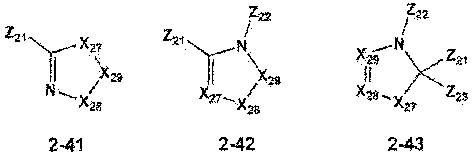 wherein, in Formulae 2-1 to 2-43,
X₂₁ to X₂₃ are each independently C(Z₂₄) or C-*, wherein at least two selected from X₂₁ to X₂₃ are each C-*,
X₂₄ is N-*, and X₂₅ and X₂₆ are each independently C(Z₂₄) or C-*, wherein at least one selected from X₂₅ and X₂₆ is C-*,
X₂₇ and X₂₈ are each independently N, N(Z₂₅), or N-*, X₂₉ is C(Z₂₄) or C-*, wherein i) at least one selected from X₂₇ and X₂₈ are each N-*, and X₂₉ is C-*, or ii) X₂₇ and X₂₈ are N-*, and X₂₉ is C(Z₂₄),
Z₂₁ to Z₂₅ are each independently deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkenyl group, a C₁-C₂₀ alkynyl group, a C₁-C₂₀ alkoxy group, a phenyl group, a biphenyl group, a terphenyl group, a naphthyl group, a fluorenyl group, a spiro-bifluorenyl group, a phenanthrenyl group, an anthracenyl group, a triphenylenyl group, a pyridinyl group, a pyrimidinyl group, a carbazolyl group, or a triazinyl group, c21 is 1, 2, or 3,
c22 is 1, 2, 3, 4, or 5,
c23 is 1, 2, 3, or 4,
c24 is 1 or 2, and
* indicates a binding site to a neighboring atom.

6. The organometallic compound of any one of the preceding claims, wherein:
L₁₁ is *-C(R₁)(R₂)-*' or a C₅-C₆₀ carbocyclic group unsubstituted or substituted with at least one R₁₀ₐ,
a11 is 1 or 2, and
R₁ and R₂ are each independently hydrogen, deuterium, -F, -Cl, -Br, -I, a hydroxyl group, a cyano group, a nitro group, an amidino group, a hydrazino group, a hydrazono group, or a C₁-C₆₀ alkyl group unsubstituted or substituted with at least one R₁₀ₐ, * and *' each indicate a binding site to a neighboring atom.

7. The organometallic compound of any one of the preceding claims, wherein:
R₁ to R₄, R₁₀, R₂₀, R₃₀, and R₄₀ are each independently hydrogen, deuterium, -F, -Cl, -Br, -I, a cyano group, a C₁-C₂₀ alkyl group, or a C₁-C₂₀ alkoxy group;
a C₁-C₂₀ alkyl group or a C₁-C₂₀ alkoxy group, each substituted with deuterium, -F, -Cl, - Br, -I, a cyano group, a phenyl group, a biphenyl group, or any combination thereof; or a group represented by one of Formulae 5-1 to 5-26 and 6-1 to 6-55,
neighboring two or more of R₁ to R₄, R₁₀, R₂₀, R₃₀, and R₄₀ are optionally bonded together to form:
a cyclopropane group, a cyclobutane group, a cyclopentane group, a cyclohexane group, a cycloheptane group, a cyclopropene group, a cyclobutene group, a cyclopentene group, a cyclohexene group, a cycloheptene group, a benzene group, a naphthalene group, a fluorene group, a phenanthrene group, a carbazole group, a dibenzofuran group, a dibenzothiophene group, or a dibenzosilole group; or
a cyclopropane group, a cyclobutane group, a cyclopentane group, a cyclohexane group, a cycloheptane group, a cyclopropene group, a cyclobutene group, a cyclopentene group, a cyclohexene group, a cycloheptene group, a benzene group, a naphthalene group, a fluorene group, a phenanthrene group, a carbazole group, a dibenzofuran group, a dibenzothiophene group, or a dibenzosilole group, each substituted with deuterium, -F, -Cl, -Br, -I, a cyano group, a phenyl group, a biphenyl group, or any combination thereof: 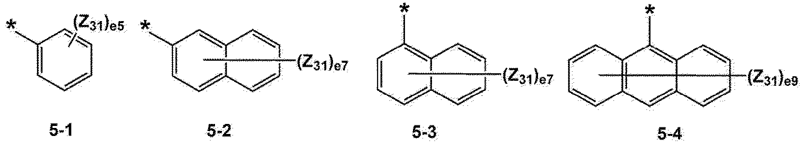 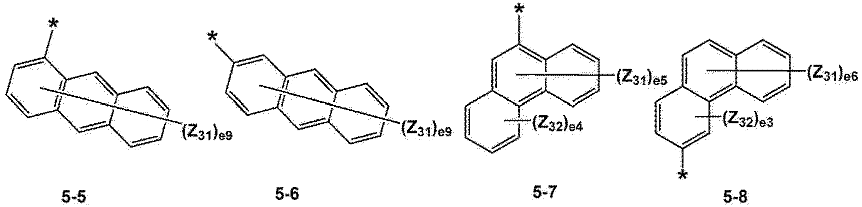 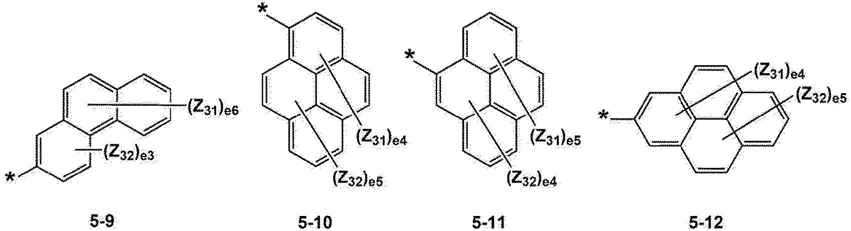 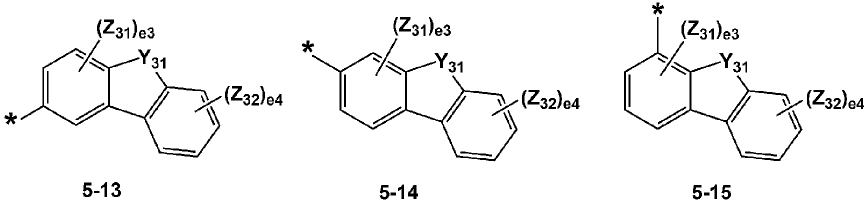 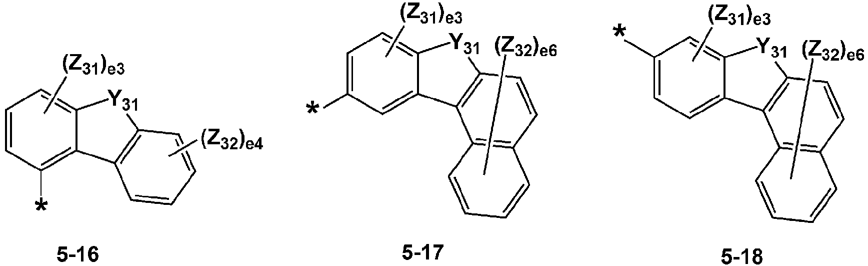 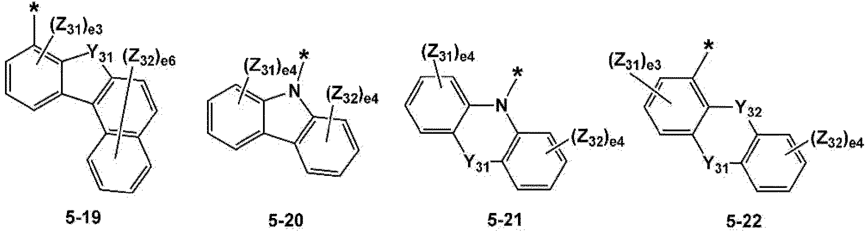 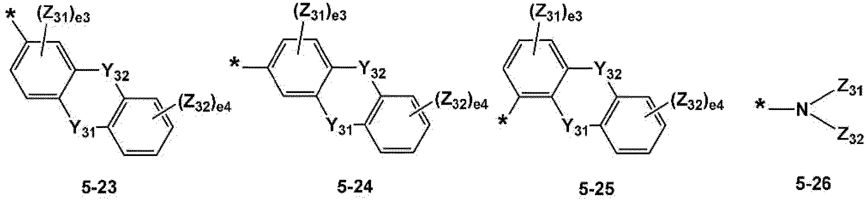 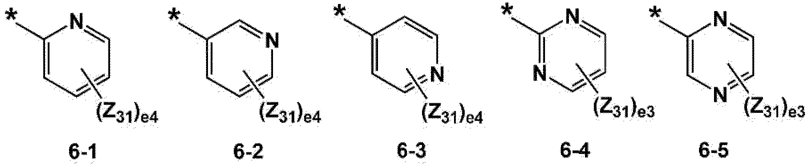 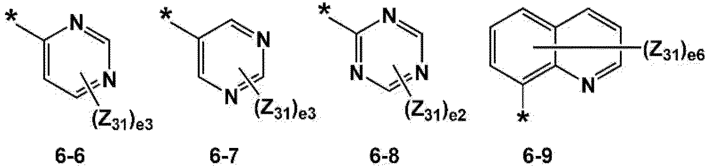 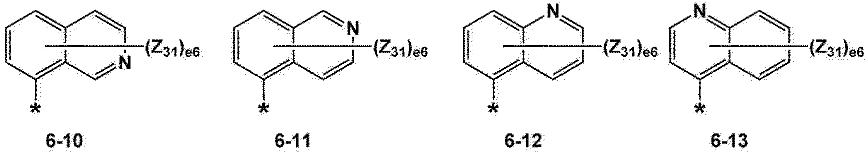 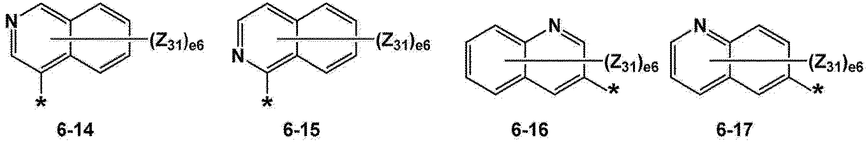 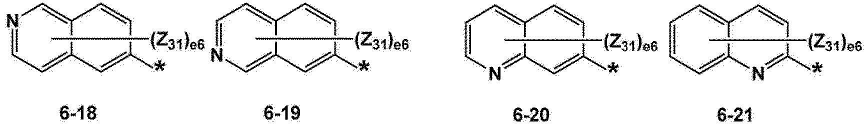 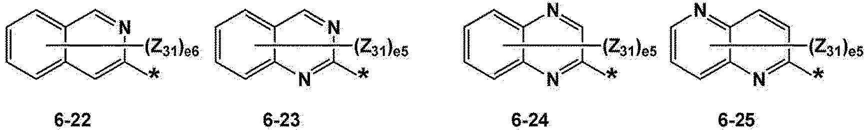 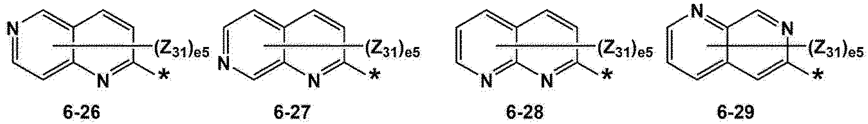 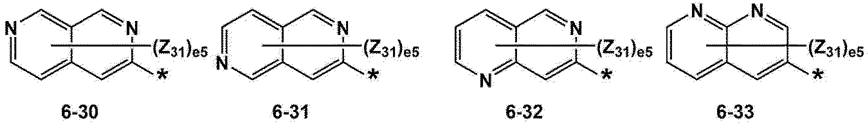 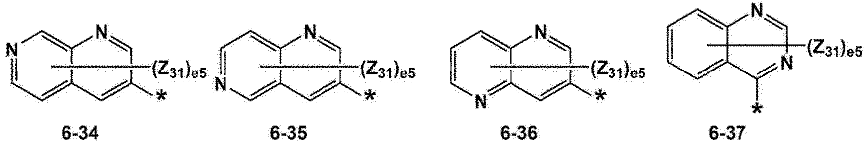 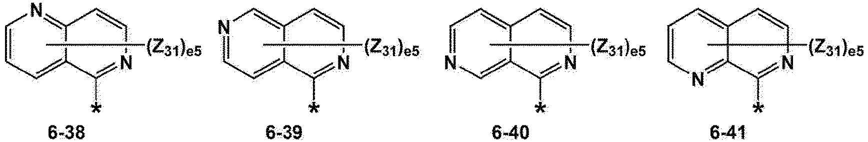 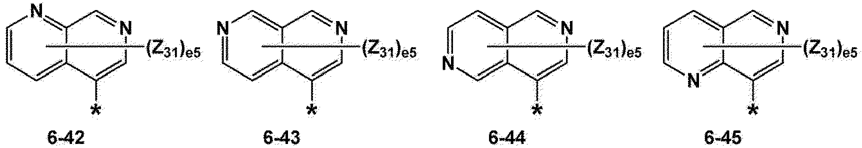 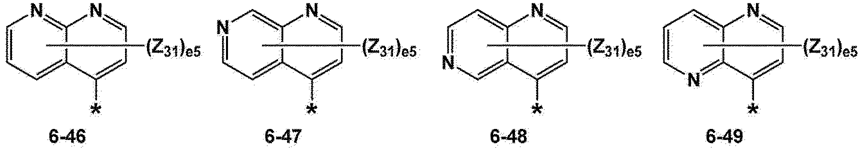 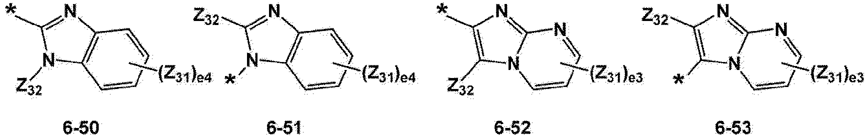 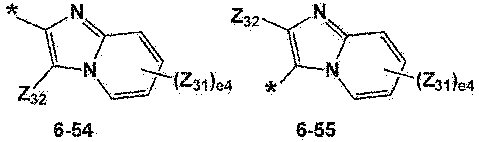 wherein, in Formulae 5-1 to 5-26 and 6-1 to 6-55,
Y₃₁ and Y₃₂ are each independently O, S, C(Z₃₃)(Z₃₄), N(Z₃₃), or Si(Z₃₃)(Z₃₄),
Z₃₁ to Z₃₄ are each independently selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkenyl group, a C₁-C₂₀ alkynyl group, a C₁-C₂₀ alkoxy group, a phenyl group, a biphenyl group, a terphenyl group, a naphthyl group, a fluorenyl group, a spiro-bifluorenyl group, a phenanthrenyl group, an anthracenyl group, a triphenylenyl group, a pyridinyl group, a pyrimidinyl group, a carbazolyl group, and a triazinyl group,
e2 is 1 or 2,
e3 is an integer from 1 to 3,
e4 is an integer from 1 to 4,
e5 is an integer from 1 to 5,
e6 is an integer from 1 to 6,
e7 is an integer from 1 to 7,
e9 is an integer from 1 to 9, and
* indicates a binding site to a neighboring atom.

8. The organometallic compound of claim 1, wherein the organometallic compound represented by Formula 1 is a compound represented by one of Formulae 11 to 13: 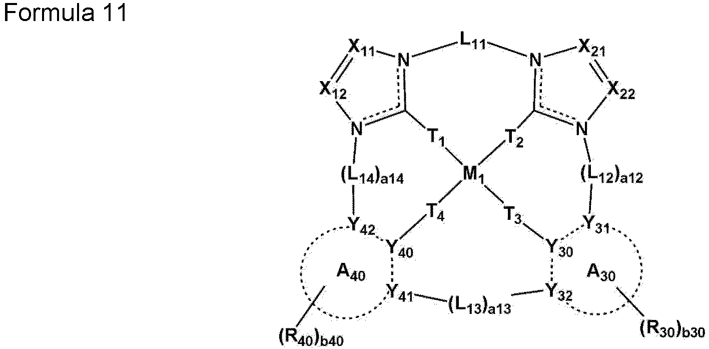 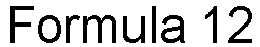 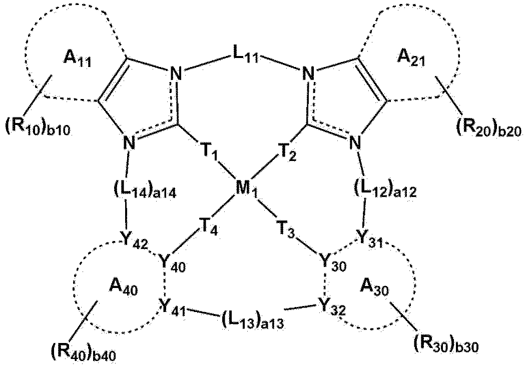 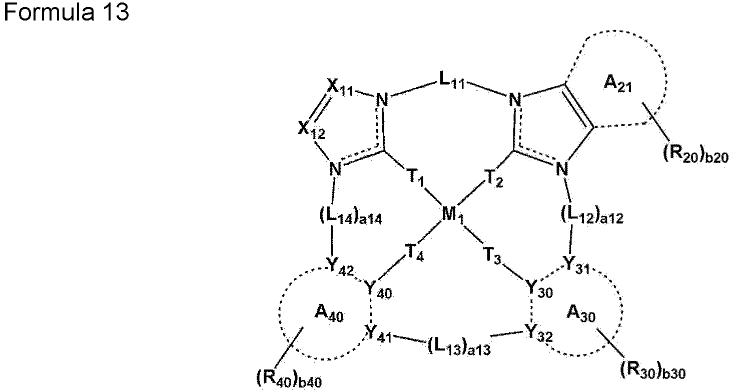 wherein, in Formulae 11 to 13,
M₁, A₃₀, A₄₀, Y₃₀ to Y₃₂, Y₄₀ to Y₄₂, T₁ to T₄, L₁₁ to L₁₄, a12 to a14, R₁₀, R₂₀, R₃₀, R₄₀, b10, b20, b30, and b40 are each as defined in claim 1,
X₁₁ is C(R₁₁₎ or N, X₁₂ is C(R₁₂) or N,
X₂₁ is C(R₂₁) or N, and X₂₂ is C(R₂₂) or N,
R₁₁ and R₁₂ are each defined as for R₁₀ in claim 1,
R₂₁ and R₂₂ are each defined as for R₂₀ in claim 1, and
A₁₁ and A₂₁ are each independently a cyclopentene group, a cyclohexene group, a benzene group, a naphthalene group, a fluorene group, an anthracene group, a phenanthrene group, a carbazole group, a dibenzofuran group, a dibenzothiophene group, a dibenzosilole group, a pyridine group, a pyrimidine group, a pyrazine group, a triazine group, a quinoline group, an isoquinoline group, a quinoxaline group, or a quinazoline group.

9. The organometallic compound of claim 1, wherein the organometallic compound represented by Formula 1 is a compound represented by one of Formulae 31 to 33: 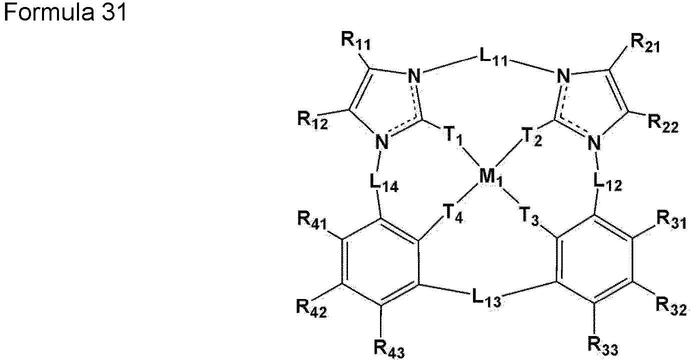 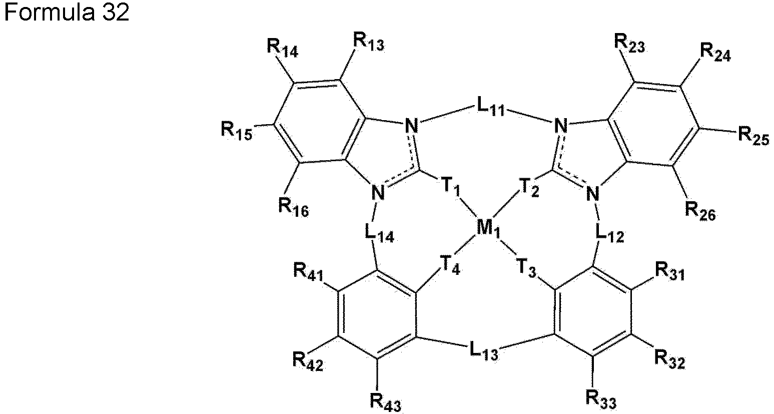 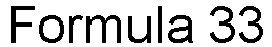 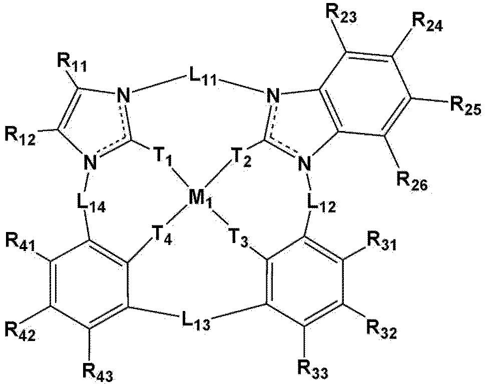 wherein, in Formulae 31 to 33,
M₁, T₁ to T₄, and L₁₁ to L₁₄ are each as defined in claim 1,
R₁₁ to R₁₆ are each independently defined as for R₁₀ in claim 1,
R₂₁ to R₂₆ are each independently defined as for R₂₀ in claim 1,
R₃₁ to R₃₃ are each independently defined as for R₃₀ in claim 1, and
R₄₁ to R₄₃ are each independently defined as for R₄₀ in claim 1.

10. The organometallic compound of claim 1, wherein the organometallic compound represented by Formula 1 is one of Compounds 1 to 71:

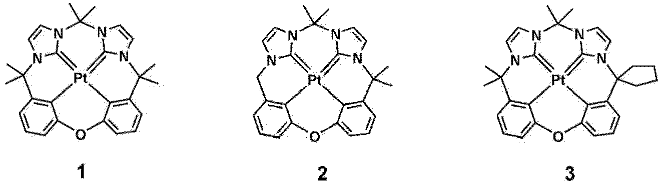

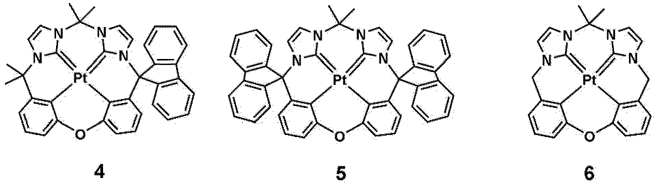

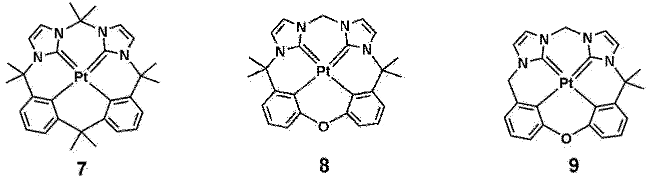

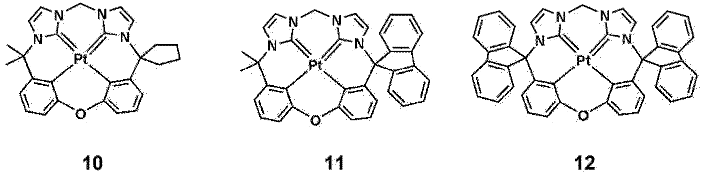

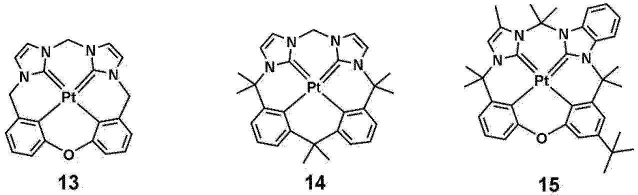

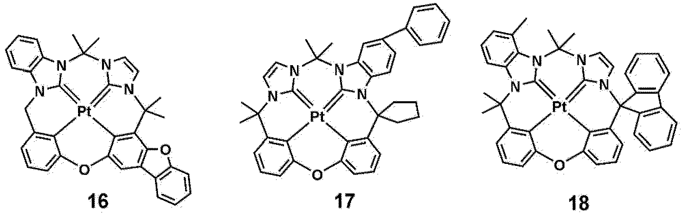

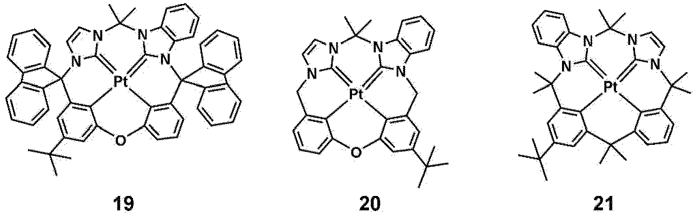

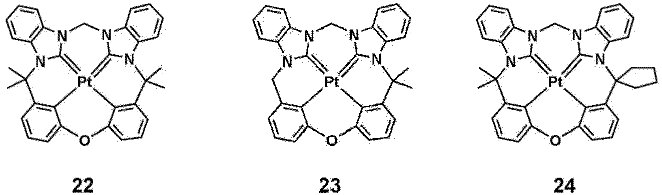

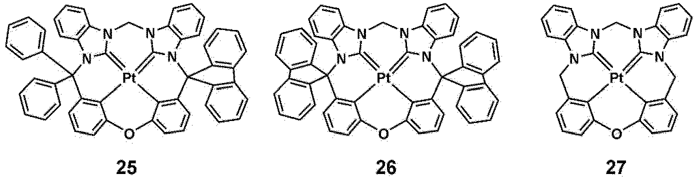

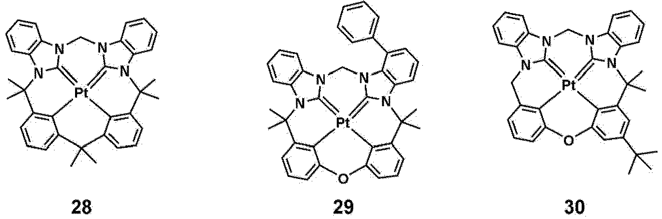

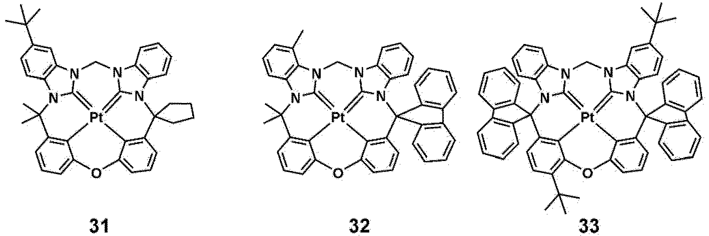

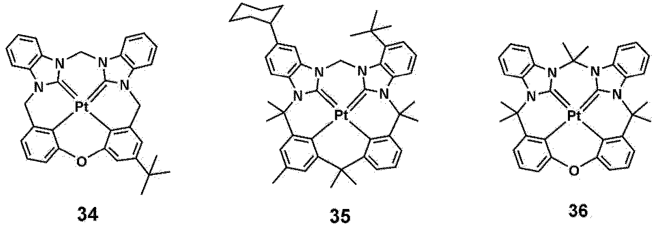

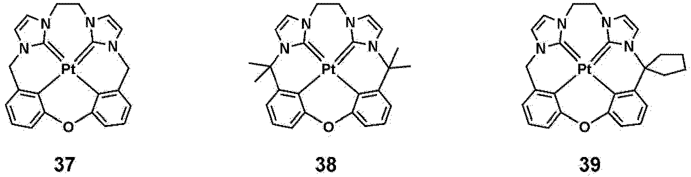

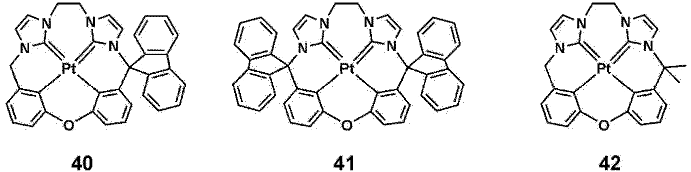

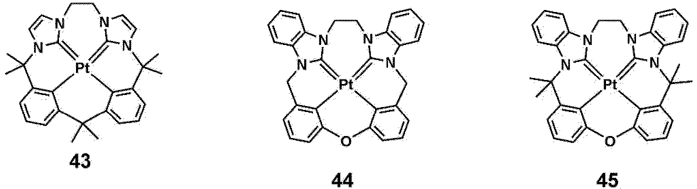

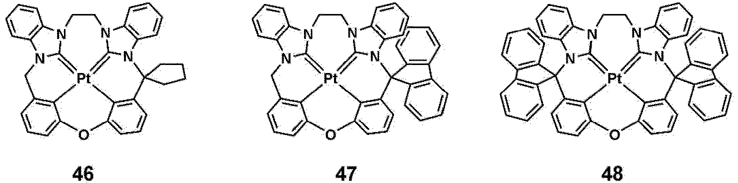

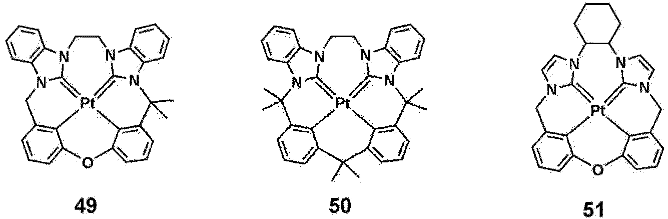

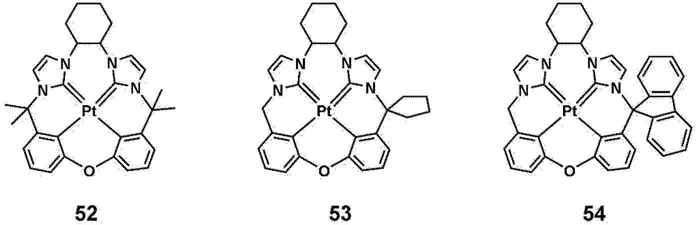

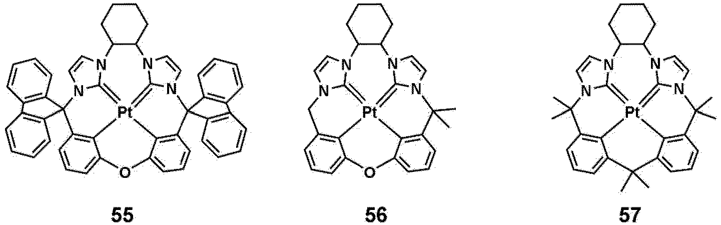

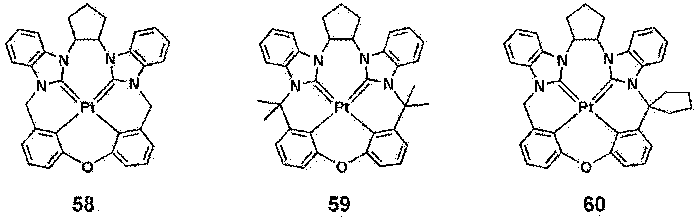

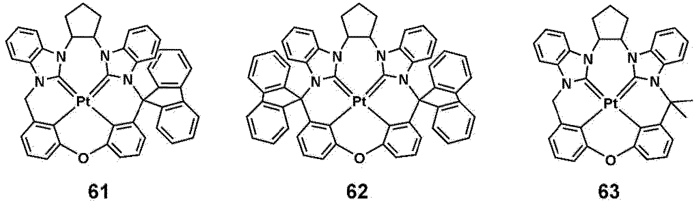

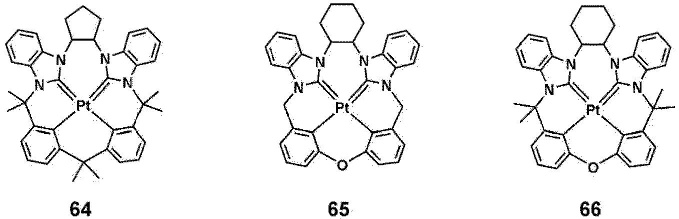

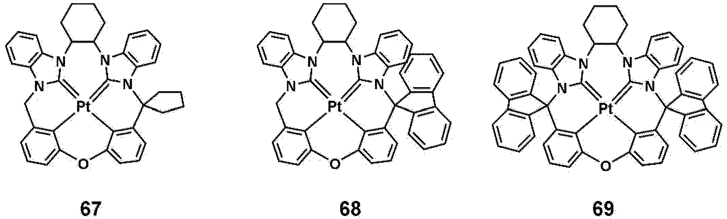

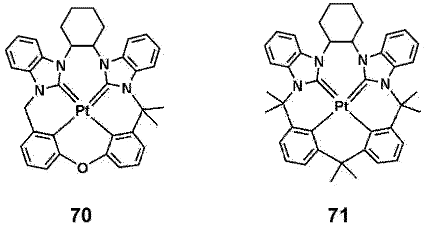

11. An organic light-emitting device (10) comprising:
a first electrode (110);
a second electrode (150) facing the first electrode (110);
an interlayer (130) arranged between the first electrode (110) and the second electrode (150) and comprising an emission layer; and
the organometallic compound of any one of claims 1 to 10.

12. The organic light-emitting device (10) of claim 11, wherein:
the first electrode (110) is an anode,
the second electrode (150) is a cathode,
the interlayer (130) further comprises a hole transport region between the first electrode (110) and the emission layer and an electron transport region between the emission layer and the second electrode (150),
the hole transport region comprises a hole injection layer, a hole transport layer, and/or an electron blocking layer, and
the electron transport region comprises a hole blocking layer, an electron transport layer, and/or an electron injection layer.

13. The organic light-emitting device (10) of claim 11, wherein the emission layer comprises the organometallic compound; and/or
the emission layer comprises a host and a dopant, and
the dopant comprises the organometallic compound; and/or
the emission layer emits blue light having a maximum emission wavelength of about 410 nm to about 490 nm; and/or
the host comprises a first host compound and a second host compound,
the first host compound is a hole-transporting host,
the second host compound is an electron-transporting host, and
the first host compound and the second host compound form an exciplex; and/or
the emission layer further comprises a delayed fluorescence material.

14. An electronic apparatus or a consumer product comprising the organic light-emitting device of claim 11.

15. The consumer product of claim 14, wherein the consumer product is one a flat panel display, a curved display, a computer monitor, a medical monitor, a television, a billboard, an indoor or outdoor light and/or light for signal, a head-up display, a fully or partially transparent display, a flexible display, a rollable display, a foldable display, a stretchable display, a laser printer, a telephone, a portable phone, a tablet personal computer, a phablet, a personal digital assistant (PDA), a wearable device, a laptop computer, a digital camera, a camcorder, a viewfinder, a micro display, a three-dimensional (3D) display, a virtual reality and/or augmented reality display, a vehicle, a video wall with multiple displays tiled together, a theater and/or stadium screen, a phototherapy device, and/or a signboard.
